# EUROPEAN PATENT APPLICATION

(11) **EP 1 638 148 A2**
(43) Date of publication of application: **22.03.2006**
(21) Application number: 05019373.9
(22) Date of filing: 06.09.2005
(51) Int. Cl.: H01L 29/78, H01L 29/267, H01L 29/24, H01L 21/04

(54) **Semiconductor device and method of manufacturing semiconductor device**

(30) Priority: 17.09.2004 JP 2004270923; 27.09.2004 JP 2004279224; 28.09.2004 JP 2004281158
(71) Applicant: NISSAN MOTOR CO., LTD., Yokohama-shi Kanagawa-ken (JP)
(72) Inventor: Hayashi, Tetsuya, Yokosuka-shi Kanagawa-ken (JP); Hoshi, Masakatsu, Yokohama-shi Kanagawa-ken (JP); Tanaka, Hideaki, Yokohama-shi Kanakawa-ken (JP); Shimoida, Yoshio, Yokosuka-shi Kanagawa-ken (JP)
(74) Representative: Grünecker, Kinkeldey, Stockmair & Schwanhäusser Anwaltssozietät

(57) **Abstract**

An aspect of the present invention provides a method of manufacturing a semiconductor device, the method including a first process step to form a semiconductor layer on a principal surface of the semiconductor base forming a heterojunction with said semiconductor base, a second process step to etch selectively the heterojunction-forming semiconductor layer to form a so called second hetero-semiconductor region employing a mask layer provided with a predetermined opening, a third process step to form, employing the mask layer, another semiconductor layer forming a heterojunction with said semiconductor base, a fourth process step to etch selectively this semiconductor layer to form a so called first hetero-semiconductor region, and a fifth process to form the gate insulating film in contact with the first hetero-semiconductor region and the semiconductor base.

## Description

### BACKGROUND OF THE INVENTION

The present invention relates to a semiconductor device and a method of manufacturing the semiconductor device.

A related art acting as the background of the present invention is Japanese Laid-Open Patent Publication No. 2003-318398. The related art discloses a semiconductor device having an n⁺-type silicon carbide substrate and an n⁻-type silicon carbide epitaxial region formed on the substrate. The substrate and epitaxial region form a semiconductor base. On a principal surface of the semiconductor base, an n⁻-type polycrystalline silicon (hereinafter referred to as "polysilicon") region and an n⁺-type polysilicon region are formed in contact with each other. The epitaxial region and the n⁻-type polysilicon region and n⁺-type polysilicon region form heterojunctions. Adjacent to the heterojunction between the epitaxial region and the n⁺-type polysilicon region, a gate insulating film and a gate electrode are formed. The n⁻-type polysilicon region is connected to a source electrode. On a bottom surface of the n⁺-type silicon carbide substrate, a drain electrode is formed.

According to the related art, the source electrode is grounded and a given positive potential is applied to the drain electrode. Under this state, the related art controls a potential applied to the gate electrode, so that the semiconductor device may function as a switch. If the gate electrode is grounded, the heterojunctions between the n⁻- and n⁺-type polysilicon regions and the epitaxial region receive a reverse bias, and therefore, no current passes between the drain electrode and the source electrode. If a given positive voltage is applied to the gate electrode, a gate electric field acts on the heterojunction between the n⁺-type polysilicon region and the epitaxial region to thin an energy barrier at the heterojunction along the gate oxide film. This results in passing a current between the drain electrode and the source electrode. This related art employs the heterojunctions as control channels to stop and pass a current According to the related art, the thickness of the heterojunctions is substantially equal to a channel length, to realize low-resistance conduction.

### SUMMARY OF THE INVENTION

According to the related art, however, the heterojunctions between the n⁻- and n⁺-tyge polysilicon regions and the n⁻-type epitaxial region cause a leakage current that is physically determined by the height of a hetero-barrier. There is a limit to reduce the leakage current.

To improve the OFF characteristics of the semiconductor device, the major hetero-semiconductor region must be a p⁺-type region, to form separate p- and n-type regions as disclosed in Japanese Patent Application No. 2004-065958. This disclosure forms an n-type region (first hetero-semiconductor region) that has a very narrow cross section and a p⁺-type region (second hetero-semiconductor region) that occupies the remaining area. This configuration, however, reduces a contact area between the very narrow n-type region and a source electrode, to increase contact resistance.

In addition, the related art forms the hetero-semiconductor region from polysilicon in which impurities diffuse at high speed. The impurities diffuse along grain boundaries to make it difficult to control the conductivity of microscopic regions. It is difficult for the related art to reduce the size of a current modulation part in the hetero-semiconductor region. If the size of the current modulation part is not reducible, a leakage current will increase.

An object of the present invention is to provide a semiconductor device such as a high-voltage withstanding field effect transistor capable of securing a drive power equivalent to that of the related art and reducing a leakage current, as well as a method of manufacturing such a semiconductor device.

Another object of the present invention is to provide a semiconductor device capable of reducing contact resistance between a first hetero-semiconductor region and a source electrode, as well as a method of manufacturing such a semiconductor device.

Still another object of the present invention is to provide a semiconductor device capable of reducing a leakage current occurring at a hetero-interface, as well as a method of manufacturing such a semiconductor device.

An aspect of the present invention provides a method of manufacturing a semiconductor device including a semiconductor base of a first conductivity type, a first hetero-semiconductor region, and a second hetero-semiconductor region, the first and second hetero-semiconductor regions being in contact with the semiconductor base and having different band gaps from that of the semiconductor base, the method including a first process to form a second hetero-semiconductor layer on a principal surface of the semiconductor base, a second process to etch selectively the second hetero-semiconductor layer to form the second hetero-semiconductor region employing a mask layer provided with a predetermined opening, a third process to form, employing the mask layer, a first hetero-semiconductor layer, a fourth process to etch selectively the first hetero-semiconductor layer to form the first hetero-semiconductor region, and a fifth process to form the gate insulating film in contact with the first hetero-semiconductor region and the semiconductor base.

Another aspect of the present invention provides a method of manufacturing a semiconductor device including a semiconductor base of a first conductivity type, and a first hetero-semiconductor region and a second hetero-semiconductor region that are in contact with a principal surface of the semiconductor base and have different band gaps from that of the semiconductor base, the method including a first process to form a second hetero-semiconductor layer on a principal surface of the semiconductor base, a second process to form an interlayer insulating film in contact with at least the second hetero-semiconductor layer, a third process to form a semiconductor layer in contact with at least the interlayer insulating film, a fourth process to etch selectively, employing a mask layer provided with a predetermined opening, the second hetero-semiconductor layer, interlayer insulating film, and semiconductor layer to form the second hetero-semiconductor region, interlayer insulating film, and a semiconductor region in contact with the first hetero-semiconductor region and formed on at least a part of the second hetero-semiconductor region through an interlayer insulating film, a fifth process to form, employing the mask layer, a first hetero-semiconductor layer, a sixth process to etch selectively the first hetero-semiconductor layer to form the first hetero-semiconductor region, and a seventh process to form a gate insulating film in contact with the first hetero-semiconductor region and the semiconductor base.

Still another aspect of the present invention provides a semiconductor device that includes a semiconductor base of a first conductivity type a first hetero-semiconductor region and a second hetero-semiconductor region that are in contact with a principal surface of the semiconductor base and have different band gaps from that of the semiconductor base, a semiconductor region that is in contact with the first hetero-semiconductor region and is formed on at least a part of the second hetero-semiconductor region through an interlayer insulating film, a gate electrode formed on a gate insulating film at a junction between the first hetero-semiconductor region and the semiconductor base, a source electrode connected through the semiconductor region to the first hetero-semiconductor region, the source electrode being passed through at least the interlayer insulating film and being connected to the second hetero-semiconductor region, and a drain electrode formed in ohmic-contact with the semiconductor base.

### BRIEF DESCRIPTION OF THE DRAWINGS

Figure 1 is a sectional view showing two structural unit cells that face each other of a semiconductor device according to a first embodiment of the present invention.
Figures 2A, 2B, 2C, and 2D are sectional views for explanation of a method of manufacturing a semiconductor device according to the first embodiment shown in Fig. 1
Figures 3A, 3B, 3C, and 3D are sectional views for explanation of a method of manufacturing a semiconductor device according to the first embodiment shown in Fig. 1
Figure 4A shows a modification of the first embodiment with no trench in the drain region 102 to provide a planar-type semiconductor device, and Figure 4B shows a semiconductor device according to another modification of the first embodiment of the present invention.
Figure 5 shows a semiconductor device according to still another modification of the first embodiment of the present invention.
Figure 6 shows a semiconductor device according to still another modification of the first embodiment of the present invention.
Figure 7 shows a semiconductor device according to still another modification of the first embodiment of the present invention.
Figure 8 shows a semiconductor device according to still another modification of the first embodiment of the present invention.
Figure 9 is a sectional view showing two structural unit cells that face each other of a semiconductor device according to a second embodiment of the present invention.
Figures 10A, 10B, 10C, and 10D are sectional views for explanation of a method of manufacturing a semiconductor device according to the second embodiment shown in Fig. 9.
Figures 11A, 11B, 11C, and 11D are sectional views for explanation of a method of manufacturing a semiconductor device according to the second embodiment shown in Fig. 9.
Figures 12A and 12B are sectional views for explanation of a method of manufacturing a semiconductor device according to the second embodiment shown in Fig. 9.
Figure 13 shows a semiconductor device according to a modification of the second embodiment of the present invention.
Figure 14 shows a semiconductor device according to another modification of the second embodiment of the present invention.
Figure 15 shows a semiconductor device according to still another modification of the second embodiment of the present invention.
Figure 16 shows a semiconductor device according to still another modification of the second embodiment of the present invention.
Figure 17 shows a semiconductor device according to still another modification of the second embodiment of the present invention.
Figure 18 shows a semiconductor device according to still another modification of the second embodiment of the present invention.
Figure 19 is a sectional view showing two structural unit cells that face each other of a semiconductor device according to a third embodiment of the present invention.
Figures 20A, 20B, 20C, and 20D are sectional views for explanation of a method of manufacturing a semiconductor device according to the third embodiment shown in Fig. 19.
Figures 21A, 21B, 21C, and 21D are sectional views for explanation of a method of manufacturing a semiconductor device according to the third embodiment shown in Fig. 19.
Figure 22A is a sectional view taken along a line a-a' of Fig. 22B showing a semiconductor device according to a fourth embodiment of the present invention, and Figure 22B is a plan view showing a layout of the semiconductor device of the fourth embodiment
Figure 23 is a sectional view taken along a line b-b' of Fig. 22B showing a semiconductor device according to a fourth embodiment of the present invention.
Figure 24 is a plan view showing the first hetero-semiconductor region 209 including the contact region 213 has a lattice layout.
Figure 25 is a sectional view showing a contact part of a semiconductor device according to a fifth embodiment of the present invention.
Figure 26 is a sectional view showing a contact part of a semiconductor device according to a sixth embodiment of the present invention
Figure 27A is a plan view showing a layout of a semiconductor device according to a seventh embodiment of the present invention and Figure 27B is a plan view showing a wider area of the semiconductor device of the seventh embodiment
Figure 28A is a sectional view showing a semiconductor device according to an eighth embodiment of the present invention, and Figure 28B is a sectional view showing a contact structure of the eighth embodiment
Figure 29 is a plan view showing a layout of a semiconductor device according to an eighth embodiment of the present invention.
Figure 30A is a sectional view showing a semiconductor device according to a ninth embodiment of the present invention, and Figure 30B is a sectional view showing a contact structure of the ninth embodiment.
Figure 31 is a plan view showing a layout of a semiconductor device according to a ninth embodiment of the present invention.
Figure 32 is a sectional view showing two unit cells that face each other of a semiconductor device according to a tenth embodiment of the present invention.
Figures 33A, 33B, 33C, and 33D are sectional views for explanation of a method of manufacturing a semiconductor device according to the tenth embodiment shown in Fig. 32.
Figures 34A, 34B, 34C, and 34D are sectional views for explanation of a method of manufacturing a semiconductor device according to the tenth embodiment shown in Fig. 32.
Figures 35A, 35B, 35C, and 35D are sectional views for explanation of a method of manufacturing a semiconductor device according to the tenth embodiment shown in Fig. 32.
Figure 36 is a sectional view showing a heterojunction diode according to an eleventh embodiment of the present invention.
Figures 37A, 37B, 37C, and 37D are sectional views for explanation of a method of manufacturing a semiconductor device according to the eleventh embodiment shown in Fig. 36.
Figures 38A, 38B, and 38Care sectional views for explanation of a method of manufacturing a semiconductor device according to the eleventh embodiment shown in Fig. 36.
Figures 39A, 39B, and 39C are sectional views for explanation of a method of manufacturing a semiconductor device according to the eleventh embodiment shown in Fig. 36.
Figure 40A is a sectional view showing a heterojunction diode according to a modification of the twelfth embodiment of the present invention, and Fig. 40B is a sectional view taken along a line A-B of Fig. 40A in a direction orthogonal to the plane of Fig. 40A.
Figure 41 is a sectional view showing a heterojunction diode according to another modification of the eleventh embodiment of the present invention.
Figure 42 is a sectional view showing a heterojunction field effect transistor according to a twelfth embodiment of the present invention.
Figures 43A, 43B, and 43C are sectional views for explanation of a method of manufacturing a semiconductor device according to the eleventh embodiment shown in Fig. 42.
Figures 44A, 44B, and 44C are sectional views for explanation of a method of manufacturing a semiconductor device according to the eleventh embodiment shown in Fig. 42.
Figures 45A, 45B, and 45C are sectional views for explanation of a method of manufacturing a semiconductor device according to the eleventh embodiment shown in Fig. 42.
Figures 46A, 46B, and 46C are sectional views for explanation of a method of manufacturing a semiconductor device according to the eleventh embodiment shown in Fig. 42.
Figures 47A and 47B are sectional views for explanation of a method of manufacturing a semiconductor device according to the eleventh embodiment shown in Fig. 42.
Figure 48 is a sectional view showing a semiconductor device according to a modification of the twelfth embodiment of the present invention.
Figure 49 is a sectional view showing a semiconductor device according to another modification of the twelfth embodiment of the present invention.
Figure 50 is a sectional view showing a semiconductor device according to still another modification of the twelfth embodiment of the present invention.
Figure 51A is a sectional view showing a heterojunction field effect transistor according to still another modification of the twelfth embodiment of the present invention, and Fig. 51B is a sectional view taken along a line A-B of Fig. 51A in a direction orthogonal to the plane of Fig. 51A.

### DETAILED DESCRIPTION OF EMBODIMENTS

Various embodiments of the present invention will be described with reference to the accompanying drawings. It is to be noted that same or similar reference numerals are applied to the same or similar parts and elements throughout the drawings, and the description of the same or similar parts and elements will be omitted or simplified.

### (First embodiment)

### (Semiconductor device)

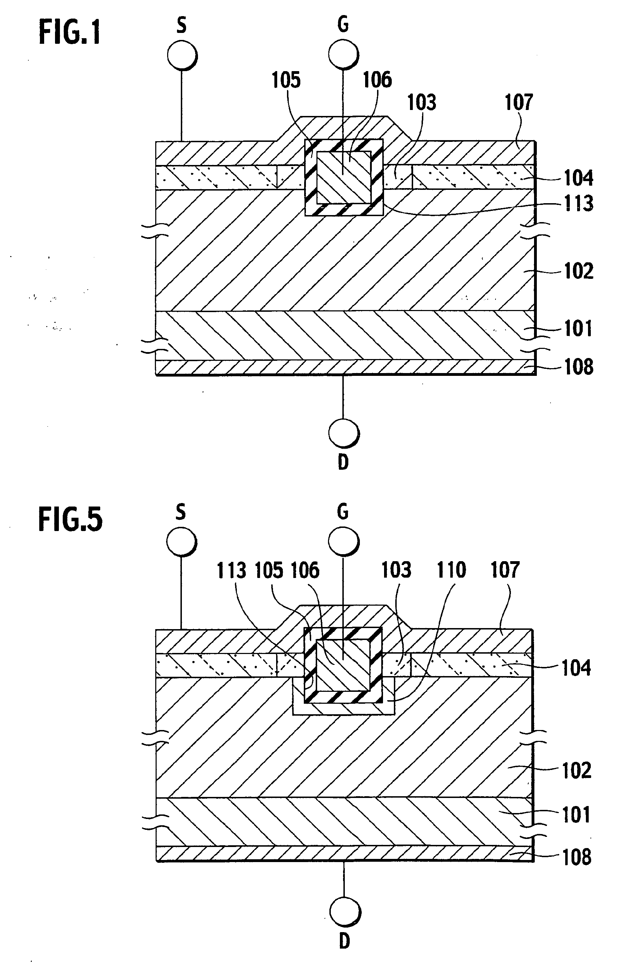

Figure 1 is a sectional view showing two structural unit cells that face each other of a semiconductor device according to a first embodiment of the present invention. The semiconductor device according to this embodiment employs, for example, silicon carbide (SiC) as a substrate material.

The semiconductor device according to the first embodiment has an n⁺-type SiC substrate 101 made of silicon carbide whose polytype is, for example, 4H. On the substrate 101, a drain region 102 is formed from an n⁻-type SiC epitaxial layer. In contact with a principal surface that is opposite to a junction between the drain region 102 and the substrate 101, there are formed a first hetero-semiconductor region 103 made of, for example, n-type polysilicon and a second hetero-semiconductor region 104 made of, for example, p-type polysilicon. Namely, junctions between the drain region 102 and the first and second hetero-semiconductor regions 103 and 104 are heterojunctions made of SiC and polysilicon having different band gaps. Along the heterojunctions, there are energy barriers. In contact with a junction interface between the first hetero-semiconductor region 103 and the drain region 102, there is formed a gate insulating film 105 made of, for example, a silicon oxide film. On the gate insulating film 105, there is formed a gate electrode 106. Opposite to the junction interfaces between the first and second hetero-semiconductor regions 103 and 104 and the drain region 102, there is formed a source electrode 107, and opposite to the source electrode 107, a drain electrode 108 is formed on the bottom surface of the substrate 101.

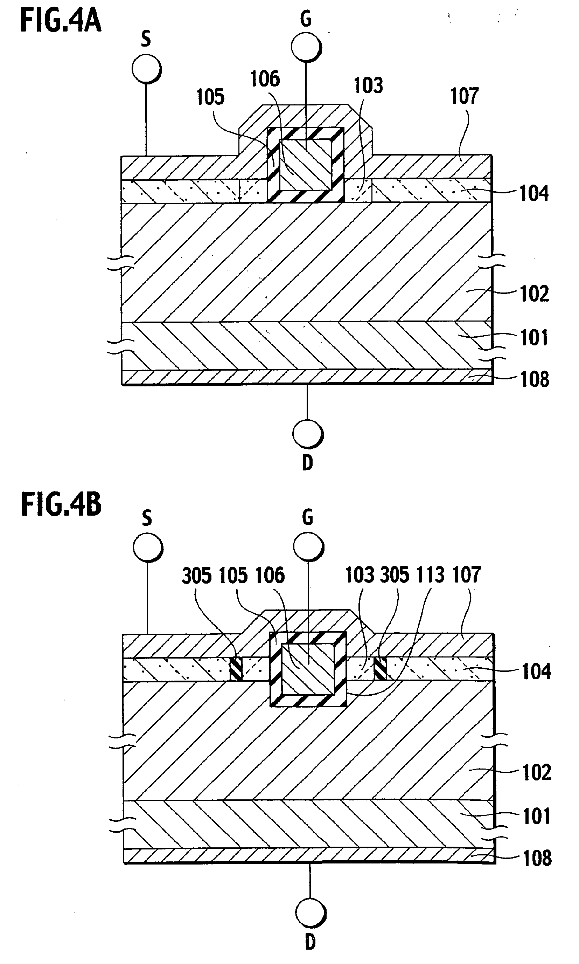

According to this embodiment, a trench 113 is formed in the surface of the drain region 102 as shown in Fig. 1. In the trench 113, the gate insulating film 105 and gate electrode 106 are formed, to constitute a trench-type semiconductor device. The drain region 102 may have no trench, to constitute a planar-type semiconductor device as shown in Fig. 4A.

### (Method of manufacturing the semiconductor device)

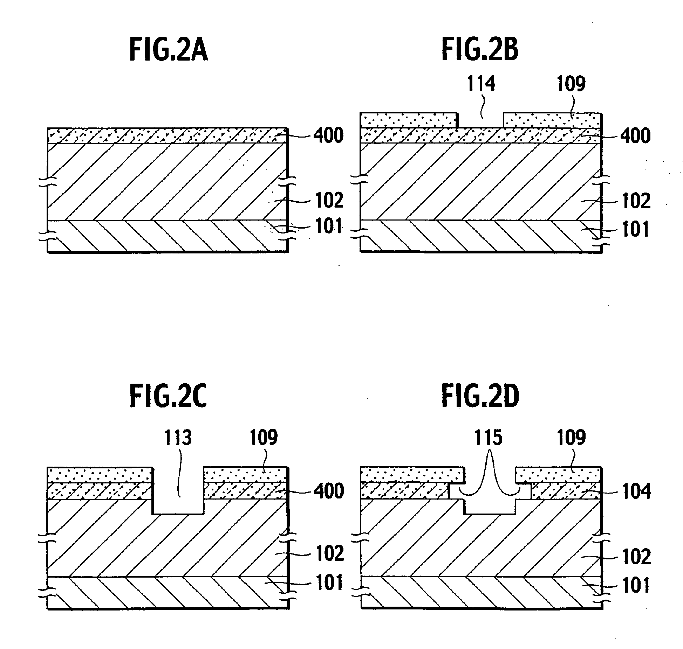

A method of manufacturing the silicon carbide semiconductor device according to the first embodiment shown in Fig. 1 will be explained with reference to Figs. 2A to 3D.

In Fig. 2A, an n⁺-type SiC substrate 101 is prepared. On the substrate 101, an n⁻-type drain region 102 is epitaxially grown, to form an n-type silicon carbide semiconductor base. On the semiconductor base, a first polysilicon layer 400 (to form a second hetero-semiconductor region) is deposited by, for example, LP-CVD. Boron doping is carried out in an atmosphere of, for example, BBr₃ to form a p-type first polysilicon layer 400. The first polysilicon layer 400 may be formed by deposition according to an electron beam deposition method or a spattering method and by recrystallization according to, for example, a laser annealing method. Alternatively, the first polysilicon layer 400 may be formed from monocrystalline silicon (hereinafter referred to as "monosilicon") epitaxially grown according to, for example, molecular-beam epitaxy. The doping may be carried out with the use of a combination of ion implantation and activation heat treatment. The drain region 102 may have an impurity concentration of, for example, 1 x 10¹⁶ cm⁻³ and a thickness of, for example, 10 ,,m. The first polysilicon layer 400 may have a thickness of, for example, 0.5 ,,m.

In Fig. 2B, a silicon nitride film is deposited on the first polysilicon layer 400 according to, for example, LP-CVD. An opening 114 is formed in the silicon nitride film according to photolithography and etching, to form a mask layer 109. Although the mask layer 109 is made of a silicon nitride film in this embodiment, it may be made of any other material if the material is appropriate for selective etching and is easy to remove.

In Fig. 2C, the first polysilicon layer 400 and a surface part of the drain region 102 are etched according to, for example, reactive ion etching (dry etching), to form a trench 113 having a predetermined depth. The polysilicon layer 400 may be etched by any other etching method such as wet etching.

In Fig. 2D, a space 115 is formed just under an end of the mask layer 109 by removing an end of the first polysilicon layer 400. For example, with the mask layer 109, the polysilicon layer 400 is oxidized in an oxygen atmosphere. At this time, the surface of the first polysilicon layer 400 covered with the silicon nitride mask layer 109 is not oxidized, and only an exposed end of the first polysilicon layer 400 is oxidized. The end of the first polysilicon layer 400 is oxidized by, for example, 0.1 ,,m and is wet-etched with, for example, hydrofluoric acid. The oxidized end part (0.1 ,,m in this example) of the polysilicon layer 400 is removed to form the space 115 just under the end of the mask layer 109. The end of the first polysilicon layer 400 may be etched according to any other etching method. This forms the second hetero-semiconductor region 104.

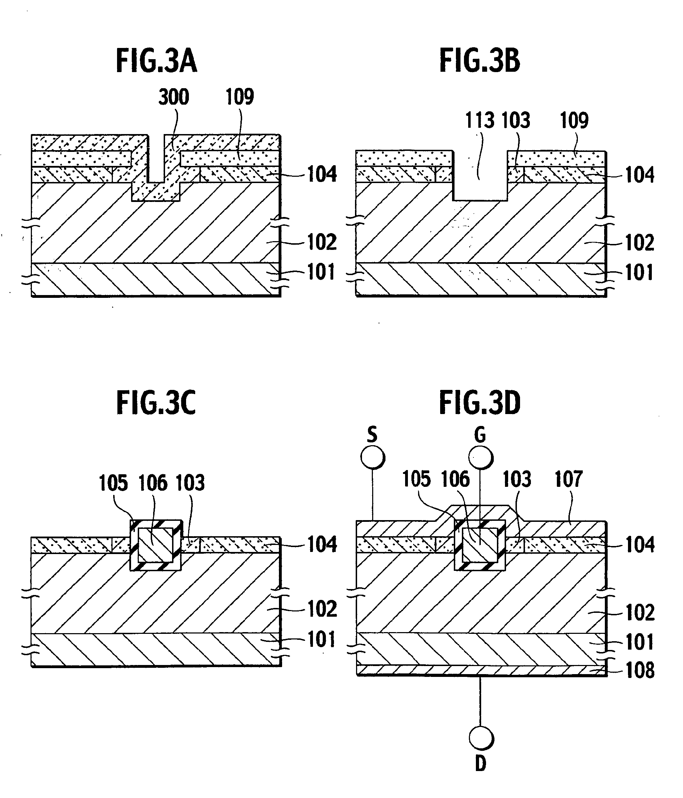

In Fig. 3A, a second polysilicon layer 300 (to form the first hetero-semiconductor region) is deposited according to, for example, LP-CVD. At this time, the second polysilicon layer 300 is isotropically formed along the exposed surfaces of the respective layers, and therefore, the space 115 (Fig. 2D) formed just under the end of the mask layer 109 is filled with the second polysilicon layer 300. The conductivity type and impurity concentration of the second polysilicon layer 300 are determined according to design specifications. According to this embodiment, the second polysilicon layer 300 is of an n-type and has a thickness of 0.5 ,,m.

After forming the space 115 and before forming the second polysilicon layer 300, an impurity diffusion preventive layer may be formed between the second hetero-semiconductor region 104 and the second polysilicon layer 300. The impurity diffusion preventive layer may be formed according to the eleventh embodiment to be explained later. The impurity diffusion preventive layer prevents impurities from diffusing between the adjacent second polysilicon layer 300 (first hetero-semiconductor layer 103) and the second hetero-semiconductor region 104. This technique realizes the formation of fine hetero-semiconductor layers having different impurity concentrations or different conductivity types. This technique also realizes a heterojunction diode capable of reducing a leakage current occurring at a hetero-interface.

In Fig. 3B, the second polysilicon layer 300 is removed by, for example, reactive ion etching (dry etching) except the part just under the end of the mask layer 109. This forms the first hetero-semiconductor region 103 having a narrow width (0.1 "m in this embodiment), In this way, the first hetero-semiconductor region 103 is formed in a self-aligning manner to have a narrow width by, for example, thermal oxidation capable of controlling the thickness of the region 103. The polysilicon layer may be etched by any other etching method such as wet etching.

In Fig. 3C, the mask layer 109 is removed by, for example, phosphoric acid. Thereafter, a gate insulating film 105 is deposited over the first and second hetero-semiconductor regions 103 and 104 and along the inner wall of the trench 113. On the gate insulating film 105, a polysilicon layer to form the gate electrode 106 is deposited. Solid state diffusion with POCl₃ is achieved to dope the gate-electrode-forming polysilicon layer with phosphorus. Photolithography and etching are carried out to form the gate electrode 106. To cap the gate electrode 106, a gate insulating film 105 is again deposited. Photolithography and etching are carried out to remove the gate insulating film 105 from the top surfaces of the first and second hetero-semiconductor regions 103 and 104 and open contact holes (not shown). According to this embodiment, the gate insulating film 105 is left only around the gate electrode 106. The gate insulating film may be also left over one or both of the first and second hetero-semiconductor regions 103 and 104.

In Fig. 3D, a drain electrode 108 is formed on the bottom surface of the substrate 101 from titanium (Ti) and nickel (Ni). On the surfaces of the first and second hetero-semiconductor regions 103 and 104, a source electrode 107 is formed by sequentially depositing titanium (Ti) and aluminum (Al), to thereby complete the silicon carbide semiconductor device according to the first embodiment of the present invention shown in Fig. 1.

In this way, the semiconductor device according to this embodiment is easy to realize with the use of conventional manufacturing techniques. The manufacturing method according to the embodiment is capable of forming the narrow first hetero-semiconductor region 103 in a self-aligning manner. In addition, the manufacturing method according to this embodiment is capable of freely designing the conductivity type and impurity concentration of the first hetero-semiconductor region 103 that contacts the gate electrode 106 through the gate insulating film 105.

Operation of the semiconductor device according to this embodiment of the present invention will be explained. For example, the source electrode 107 is grounded, and a positive potential is applied to the drain electrode 108. If a ground potential or a negative potential is applied to the gate electrode 106, a nonconductive state (OFF state, or disconnected state) is maintained. Namely, heterojunction interfaces between the first and second hetero-semiconductor regions 103 and 104 and the drain region 102 form energy barriers against conduction electrons. The first and second hetero-semiconductor regions 103 and 104 are each made of silicon material, and therefore, substantially form the same energy barrier difference ,, EC relative to the drain region 102 made of silicon carbide. However, the n-type first hetero-semiconductor region 103 and p-type second hetero-semiconductor region 104 differ from each other in Fermi energy that is energy from a conduction band to Fermi level. Accordingly, the regions 103 and 104 form depletion layers having different widths, the depletion layers extending from the junction interfaces with the drain region 102. More precisely, the width of the depletion layer extending from the junction interface of the second hetero-semiconductor region 104 is larger than that of the depletion layer extending from the junction interface of the first hetero-semiconductor region 103, to block a leakage current. If the impurity concentration of the second hetero-semiconductor region 104 is set to be higher than that of the first hetero-semiconductor region 103, a depletion layer that is produced by a built-in electric field of a pn diode formed from the second hetero-semiconductor region 104 and first hetero-semiconductor region 103 extends toward the first hetero-semiconductor region 103. This may further reduce a leakage current at the heterojunction between the first hetero-semiconductor region 103 and the drain region 102.

The manufacturing method according to the embodiment is capable of easily controlling the width of the first hetero-semiconductor region 103 to cover a gate electric field extending from the gate electrode 106. It is possible, for example, to form an inverted region over the first hetero-semiconductor region 103 when a negative potential is applied to the gate electrode 106, thereby further improving the turn-off capability of the semiconductor device. According to this embodiment, the first hetero-semiconductor region 103 is formed in a self-aligning manner. Due to this, the width of the first hetero-semiconductor region 103 is correctly controllable even when integrating a plurality of cells. This eliminates variations in turn-off capability among the cells.

In this way, the embodiment improves turn-off capability higher than that of the conventional structure. The embodiment forms the first hetero-semiconductor region 103 from a polysilicon layer that is different from that forming the second hetero-semiconductor region 104. Accordingly, the embodiment can freely set the conductivity type and concentration of impurities, to improve the degree of designing freedom.

Next, a positive potential is applied to the gate electrode 106 to change the nonconductive state to a conductive state. Through the gate insulating film 105, a gate electric field extends up to the heterojunction interface between the first hetero-semiconductor region 103 and the drain region 102. As a result, an accumulation layer of conduction electrons is formed in the first hetero-semiconductor region 103 and drain region 102 around the gate electrode 106. Namely, at the junction interface between the first hetero-semiconductor region 103 and the drain region 102 in the vicinity of the gate electrode 106, the potential of the first hetero-semiconductor region 103 is pushed down, and the energy barrier on the drain region 102 side becomes steep to pass conduction electrons through the energy barrier.

Here, the first hetero-semiconductor region 103 has been formed in a self-aligning manner to correctly control the width thereof and suppress variations in ON-resistance among a plurality of cells that are integrated. Consequently, the embodiment can suppress a current concentration and improve the reliability of the semiconductor device.

Next, a ground potential is again applied to the gate electrode 106 to switch the conductive state to a nonconductive state. The conduction electron accumulated state at the heterojunction interface between the first hetero-semiconductor region 103 and the drain region 102 is released to stop the tunneling of the energy barrier. Namely, the flow of conduction electrons from the first hetero-semiconductor region 103 to the drain region 102 stops. Conduction electrons in the drain region 102 flow to the substrate 101 and deplete. Then, a depletion layer extends from the heterojunction to the drain region 102, to establish the nonconductive state.

Like the conventional structure, this embodiment can realize reverse conduction (return operation) with the source electrode 107 being grounded and the drain electrode 108 receiving a negative potential. For example, the source electrode 107 and gate electrode 106 are grounded, and a predetermined positive potential is applied to the drain electrode 108. In this state, an energy barrier against conduction electrons disappears, so that conduction electrons flow from the drain region 102 to the first and second hetero-semiconductor regions 103 and 104, to establish the reverse conduction state. At this time, there is no injection of holes. Namely, the conductive state is established only with conduction electrons. As a result, a loss due to a reverse recovery current to shift the reverse conduction state to a nonconductive state is small. It is possible to use the gate electrode 106 as a control electrode instead of grounding the same.

Although the manufacturing method of the embodiment has been explained in connection with the structure of Fig. 1, the method is also applicable to structures shown in Figs. 4A to 8. The structures shown in Figs. 4A to 8 will be explained.

### (Semiconductor devices)

The embodiment of Fig. 1 forms the trench 113 in the surface of the drain region 102 and forms the gate insulating film 105 and gate electrode 106 in the trench 113, to provide a trench-type semiconductor device. Figure 4A shows a modification of the first embodiment with no trench in the drain region 102 to provide a planar-type semiconductor device.

To form the structure of Fig. 4A, a first polysilicon layer 400 (Fig. 2C) is etched by, for example, reactive ion etching. At this time, the surface of a drain region 102 is not etched, and only the first polysilicon layer 400 is etched and removed.

Thereafter, an end of the first polysilicon layer 400 is removed, and a space 115 is formed just under an end of a mask layer 109 (Fig. 2D). These processes and processes that follow are the same as those for forming the structure of Fig. 1, and therefore, the explanation thereof is omitted.

Figure 4B shows a semiconductor device according to another modification of the first embodiment of the present invention. The semiconductor device of Fig. 4B has an impurity diffusion preventive film 305 in addition to the structure of Fig. 1. The impurity diffusion preventive film 305 is formed between a first hetero-semiconductor region 103 and a second hetero-semiconductor region 104, to provide a heterojunction diode capable of reducing a leakage current occurring at an interface between the hetero-semiconductor regions 103 and 104.

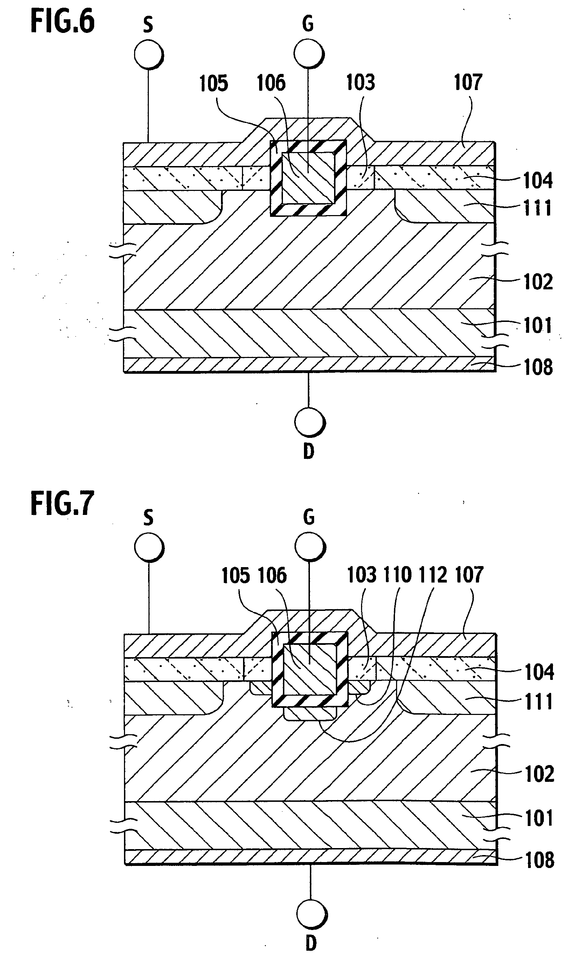

Figure 5 shows a semiconductor device according to still another modification of the first embodiment of the present invention. This device has, in addition to the structure of Fig. 1, an n⁺-type conductive region 110 whose impurity concentration is higher than that of a drain region 102. The conductive region 110 is formed in the drain region 102 at a location where a gate insulating film 105 is in contact with a first hetero-semiconductor region 103. The conductive region 110 is also formed at the bottom of a trench 113 under a gate electrode 106. An example of a method of manufacturing the structure of Fig. 5 will be explained.

A mask layer 109 is formed (Fig. 3B). Phosphorus doping is carried out in an atmosphere of, for example, POCl₃ at a high temperature so that phosphorus is introduced through an ion-etched surface of a polysilicon layer 104 and through a silicon carbide surface. Like the structure of Fig. 1, no phosphorus is introduced through the part covered with the mask layer 109. Accordingly, only in a region in contact with the ion-etched surface, the n-type first hetero-semiconductor region (polysilicon) 103 and n⁺-type conductive region 110 are simultaneously formed. The impurities may be introduced by solid state diffusion or ion implantation.

In a conductive state, the above-mentioned structure relaxes an energy barrier at a heterojunction between the first hetero-semiconductor region 103 and the conductive region 110, to easily pass majority carriers from the first hetero-semiconductor region 103 to the drain region 102 through the conductive region 110. This results in improving conductivity and reducing ON-resistance. The manufacturing method mentioned above is capable of correctly providing a part of the conductive region 110 that is in contact with the first hetero-semiconductor region 103 with a required minimum width. In addition, the method can form the conductive region 110 in a self-aligning manner simultaneously with the first hetero-semiconductor region 103. This results in suppressing current unevenness among cells in a conductive state as well as in a nonconductive state. Also minimized is a leakage current at a heterojunction between the first hetero-semiconductor region 103 and the conductive region 110 in a nonconductive state. Namely, this embodiment can reduce ON-resistance without deteriorating turn-off capability.

Figure 6 shows a semiconductor device according to still another modification of the first embodiment of the present invention. This device has a first field relaxation region 111 in addition to the structure of Fig. 1. The region 111 is formed at the surface of a drain region 102 in contact with a first hetero-semiconductor region 103 or a second hetero-semiconductor region 104. In Fig. 6, the region 111 is in contact with the second hetero-semiconductor region 104 and is separated by a predetermined distance from a location where the first hetero-semiconductor region 103 faces a gate electrode 106. An example of a method of manufacturing the semiconductor device of Fig. 6 will be explained.

In Fig. 2A of the first embodiment, a mask layer having a predetermined opening is used before forming the polysilicon layer 400. With the use of the mask layer, aluminum ions or boron ions are implanted to form the first field relaxation region 111. The region 111 may be formed according to solid state diffusion. Thereafter, the same processes as those for forming the structure of Fig. 1 are carried out.

According to the structure of Fig. 6, a depletion layer spreads in a nonconductive state between the first field relaxation region 111 and the drain region 102 according to a drain potential. Namely, a drain electric field acting on the heterojunction interfaces between the first and second hetero-semiconductor regions 103 and 104 and the drain region 102 is relaxed by the first field relaxation region 111, to further suppress a leakage current and improve turn-off capability.

Figure 7 shows a semiconductor device according to still another modification of the first embodiment of the present invention. This embodiment forms an n⁺-type conductive region 110 at a predetermined location in a drain region 102 where a gate insulating film 105 and a first hetero-semiconductor region 103 are in contact with each other. The impurity concentration of the conductive region 110 is higher than that of the drain region 102. In addition, this embodiment forms a first field relaxation region 111 at the surface of the drain region 102. The relaxation region 111 is separated by a predetermined distance from a part where a gate electrode 106 faces the first hetero-semiconductor region 103. The relaxation region 111 is in contact with the first hetero-semiconductor region 103 or a second hetero-semiconductor region 104 (in this embodiment, the second hetero-semiconductor region 104). In addition, a second field relaxation region 112 is formed in contact with the bottom of a trench 113 in which the gate electrode 106 is formed. An example of a method of manufacturing the semiconductor device of Fig. 7 will be explained.

Like the structure of Fig. 6, the first field relaxation region 111 (and simultaneously the second field relaxation region 112, if required) is formed in the state of Fig. 2A before forming a polysilicon layer 400. Thereafter, like the structure of Fig. 1, the polysilicon layer 400 and mask layer 109 are formed (Fig. 2B). Ion etching is carried out to form the trench 113 (Fig. 2C). With the mask layer 109, aluminum ions or boron ions are implanted to form the second field relaxation region 112. With the mask layer 109, phosphorus doping is carried out in, for example, a POCl₃ atmosphere at a high temperature to introduce phosphorus into the silicon carbide surface of the ion-etched polysilicon layer 400. This simultaneously forms the n-type polysilicon layer 103 and n⁺-type conductive region 110. According to this embodiment, the second field relaxation region 112 is formed, and thereafter, the first hetero-semiconductor region 103 and conductive region 110 are formed. Order of forming the regions 112, 103, and 110 is optional. Processes that follow are the same as those for forming the structure of Fig. 1.

In a conductive state, the above-mentioned structure relaxes an energy barrier at a heterojunction between the first hetero-semiconductor region 103 and the conductive region 110, to improve conductivity. Namely, the embodiment can further reduce ON-resistance and improve conductivity.

In a nonconductive state, a depletion layer spreads between the first and second field relaxation regions 111 and 112 and the drain region 102 according to a drain potential. The first field relaxation region 111 relaxes a drain electric field acting on the heterojunction interfaces between the first and second hetero-semiconductor regions 103 and 104 and the drain region 102. This further reduces a leakage current and improves turn-off capability. The second field relaxation region 112 relaxed a drain electric field acting on the gate insulating film 105, to prevent the dielectric breakdown of the gate insulating film 105, thereby improving the reliability of the gate insulating film 105. Although this embodiment forms all of the conductive region 110, first field relaxation region 111, and second field relaxation region 112, the effect of the embodiment will be provided if at least one of them is formed.

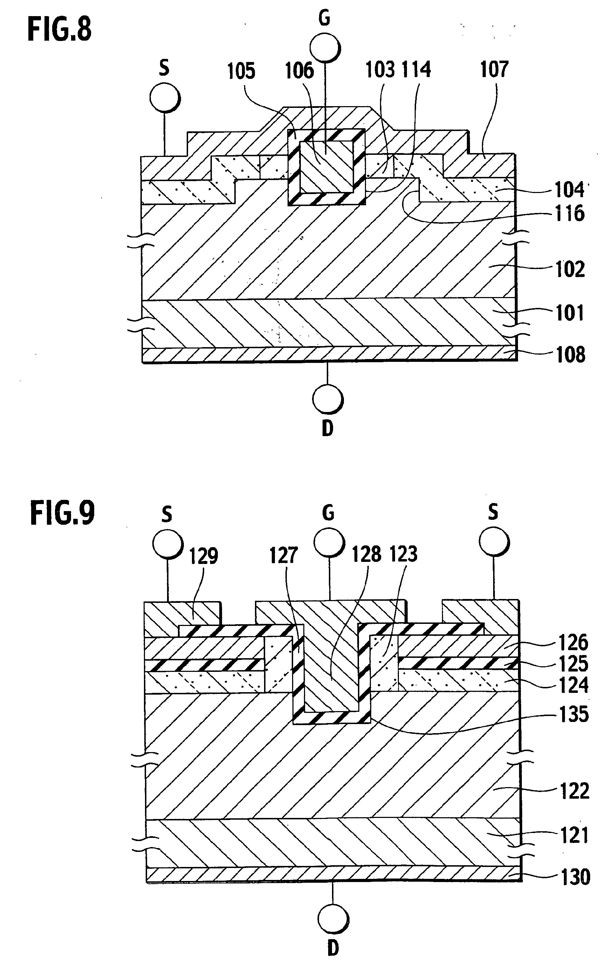

Figure 8 shows a semiconductor device according to still another modification of the first embodiment of the present invention. An example of a method of manufacturing this modification will be explained. In Fig. 2A, a trench 113 is formed in a drain region 102 before forming a polysilicon layer 400. Thereafter, the polysilicon layer 400 is formed. Processes that follow are the same as those for forming the structure of Fig. 1. Compared with the structure of Fig. 1, the structure of Fig. 8 can further reduce a leakage current at a first hetero-semiconductor region 103. In this way, the basic processes according to the present invention shown in Figs. 2A to 3D are usable to form the semiconductor devices of different structures shown in Figs. 4A to 8.

As explained above, a semiconductor device according to the above-mentioned embodiment of the present invention has a semiconductor base (consisting of a substrate 101 and a drain region 102) of a first conductivity type, a first hetero-semiconductor region 103 and a second hetero-semiconductor region 104 that are in contact with a principal surface of the semiconductor base and have different band gaps from that of the semiconductor base, a gate electrode 106 formed on a gate insulating film 105 at a junction between the first hetero-semiconductor region 103 and the semiconductor base, a source electrode 107 formed in contact with the first hetero-semiconductor region 103, and a drain electrode 108 formed in ohmic-contact with the semiconductor base. A method of manufacturing such a semiconductor device at least includes a first process of forming a semiconductor layer 400, which is used to form the second hetero-semiconductor region, on a principal surface of a semiconductor base, a second process of employing a mask layer 109 provided with a predetermined opening 114, selectively etching the semiconductor layer 400, and forming the second hetero-semiconductor region 104, a third process of forming, with the mask layer 109, a semiconductor layer 300 which is used to form the first hetero-semiconductor region, a fourth process of selectively etching the semiconductor layer 300 and forming the first hetero-semiconductor region 103, and a fifth process of forming the gate insulating film 105 in contact with the first hetero-semiconductor region 103 and semiconductor base. In a conductive state, a heterojunction between the first hetero-semiconductor region 103 of the first conductivity type and the drain region 102 serves as a channel to pass a current. This realizes ON-resistance equivalent to that of the related art In a nonconductive state, a second heterojunction between the second hetero-semiconductor region 104 and the drain region 102 can reduce a leakage current more than the related art because the second hetero-semiconductor region 104 is of a second conductivity type. To realize high withstand voltage and high drive power, impurities must be separately implanted into the hetero-semiconductor regions depending on their respective conductivity types. It is difficult for ion implantation to provide only a drive part with the first conductivity type, and there is a risk of causing a pattern deviation that may bias a current. The embodiment can easily form the very narrow first hetero-semiconductor region 103 of the first conductivity type. The embodiment can form the first hetero-semiconductor region 103 in a self-aligning manner, to prevent the current biasing.

One of the second and fourth processes simultaneously and selectively etches the surface of the semiconductor base when selectively etching a corresponding one of the second hetero-semiconductor layer (second-hetero-semiconductor-region-forming semiconductor layer) 400 and a first hetero-semiconductor layer (first-hetero-semiconductor-region-forming semiconductor layer) 300. This helps forming the gate electrode 106 to face, through the gate insulating film 105, a first heterojunction between the first hetero-semiconductor region 103 and the drain region 102. With this structure, it is easy to apply a gate electric field to the first heterojunction in a conductive state, to further reduce ON-resistance.

Included after the first process is at least a process of introducing impurities into a predetermined part of the second hetero-semiconductor layer 400 so that the second hetero-semiconductor region 104 may have a second conductivity type. This easily forms the second hetero-semiconductor region 104 of the second conductivity type.

Included before the third process is at least a process of removing an end of the second hetero-semiconductor layer 400 by a predetermined width, so that a space 115 is formed just under an end of the mask layer 109. This easily forms the first hetero-semiconductor region 103 of the first conductivity type in a very narrow region.

Included between the third process and the fifth process is at least a process of introducing, with the mask layer 109 being left, impurities into the first hetero-semiconductor layer 300. This easily forms the first hetero-semiconductor region 103 of the first conductivity type in a very narrow region.

The third process may introduce impurities into the first hetero-semiconductor layer 300. This easily forms the first hetero-semiconductor region 103 of the first conductivity type in a very narrow region.

The semiconductor base is made of silicon carbide. Namely, the high-voltage withstanding semiconductor device of the embodiment is easy to form from standard semiconductor materials.

The first hetero-semiconductor region 103 is formed from at least one of monosilicon, polysilicon, and amorphous silicon. Namely, the semiconductor device of the embodiment is easy to form from standard semiconductor materials.

The second hetero-semiconductor region 104 is formed from at least one of monosilicon, polysilicon, and amorphous silicon. Namely, the semiconductor device of the embodiment is easy to form from standard semiconductor materials.

In this way, the semiconductor device according to the embodiment is a high-voltage withstanding field effect transistor capable of securing a drive power equivalent to that of the related art and reducing a leakage current produced at a hetero-interface.

### (Second embodiment)

Figure 9 is a sectional view showing two structural unit cells that face each other of a semiconductor device according to a second embodiment of the present invention. The semiconductor device according to this embodiment employs, for example, silicon carbide (SiC) as a substrate material.

The semiconductor device according to the second embodiment has an n⁺-type SiC substrate 121 made of silicon carbide whose polytype is,: for example, 4H. On the substrate 121, a drain region 122 is formed from an n⁻-type SiC epitaxial layer. In contact with a principal surface that is opposite to a junction between the drain region 122 and the substrate 121, there are formed a first hetero-semiconductor region 123 made of, for example, an n-type polysilicon and a second hetero-semiconductor region 124 made of, for example, p-type polysilicon. Namely, junctions between the drain region 122 and the first and second hetero-semiconductor regions 123 and 124 are heterojunctions made of SiC and polysilicon having different band gaps. Along the heterojunctions, there are energy barriers. In contact with a junction interface between the first hetero-semiconductor region 123 and the drain region 122, there is formed a gate insulating film 127 made of, for example, a silicon oxide film. On the gate insulating film 127, there is formed a gate electrode 128. Opposite to the junction interfaces between the first and second hetero-semiconductor regions 123 and 124 and the drain region 122, there is formed a source electrode 129. Opposite to the source electrode 129, there is formed a drain electrode 130 on the bottom surface of the substrate 121.

Like the structure of Fig. 1, the polysilicon layers formed on the drain region 122 include a portion that is in contact with the drain region 122 and is of a second conductivity type, i.e., p-type to form the second hetero-semiconductor region 124. Parts of the second embodiment that are different from those of the first embodiment of Fig. 1 will be explained. On the second hetero-semiconductor region 124, there is formed an interlayer insulating film 125. On the interlayer insulating film 125, there is formed a semiconductor region 126 of a first conductivity type, i.e., n-type. Like the structure of Fig. 1, a part in the vicinity of the gate insulating film 127 includes the first hetero-semiconductor region 123 that is of n-type and is narrow. The first hetero-semiconductor region 123 is low in electrical resistance and is connected to the semiconductor region 126. In this way, the second embodiment has the two polysilicon layers having different conductivity types, to maintain a turn-off capability at the hetero-interface between the second hetero-semiconductor region 124 and the drain region 122 and allow the wide surface of the semiconductor region 126 to directly contact with the source electrode 129. Operation of this semiconductor device is basically the same as that of the first embodiment. With this configuration, the semiconductor device of the second embodiment provides excellent turn-off capability and low ON-resistance without forming a field relaxation region in the drain region 122.

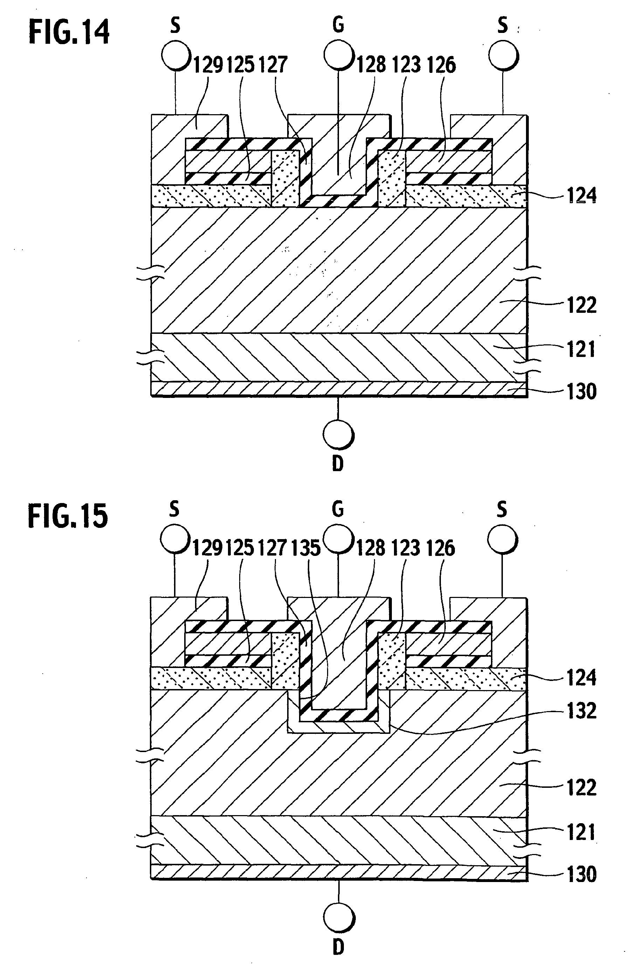

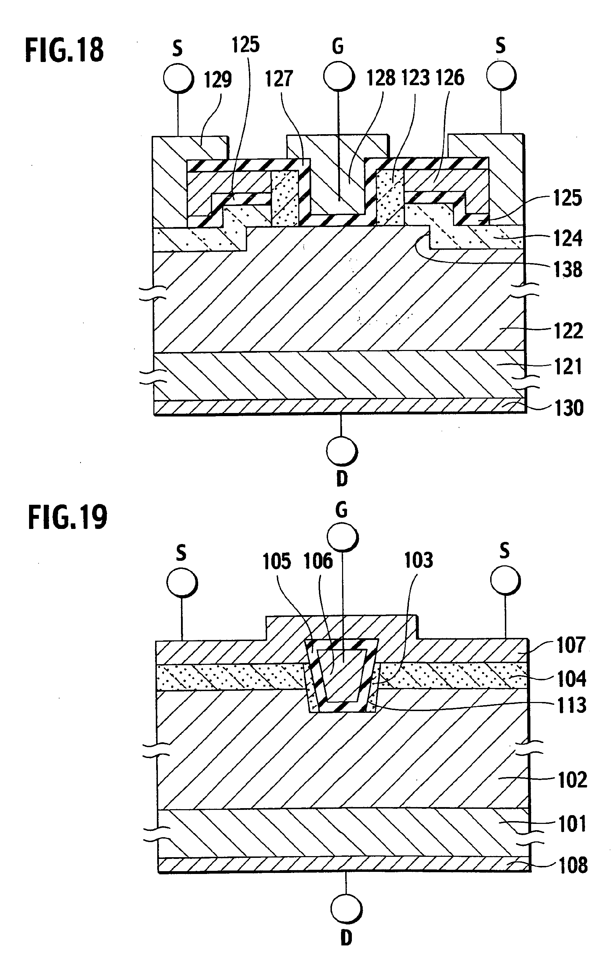

According to the second embodiment of Fig. 9, a trench 135 is formed in the surface of the drain region 122, and the gate insulating film 127 and gate electrode 128 are formed in the trench 135, to provide a trench-type semiconductor device. As shown in Figs. 14 and 18, the drain region 122 may have no trench, to provide a planar semiconductor device.

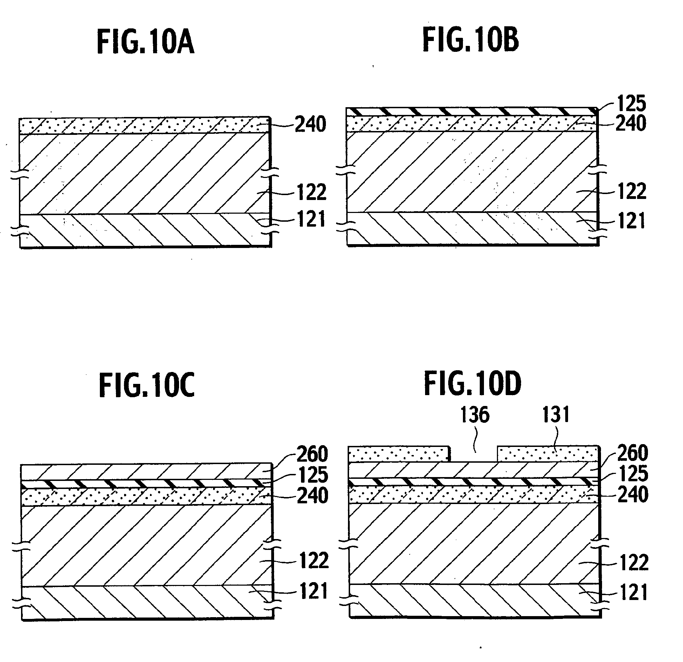

A method of manufacturing the silicon carbide semiconductor device of the second embodiment shown in Fig. 9 will be explained with reference to Figs. 10A to 12B.

In Fig. 10A, an n⁺-type SiC substrate 121 is prepared. On the substrate 121, an n-type drain region 122 is epitaxially grown, to form an n-type silicon carbide semiconductor base. On the semiconductor base, a first polysilicon layer 240 (to form the second hetero-semiconductor region 124) is deposited by, for example, LP-CVD. Boron doping is carried out in an atmosphere of, for example, BBr₃ to form a p-type first polysilicon layer 240. The first polysilicon layer 240 may be formed by deposition according to an electron beam deposition method or a spattering method and by recrystallization according to, for example, a laser annealing method. Alternatively, the first polysilicon layer 240 may be formed from monosilicon epitaxially grown according to, for example, molecular-beam epitaxy. The doping may be carried out with the use of a combination of ion implantation and activation heat treatment. The drain region 122 may have an impurity concentration of, for example, 1 x 10¹⁶ cm⁻³ and a thickness of, for example, 10 ,,m. The first polysilicon layer 240 may have a thickness of, for example, 0.5 ,,m.

In Fig. 10B, on the first polysilicon layer 240, an interlayer insulating film 125 is formed. In Fig. 10C, on the interlayer insulating film 125, an n-type second polysilicon layer 260 (to form the semiconductor region 126) by, for example, LP-CVD. In Fig. 10D, a silicon nitride film is deposited on the second polysilicon layer 260 according to, for example, LP-CVD. An opening 136 is formed in the silicon nitride film according to photolithography and etching, to form a mask layer 131. Although the mask layer 131 is made of a silicon nitride film in this embodiment, it may be made of any other material if the material is appropriate for selective etching and is easy to remove.

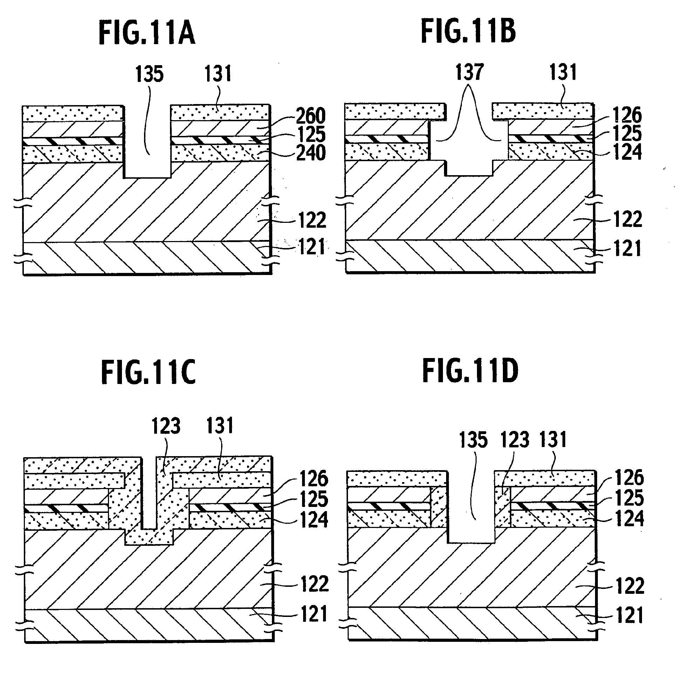

In Fig. 11A, the second polysilicon layer 260, interlayer insulating film 125, first polysilicon layer 240, and a surface part of the drain region 122 are etched according to, for example, reactive ion etching (dry etching), to form a trench 135 having a predetermined depth. The polysilicon layers 240 and 260 and interlayer insulating film 125 may be etched according to any other etching method such as wet etching.

In Fig. 11B, a space 137 is formed just under an end of the mask layer 131 by removing ends of the second polysilicon layer 260, interlayer insulating film 125, and first polysilicon layer 240. For example, with the mask layer 131, the polysilicon layers 240 and 260 and interlayer insulating film 125 are oxidized in an oxygen atmosphere. At this time, the surface of the polysilicon layer 260 covered with the silicon nitride mask layer 131 is not oxidized, and only the exposed ends of the polysilicon layers 240 and 260 and interlayer insulating film 125 are oxidized.

The ends of the polysilicon layers 240 and 260 and interlayer insulating film 125 are oxidized by, for example, 0.1"m and are wet-etched with, for example, hydrofluoric acid. As a result, the oxidized end parts (0.1 "m in this example) of the polysilicon layers 240 and 260 and interlayer insulating film 125 are removed to form the space 137 just under the end of the mask layer 131. The ends of the polysilicon layers 240 and 260 and interlayer insulating film 125 may be etched according to any other etching method. This completes the second hetero-semiconductor region 124 and the semiconductor region 126.

In Fig. 11C, a third polysilicon layer 123 (to form the first hetero-semiconductor region 123) is deposited according to, for example, LP-CVD. At this time, the third polysilicon layer 123 is isotropically formed along the exposed surfaces of the layers, and therefore, the space 137 (Fig. 11B) formed just under the end of the mask layer 131 is filled with the third polysilicon layer 123. The conductivity type and impurity concentration of the third polysilicon layer 123 are determined according to design specifications. According to this embodiment, the third polysilicon layer 123 is of an n-type and has a thickness of 0.5 "m.

In Fig. 11D, reactive ion etching (dry etching) is carried out to remove the third polysilicon layer 123 except the part just under the end of the mask layer 131. This forms the first hetero-semiconductor region 123 having a narrow width (0.1 ,,m in this embodiment). In this way, the first hetero-semiconductor region 123 is formed in a self-aligning manner to have a narrow width by, for example, thermal oxidation capable of controlling the thickness of the region 123. The polysilicon layer may be etched by any other etching method such as wet etching.

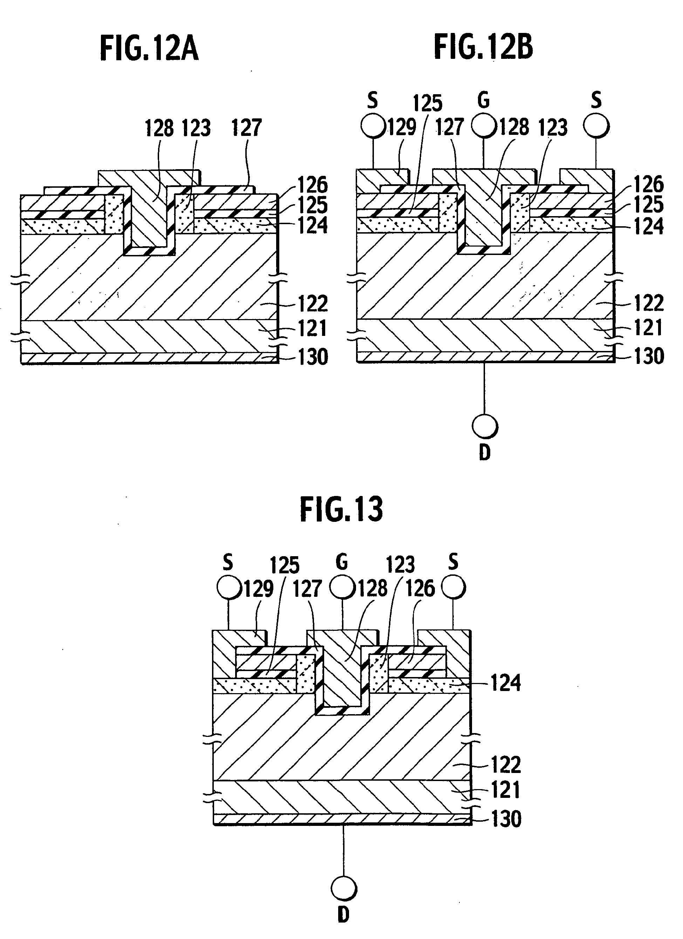

In Fig. 12A, the mask layer 131 is removed by, for example, phosphoric acid. Thereafter, a gate insulating film 127 is deposited over the first hetero-semiconductor region 123 and semiconductor region 126 and along the inner wall of the trench 135. On the gate insulating film 127, a polysilicon layer to form a gate electrode 128 is deposited. Solid state diffusion with POCl₃ is achieved to dope the gate-electrode-forming polysilicon layer with phosphorus. Photolithography and etching are carried out to form the gate electrode 128. Photolithography and etching are carried out to remove a predetermined part of the gate insulating film 127 on the semiconductor region 126, thereby opening a contact hole (not shown). Like the first embodiment of Fig. 1, the top of the gate electrode 128 may be capped by again depositing a gate insulating film 127. In this case, photolithography and etching must be carried out to remove the gate insulating film 127 from a part of the top surface of the semiconductor region 126 and form a contact hole.

In Fig. 12B, a drain electrode 130 is formed on the bottom surface of the substrate 121 from titanium (Ti) and nickel (Ni). On the surfaces of the semiconductor region 126, a source electrode 129 is formed by sequentially depositing titanium (Ti) and aluminum (Al), to thereby complete the silicon carbide semiconductor device according to the second embodiment of the present invention shown in Fig. 9.

In this way, the semiconductor device according to this embodiment is easy to realize with the use of conventional manufacturing techniques. The manufacturing method according to the embodiment is capable of forming the narrow first hetero-semiconductor region 123 in a self-aligning manner. In addition, the manufacturing method according to this embodiment is capable of freely designing the conductivity type and impurity concentration of the first hetero-semiconductor region 123 that contacts the gate electrode 128 through the gate insulating film 127.

Operation of the semiconductor device according to this embodiment of the present invention will be explained. For example, the source electrode 129 is grounded, and a positive potential is applied to the drain electrode 130. If a ground potential or a negative potential is applied to the gate electrode 128, a nonconductive state (OFF state, or disconnected state) is maintained. Namely, heterojunction interfaces between the first and second hetero-semiconductor regions 123 and 124 and the drain region 122 form energy barriers against conduction electrons. The first and second hetero-semiconductor regions 123 and 124 are each made of silicon material, and therefore, substantially form the same energy barrier difference ,,EC relative to the drain region 122 made of silicon carbide. However, the n-type first hetero-semiconductor region 123 and p-type second hetero-semiconductor region 124 differ from each other in Fermi energy that is energy from a conduction band to Fermi level. Accordingly, the regions 123 and 124 form depletion layers having different widths, the depletion layers extending from the junction interfaces with the drain region 122. More precisely, the width of the depletion layer extending from the junction interface of the second hetero-semiconductor region 124 is larger than that of the depletion layer extending from the junction interface of the first hetero-semiconductor region 123, to block a leakage current. If the impurity concentration of the second hetero-semiconductor region 124 is set to be higher than that of the first hetero-semiconductor region 123, a depletion layer that is produced by a built-in electric field of a pn diode formed from the second hetero-semiconductor region 124 and first hetero-semiconductor region 123 extends toward the first hetero-semiconductor region 123. This may further reduce a leakage current at the heterojunction between the first hetero-semiconductor region 123 and the drain region 122.

The manufacturing method according to the embodiment is capable of easily controlling the width of the first hetero-semiconductor region 123 to cover a gate electric field extending from the gate electrode 128. It is possible, for example, to form an inverted region over the first hetero-semiconductor region 123 when a negative potential is applied to the gate electrode 128, thereby further improving the turn-off capability of the semiconductor device.

According to this embodiment, the first hetero-semiconductor region 123 is formed in a self-aligning manner. Due to this, the width of the first hetero-semiconductor region 123 is correctly controllable even when integrating a plurality of cells. This eliminates variations in turn-off capability among the cells. In addition, this embodiment forms the first hetero-semiconductor region 123 from a polysilicon layer that is different from a polysilicon layer forming the second hetero-semiconductor region 124. Accordingly, the embodiment can freely set the conductivity type and concentration of impurities to improve the degree of designing freedom.

Next, a positive potential is applied to the gate electrode 128 to change the nonconductive state to a conductive state. Through the gate insulating film 127, a gate electric field extends up to the heterojunction interface between the first hetero-semiconductor region 123 and the drain region 122. As a result, an accumulation layer of conduction electrons is formed in the first hetero-semiconductor region 123 and drain region 122 around the gate electrode 128. Namely, at the junction interface between the first hetero-semiconductor region 123 and the drain region 122 in the vicinity of the gate electrode 128, the potential of the first hetero-semiconductor region 123 is pushed down, and the energy barrier on the drain region 122 side becomes steep to pass conduction electrons through the energy barrier.

Here, the first hetero-semiconductor region 123 has been formed in a self-aligning manner to correctly control the width thereof and suppress variations in ON-resistance among a plurality of cells that are integrated. Consequently, the embodiment can suppress a current concentration and improve the reliability of the semiconductor device.

Next, a ground potential is again applied to the gate electrode 128 to switch the conductive state to a nonconductive state. The conduction electron accumulated state at the heterojunction interface between the first hetero-semiconductor region 123 and the drain region 122 is released to stop the tunneling of the energy barrier. Namely, the flow of conduction electrons from the first hetero-semiconductor region 123 to the drain region 122 stops. Conduction electrons in the drain region 122 flow to the substrate 121 and deplete. Then, a depletion layer extends from the heterojunction to the drain region 122, to establish the nonconductive state. Like the conventional structure, this embodiment can realize reverse conduction (return operation) with the source electrode 129 being grounded and the drain electrode 130 receiving a negative potential. For example, the source electrode 129 and gate electrode 128 are grounded, and a predetermined positive potential is applied to the drain electrode 130. In this state, an energy barrier against conduction electrons disappears, so that conduction electrons flow from the drain region 122 to the first and second hetero-semiconductor regions 123 and 124, to establish the reverse conduction state. At this time, there is no injection of holes. Namely, the conductive state is established only with conduction electrons. As a result, a loss due to a reverse recovery current to shift the reverse conduction state to a nonconductive state is small. It is possible to use the gate electrode 128 as a control electrode instead of grounding the same.

Although the manufacturing method of the embodiment has been explained in connection with the structure of Fig. 9, the method is also applicable to structures shown in Figs. 13 to 18. The structures shown in Figs. 13 to 18 will be explained.

Figure 13 shows a semiconductor device according to a modification of the second embodiment of the present invention. Unlike the structure of Fig. 9 that makes the source electrode 129 contact only the semiconductor region 126, the structure of Fig. 13 makes a source electrode 129 contact a semiconductor region 126 and a second hetero-semiconductor region 124. Unlike the structure of Fig. 9 that removes only a predetermined part of the upper interlayer insulating film to contact the source electrode 129 with the semiconductor region 126, the structure of Fig. 13 removes an upper interlayer insulating film, the semiconductor region 126, and an interlayer insulating film 125, to contact the source electrode 129 with the semiconductor region 126 and second hetero-semiconductor region 124. In a nonconductive state, the structure of Fig. 13 can pass a hole current generated in a drain region 122 to the source electrode 129 through the semiconductor region 126, to improve a withstand voltage in the nonconductive state. In addition, the structure of Fig. 13 improves a withstand voltage during a transition period from a conductive state to a nonconductive state, as well as resistance against an external surge. In a reverse conduction state in which a current is passed from the source electrode 129 to a drain electrode 130, there are formed a current path from the source electrode 129 through the semiconductor region 126 and first hetero-semiconductor region 123 to the drain region 122, as well as a current path from the source electrode 129 through the second hetero-semiconductor region 124 to the drain region 122. Namely, resistance against the current is further lowered.

The structure of Fig. 13 forms a trench 135 in the surface of the drain region 122, and in the trench 135, forms the gate insulating film 127 and gate electrode 128, to provide a trench-type semiconductor device. The drain region 122 may have not trench, to constitute a planar-type semiconductor device as shown in Fig. 14.

To form the structure of Fig. 14, polysilicon layers 124 and 126 and interlayer insulating film 125 are etched by, for example, reactive ion etching (Fig. 11A). At this time, only the polysilicon layers 124 and 126 and interlayer insulating film 125 are removed without removing the surface of the drain region 122.

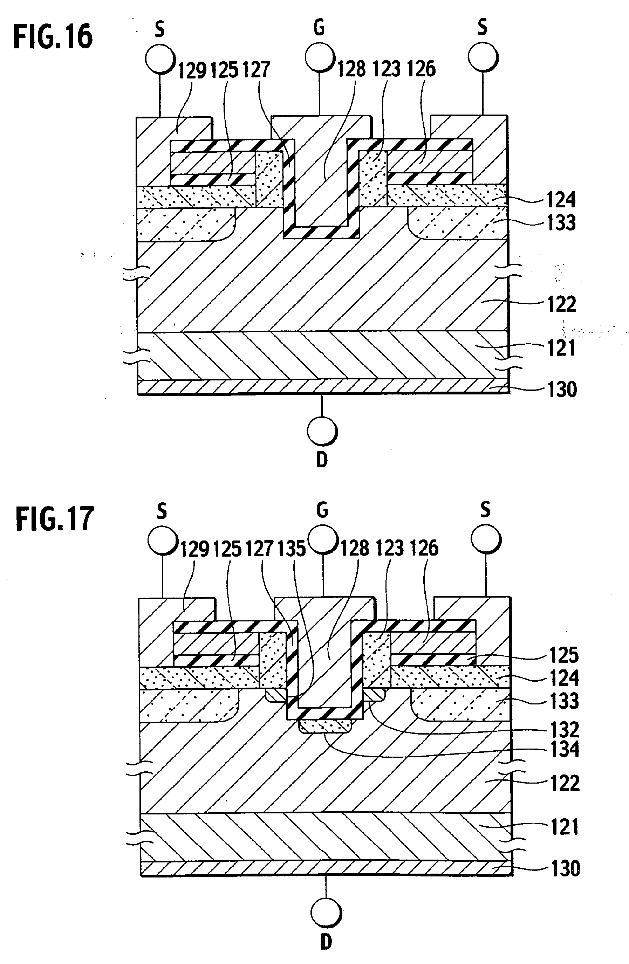

Processes that follow are the same as those for forming the structure of Fig. 9, and therefore, the explanation thereof is omitted. In Fig. 14, a source electrode 129 is in contact with the semiconductor region 126 and second hetero-semiconductor region 124. The same configuration appears in the structures of Figs. 15 to 18.

Figure 15 shows a semiconductor device according to still another modification of the second embodiment of the present invention. In addition to the structure of Fig. 13, the structure of Fig. 15 has an n⁺-type conductive region 132 in a predetermined part of a drain region 122 that is in contact with a gate insulating film 127 and a first hetero-semiconductor region 123. The impurity concentration of the conductive region 132 is higher than that of the drain region 122. The conductive region 132 is formed at the bottom of a trench 135 in which a gate electrode 128 is formed. An example of a method of manufacturing this semiconductor device will be explained.

A mask layer 131 is formed (Fig. 11D). Phosphorus doping is carried out in an atmosphere of, for example, POCl₃ at a high temperature so that phosphorus is introduced through the ion-etched surfaces of polysilicon layers 124 and 126 and interlayer insulating film 125 and through a silicon carbide surface. Like the structure of Fig. 9, no phosphorus is introduced through the part covered with the mask layer 131. Accordingly, only in a region in contact with the ion-etched surfaces, the n-type polysilicon layer 123 and n⁺-type conductive region 132 are simultaneously formed. The impurities may be introduced by solid state diffusion or ion implantation.

In a conductive state, the above-mentioned structure relaxes an energy barrier at a heterojunction between the first hetero-semiconductor region 123 and the conductive region 132, to improve conductivity. The manufacturing method mentioned above is capable of correctly providing a part of the conductive region 132 that is in contact with the first hetero-semiconductor region 123 with a required minimum width. In addition, the method can form the conductive region 132 in a self-aligning manner simultaneously with the first hetero-semiconductor region 123. This results in suppressing current unevenness among cells in a conductive state as well as in a nonconductive state. Also minimized is a leakage current at a heterojunction between the first hetero-semiconductor region 123 and the conductive region 132 in a nonconductive state. Namely, this embodiment can reduce ON-resistance without deteriorating turn-off capability.

Figure 16 shows a semiconductor device according to still another modification of the second embodiment of the present invention. In addition to the structure of Fig. 13, the structure of Fig. 16 has a first field relaxation region 133. The region 133 is formed at the surface of a drain region 122 in contact with a first hetero-semiconductor region 123 or a second hetero-semiconductor region 124. In Fig. 16, the region 123 is in contact with the second hetero-semiconductor region 124 and is separated by a predetermined distance from a location where the first hetero-semiconductor region 123 faces a gate electrode 128. An example of a method of manufacturing the semiconductor device of Fig. 16 will be explained.

In Fig. 10A of the second embodiment, a mask layer having a predetermined opening is formed before forming a polysilicon layer 240. With the use of the mask layer, aluminum ions or boron ions are implanted to form the first field relaxation region 133. The region 133 may be formed according to solid state diffusion. Thereafter, the same processes as those for forming the structure of Fig. 9 are carried out. According to the structure of Fig. 16, a depletion layer spreads in a nonconductive state between the first field relaxation region 133 and the drain region 122 according to a drain potential. Namely, a drain electric field acting on the heterojunction interfaces between the first and second hetero-semiconductor regions 123 and 124 and the drain region 122 is relaxed by the first field relaxation region 133, to further reduce a leakage current and improve turn-off capability.

Figure 17 shows a semiconductor device according to still another modification of the second embodiment of the present invention. This embodiment forms an n⁺-type conductive region 132 at a predetermined location of a drain region 122 where a gate insulating film 127 and a first hetero-semiconductor region 123 are in contact with each other. The impurity concentration of the conductive region 132 is higher than that of the drain region 122. In addition, this embodiment forms a first field relaxation region 133 at the surface of the drain region 122. The region 133 is separated by a predetermined distance from a part where a gate electrode 128 faces the first hetero-semiconductor region 123. The relaxation region 133 is in contact with the first hetero-semiconductor region 123 or a second hetero-semiconductor region 124 (in this embodiment, the second hetero-semiconductor region 124). In addition, a second field relaxation region 134 is formed in contact with the bottom of a trench 135 in which the gate electrode 128 is formed. An example of a method of manufacturing the semiconductor device of Fig. 17 will be explained.

Like the structure of Fig. 16, the first field relaxation region 133 (and simultaneously the second field relaxation region 134, if required) is formed in the state of Fig. 10A before forming a polysilicon layer 240. Thereafter, like the structure of Fig. 9, the polysilicon layer 240 and mask layer 131 are formed (Fig. 10D). Ion etching is carried out to form a trench 135 (Fig. 11A). With the mask layer 131, aluminum ions or boron ions are implanted to form the second field relaxation region 134. With the mask layer 131, phosphorus doping is carried out in, for example, a POCl₃ atmosphere at high temperature, to introduce phosphorus into the silicon carbide surfaces of the ion-etched polysilicon layers 124 and 126 and interlayer insulating film 125. This simultaneously forms the n-type polysilicon layer 123 and n⁺-type conductive region 132. According to this embodiment, the second field relaxation region 134 is formed, and thereafter, the first hetero-semiconductor region 123 and conductive region 132 are formed. Order of forming the regions 134, 123, and 132 is optional. Processes that follow are the same as those for forming the structure of Fig. 9.

In a conductive state, the above-mentioned structure relaxes an energy barrier at the heterojunction between the first hetero-semiconductor region 123 and the conductive region 132, to improve conductivity. Namely, the embodiment can further reduce ON-resistance to improve conductivity.

In a nonconductive state, a depletion layer spreads between the first and second field relaxation regions 133 and 134 and the drain region 122 according to a drain potential. Namely, the first field relaxation region 133 relaxes a drain electric field acting on the heterojunction interface between the first and second hetero-semiconductor regions 123 and 124 and the drain region 122. This further reduces a leakage current and improves turn-off capability. The second field relaxation region 134 relaxed a drain electric field acting on the gate insulating film 127, to prevent the dielectric breakdown of the gate insulating film 127, thereby improving the reliability of the gate insulating film 127.

Although this embodiment forms all of the conductive region 132, first field relaxation region 133, and second field relaxation region 134, the effect of the embodiment will be provided if at least one of them is formed.

Figure 18 shows a semiconductor device according to still another modification of the second embodiment of the present invention. An example of a method of manufacturing this semiconductor device will be explained. In Fig. 10A, a trench 138 is formed in a drain region 122 before forming a polysilicon layer 240. Thereafter, the polysilicon layer 240 is formed. Processes that follow are the same as those for forming the structure of Fig. 9. Compared with the structure of Fig. 9, the structure of Fig. 18 can further reduce a leakage current at a first hetero-semiconductor region 123.

In this way, the basic processes according to the second embodiment of the present invention shown in Figs. 10A to 12B are usable to form the different structures shown in Figs. 13 to 18.

As explained above, a semiconductor device according to the above-mentioned embodiment of the present invention has a semiconductor base (consisting of a substrate 121 and a drain region 122) of a first conductivity type, a first hetero-semiconductor region 123 and a second hetero-semiconductor region 124 that are in contact with a principal surface of the semiconductor base and have different band gaps from that of the semiconductor base, a semiconductor region 126 that is in contact with the first hetero-semiconductor region 123 and is formed on at least a part of the second hetero-semiconductor region 124 through an interlayer insulating film 125, a gate electrode 128 formed on a gate insulating film 127 at a junction between the first hetero-semiconductor region 123 and the semiconductor base, a source electrode 129 connected through the semiconductor region 126 to the first hetero-semiconductor region 123, and a drain electrode 130 formed in ohmic-contact with the semiconductor base. A method of manufacturing such a semiconductor device at least includes a first process of forming a semiconductor layer 240, which is used to form a second hetero-semiconductor region, on a principal surface of a semiconductor base, a second process of forming an interlayer insulating film 125 in contact with at least the semiconductor layer 240, a third process of forming a semiconductor layer 260 in contact with at least the interlayer insulating film 125, a fourth process of employing a mask layer 131 provided with a predetermined opening 136, selectively etching the semiconductor layer 240, interlayer insulating film 125, and semiconductor layer 260, and forming the second hetero-semiconductor region 124, interlayer insulating film 125, and semiconductor region 126, a fifth process of forming, with the mask layer 131, a semiconductor layer 230 which is used to form a first hetero-semiconductor region, a sixth process of selectively etching the semiconductor layer 230 and forming the first hetero-semiconductor region 123, and a seventh process of forming a gate insulating film 127 in contact with the first hetero-semiconductor region 123 and semiconductor base. In a conductive state, a heterojunction between the first hetero-semiconductor region 123 of the first conductivity type and the drain region 122 serves as a channel to pass a current This realizes ON-resistance equivalent to that of the related art. In a nonconductive state, a second heterojunction between the second hetero-semiconductor region 124 and the drain region 122 can reduce a leakage current more than the related art because the second hetero-semiconductor region 124 is of a second conductivity type. To realize high withstand voltage and high drive power, impurities must be separately implanted into the hetero-semiconductor regions depending on their respective conductivity types. It is difficult for ion implantation to provide only a drive part with the first conductivity type, and there is a risk of causing a pattern deviation that may bias a current. The embodiment can easily form the very narrow first hetero-semiconductor region 123 of the first conductivity type. The embodiment can form the first hetero-semiconductor region 123 in a self-aligning manner, to prevent the current biasing. Forming the semiconductor region 126 on the second hetero-semiconductor region 124 through the interlayer insulating film 125 enables the size of a contact hole for connection to the source electrode 129 to be freely designed. The semiconductor device according to the embodiment, therefore, is capable of realizing a required source contact resistance and is easy to manufacture.

One of the fourth and sixth processes simultaneously and selectively etches the surface of the semiconductor base when selectively etching a corresponding one of the second hetero-semiconductor layer 240 and the first hetero-semiconductor layer 230. This helps forming the gate electrode 128 to face, through the gate insulating film 127, a first heterojunction between the first hetero-semiconductor region 123 and the drain region 122. With this structure, it is easy to apply a gate electric field to the first heterojunction in a conductive state, to further reduce ON-resistance.

Included after the first process is at least a process of introducing impurities into a predetermined region of the second hetero-semiconductor layer 240 so that the second hetero-semiconductor region 124 may have a second conductivity type. This easily forms the second hetero-semiconductor region 124 of the second conductivity type.

Included before the fifth process is at least a process of removing an end of any one of the second hetero-semiconductor layer 240, interlayer insulating film 125, and semiconductor layer 260 by a predetermined width, so that a space 137 is formed just under an end of the mask layer 131. This easily forms the first hetero-semiconductor region 123 of the first conductivity type in a very narrow region.

Included between the fifth process and the seventh process is at least a process of introducing, with the mask layer 131 being left, impurities into the first hetero-semiconductor layer 230. This easily forms the first hetero-semiconductor region 123 of the first conductivity type in a very narrow region.

The fifth process may introduce impurities into the first hetero-semiconductor layer 230. This easily forms the first hetero-semiconductor region 123 of the first conductivity type in a very narrow region.

When connecting the first hetero-semiconductor region 123 to the source electrode 129 through the semiconductor region 126, there is included at least a process of simultaneously connecting the second hetero-semiconductor region 124 to the source electrode 129 by etching predetermined parts of the semiconductor region 126 and interlayer insulating film 125. This easily realizes a structure that simultaneously connects the semiconductor region 126 and second hetero-semiconductor region 124 to the source electrode 129. When forming the source contact, the predetermined parts of the semiconductor region 126 and interlayer insulating film 125 may be simultaneously etched to simplify the manufacturing processes.

A semiconductor device according to the embodiment or modifications mentioned above has a semiconductor base of a first conductivity type, a first hetero-semiconductor region 123 and a second hetero-semiconductor region 124 that are in contact with a principal surface of the semiconductor base and have different band gaps from that of the semiconductor base, a semiconductor region 126 that is in contact with the first hetero-semiconductor region 123 and is formed on at least a part of the second hetero-semiconductor region 124 through an interlayer insulating film 125, a gate electrode 128 formed on a gate insulating film 127 at a junction between the first hetero-semiconductor region 123 and the semiconductor base, a source electrode 129 connected through the semiconductor region 126 to the first hetero-semiconductor region 123, and a drain electrode 130 formed in ohmic-contact with the semiconductor base. The source electrode 129 is passed through at least the interlayer insulating film 125 and is connected to the second hetero-semiconductor region 124 (Figs. 13 to 18). In a nonconductive state, this structure can pass a hole current generated in the drain region 122 to the source electrode 129 through the semiconductor region 126, to improve a withstand voltage in the nonconductive state. In addition, this structure improves a withstand voltage during a transition period from a conductive state to a nonconductive state, as well as increasing resistance against an external surge. In a reverse conduction state in which a current is passed from the source electrode 129 to the drain electrode 130, there are formed a current path from the source electrode 129 through the semiconductor region 126 and first hetero-semiconductor region 123 to the drain region 122, as well as a current path from the source electrode 129 through the second hetero-semiconductor region 124 to the drain region 122. This configuration further lowers resistance against the current

The semiconductor base is made of silicon carbide. Namely, the high-voltage withstanding semiconductor device of the embodiment is easy to form from standard semiconductor materials.

The first hetero-semiconductor region 123 is formed from at least one of monosilicon, polysilicon, and amorphous silicon. Namely, the semiconductor device of the embodiment is easy to form from standard semiconductor materials. The second hetero-semiconductor region 124 is formed from at least one of monosilicon, polysilicon, and amorphous silicon. Namely, the semiconductor device of the embodiment is easy to form from standard semiconductor materials. The semiconductor region 126 and first hetero-semiconductor region 123 are made of the same material. Namely, the semiconductor device of the embodiment is easy to form from standard semiconductor materials.

### (Third embodiment)

Figure 19 is a sectional view showing two structural unit cells that face each other of a semiconductor device according to a third embodiment of the present invention. The semiconductor device according to this embodiment employs, for example, silicon carbide (SiC) as a substrate material. The semiconductor device according to the third embodiment has an n⁺-type SiC substrate 101 made of silicon carbide whose polytype is, for example, 4H. On the substrate 101, a drain region 102 is formed from an n⁻-type SiC epitaxial layer. In contact with a principal surface that is opposite to a junction between the drain region 102 and the substrate 101, there are formed a first hetero-semiconductor region 103 made of, for example, n-type polysilicon and a second hetero-semiconductor region 104 made of, for example, p-type polysilicon. Namely, junctions between the drain region 102 and the first and second hetero-semiconductor regions 103 and 104 are heterojunctions made of SiC and polysilicon having different band gaps. Along the heterojunctions, there are energy barriers. In contact with a junction interface between the first hetero-semiconductor region 103 and the drain region 102, there is formed a gate insulating film 105 made of, for example, a silicon oxide film. On the gate insulating film 105, there is formed a gate electrode 106. Opposite to the junction interfaces between the first and second hetero-semiconductor regions 103 and 104 and the drain region 102, there is formed a source electrode 107. Opposite to the source electrode 107, a drain electrode 108 is formed on the bottom surface of the substrate 101.

According to this embodiment, a trench 113 is formed in the surface of the drain region 102 as shown in Fig. 19. In the trench 113, the gate insulating film 105 and gate electrode 106 are formed, to constitute a trench-type semiconductor device. The drain region 102 may have no trench, to constitute a planar-type semiconductor device.

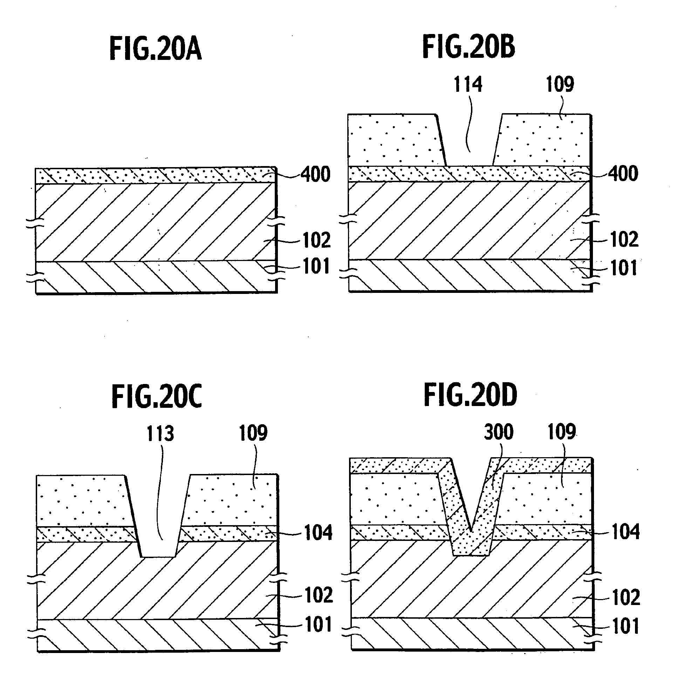

A method of manufacturing the silicon carbide semiconductor device according to the third embodiment shown in Fig. 19 will be explained with reference to Figs. 20A to 21D. In Fig. 20A, an n⁺-type SiC substrate 101 is prepared. On the substrate 101, an n-type drain region 102 is epitaxially grown, to form an n-type silicon carbide semiconductor base. On the semiconductor base, a first polysilicon layer 400 (to form the second hetero-semiconductor region 104) is deposited by, for example, LP-CVD. Boron doping is carried out in an atmosphere of, for example, BBr₃ to form a p-type first polysilicon layer 400. The first polysilicon layer 400 may be formed by deposition according to an electron beam deposition method or a spattering method and by recrystallization according to, for example, a laser annealing method. Alternatively, the first polysilicon layer 400 may be formed from monosilicon epitaxially grown according to, for example, molecular-beam epitaxy. The doping may be carried out with the use of a combination of ion implantation and activation heat treatment The drain region 102 may have an impurity concentration of, for example, 1 x 10¹⁶ cm⁻³ and a thickness of, for example, 10 ,,m. The first polysilicon layer 400 may have a thickness of, for example, 0.5 ,,m.

In Fig. 20B, a silicon nitride film is deposited on the first polysilicon layer 400 according to, for example, LP-CVD. An opening 114 is formed in the silicon nitride film according to photolithography and etching, to form a mask layer 109. In this embodiment, the silicon oxide film is thicker than the first polysilicon layer 400. The thickness of the silicon oxide film is, for example, 2 ,,m. The mask layer 109 is provided with a tapered shape (inverted trapezoidal shape). For this, the silicon oxide film is shaped under specific dry etching conditions. Although the mask layer 109 is made of a silicon oxide film in this embodiment, it may be made of any other material if the material is appropriate for selective etching and is easy to remove.

In Fig. 20C, the first polysilicon layer 400 and a surface part of the drain region 102 are etched according to, for example, reactive ion etching (dry etching), to form a trench 113 having a predetermined depth. The polysilicon layer 400 may be etched by any other etching method such as wet etching. Consequently, the second hetero-semiconductor region 104 is formed.

In Fig. 20D, a second polysilicon layer 300 (to form the first hetero-semiconductor region 103) is deposited according to, for example, LP-CVD. The conductivity type and impurity concentration of the second polysilicon layer 300 are determined according to design specifications. According to this embodiment, the second polysilicon layer 300 is of an n-type and has a thickness of 0.5 "m.

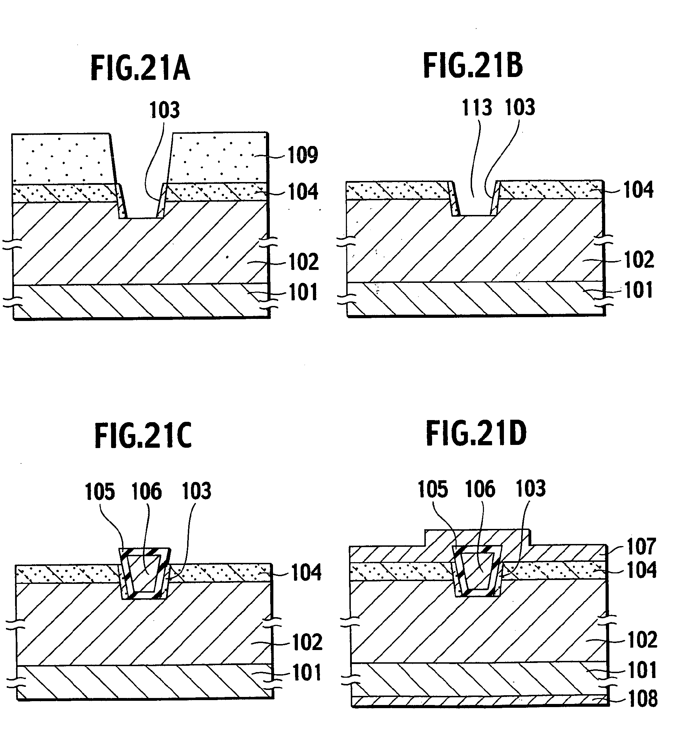

In Fig. 21A, the second polysilicon layer 300 is etched by, for example, reactive ion etching (dry etching) for a predetermined time, to remove the second polysilicon layer 300 except a part thereof that is in contact with the second hetero-semiconductor region 104. This forms the first hetero-semiconductor region 103 having a narrow width. In this way, the first hetero-semiconductor region 103 is formed in a self-aligning and thickness controllable manner to have a narrow width.

In Fig. 21B, the mask layer 109 is removed by, for example, phosphoric acid. In Fig. 21C, a gate insulating film 105 is deposited over the first and second hetero-semiconductor regions 103 and 104 and along the inner wall of the trench 113. On the gate insulating film 105, a polysilicon layer to form a gate electrode 106 is deposited. Solid state diffusion with POCl₃ is achieved to dope the gate-electrode-forming polysilicon layer with phosphorus. To cap the gate electrode 106, a gate insulating film 105 is again deposited. Photolithography and etching are carried out to remove the gate insulating film 105 from the top surfaces of the first and second hetero-semiconductor regions 103 and 104 and open contact holes (not shown).

According to this embodiment, the gate insulating film 105 is left only around the gate electrode 106. The gate insulating film may be also left over one or both of the first and second hetero-semiconductor regions 103 and 104.

In Fig. 21D, a drain electrode 108 is formed on the bottom surface of the substrate 101 from titanium (Ti) and nickel (Ni). On the surfaces of the first and second hetero-semiconductor regions 103 and 104, a source electrode 107 is formed by sequentially depositing titanium (Ti) and aluminum (Al). Thus completed is the silicon carbide semiconductor device according to the third embodiment of the present invention shown in Fig. 19.

In this way, the semiconductor device according to this embodiment is easy to realize with the use of conventional manufacturing techniques. The manufacturing method according to the embodiment is capable of forming the narrow first hetero-semiconductor region 103 in a self-aligning manner through a simple process such as a thermal oxidation process. In addition, the manufacturing method according to this embodiment is capable of freely designing the conductivity type and impurity concentration of the first hetero-semiconductor region 103 that contacts the gate electrode 106 through the gate insulating film 105.

Operation of the semiconductor device according to this embodiment will be explained. For example, the source electrode 107 is grounded, and a positive potential is applied to the drain electrode 108. If a ground potential or a negative potential is applied to the gate electrode 106, a nonconductive state (OFF state, or disconnected state) is maintained. Namely, heterojunction interfaces between the first and second hetero-semiconductor regions 103 and 104 and the drain region 102 form energy barriers against conduction electrons. The first and second hetero-semiconductor regions 103 and 104 are each made of silicon material, and therefore, substantially form the same energy barrier difference ,, EC relative to the drain region 102 made of silicon carbide. However, the n-type first hetero-semiconductor region 103 and p-type second hetero-semiconductor region 104 differ from each other in Fermi energy that is energy from a conduction band to Fermi level. Accordingly, the regions 103 and 104 form depletion layers having different widths, the depletion layers extending from the junction interfaces with the drain region 102. More precisely, the width of the depletion layer extending from the junction interface of the second hetero-semiconductor region 104 is larger than that of the depletion layer extending from the junction interface of the first hetero-semiconductor region 103, to block a leakage current. If the impurity concentration of the second hetero-semiconductor region 104 is set to be higher than that of the first hetero-semiconductor region 103, a depletion layer that is produced by a built-in electric field of a pn diode formed from the second hetero-semiconductor region 104 and first hetero-semiconductor region 103 extends toward the first hetero-semiconductor region 103. This may further reduce a leakage current at the heterojunction between the first hetero-semiconductor region 103 and the drain region 102.

The manufacturing method according to the embodiment is capable of easily controlling the width of the first hetero-semiconductor region 103 to cover a gate electric field extending from the gate electrode 106. It is possible, for example, to form an inverted region over the first hetero-semiconductor region 103 when a negative potential is applied to the gate electrode 106, thereby further improving the turn-off capability of the semiconductor device.

According to this embodiment, the first hetero-semiconductor region 103 is formed in a self-aligning manner. Due to this, the width of the first hetero-semiconductor region 103 is correctly controllable even when integrating a plurality of cells. This eliminates variations in turn-off capability among the cells. In this way, the embodiment improves turn-off capability higher than that of the conventional structure. The embodiment forms the first hetero-semiconductor region 103 from a polysilicon layer that is different from that forming the second hetero-semiconductor region 104. Accordingly, the embodiment can freely set the conductivity type and concentration of impurities, to improve the degree of designing freedom.

Next, a positive potential is applied to the gate electrode 106 to change the nonconductive state to a conductive state. Through the gate insulating film 105, a gate electric field extends up to the heterojunction interface between the first hetero-semiconductor region 103 and the drain region 102. As a result, an accumulation layer of conduction electrons is formed in the first hetero-semiconductor region 103 and drain region 102 around the gate electrode 106. Namely; at the junction interface between the first hetero-semiconductor region 103 and the drain region 102 in the vicinity of the gate electrode 106, the potential of the first hetero-semiconductor region 103 is pushed down, and the energy barrier on the drain region 102 side becomes steep to pass conduction electrons through the energy barrier.

Here, the first hetero-semiconductor region 103 has been formed in a self-aligning manner to correctly control the width thereof and suppress variations in ON-resistance among a plurality of cells that are integrated. Consequently, the embodiment can suppress a current concentration and improve the reliability of the semiconductor device.

Next, a ground potential is again applied to the gate electrode 106 to switch the conductive state to a nonconductive state. The conduction electron accumulated state at the heterojunction interface between the first hetero-semiconductor region 103 and the drain region 102 is released to stop the tunneling of the energy barrier. Namely, the flow of conduction electrons from the first hetero-semiconductor region 103 to the drain region 102 stops. Conduction electrons in the drain region 102 flow to the substrate 101 and deplete. Then, a depletion layer extends from the heterojunction to the drain region 102, to establish the nonconductive state.

Like the conventional structure, this embodiment can realize reverse conduction (return operation) with the source electrode 107 being grounded and the drain electrode 108 receiving a negative potential.

For example, the source electrode 107 and gate electrode 106 are grounded, and a predetermined positive potential is applied to the drain electrode 108. In this state, an energy barrier against conduction electrons disappears, so that conduction electrons flow from the drain region 102 to the first and second hetero-semiconductor regions 103 and 104, to establish the reverse conduction state. At this time, there is no injection of holes. Namely, the conductive state is established only with conduction electrons. As a result, a loss due to a reverse recovery current to shift the reverse conduction state to a nonconductive state is small. It is possible to use the gate electrode 106 as a control electrode instead of grounding the same.

In each of the embodiments mentioned above, the semiconductor device employs silicon carbide as substrate material. The substrate material may be any other material such as silicon, silicon germanium, gallium nitride, and diamond. Each of the embodiments employs silicon carbide having a polytype of 4H. It is possible to employ silicon carbide having any other polytype such as 6H, 3C, and the like. In each of the embodiments, the drain electrode 108 (130) and source electrode 107 (129) are arranged opposite to each other with the drain region 102 (122) interposed between them, to vertically pass a drain current Namely, in each of the embodiments, the semiconductor device is a vertical transistor. Instead, the drain electrode 108 (130) and source electrode 107 (129) may be arranged on the same principal surface to horizontally pass a drain current. Namely, the embodiment is applicable to a horizontal transistor.

In the embodiments, the first hetero-semiconductor region 103 (123) and second hetero-semiconductor region 104 (124) are made of polysilicon. The embodiment is achievable with any material if the material can form a heterojunction with respect to silicon carbide. In the embodiments, the drain region 102 (122) is made of n-type silicon carbide and the first hetero-semiconductor region 103 (123) is made of n-type polysilicon. These regions 102 (122) and 103 (123) may be made of n-type silicon carbide and p-type polysilicon, respectively. Instead, they may be made of p-type silicon carbide and p-type polysilicon, respectively. Alternatively, they may be made of p-type silicon carbide and n-type polysilicon, respectively.

### (Fourth embodiment)

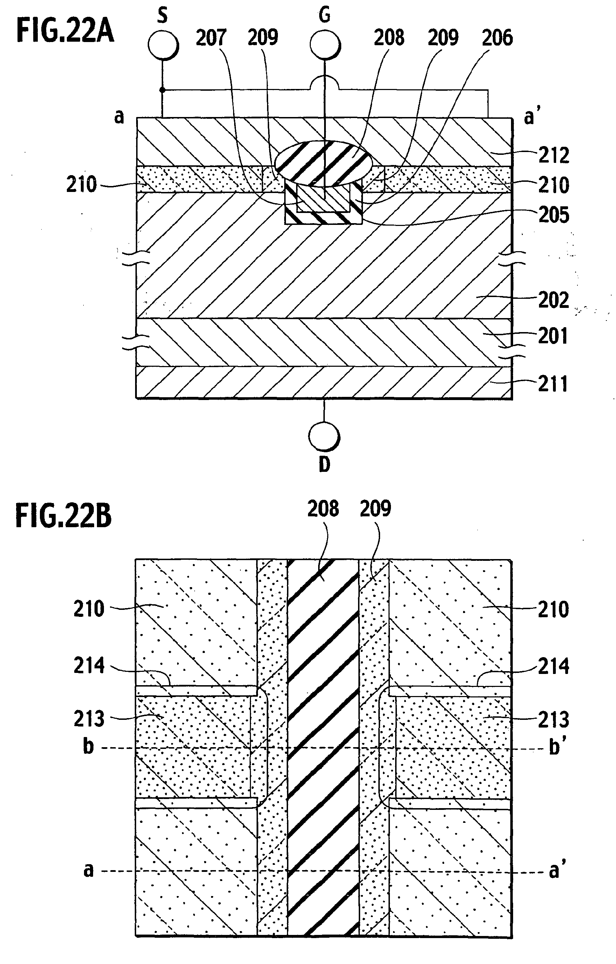

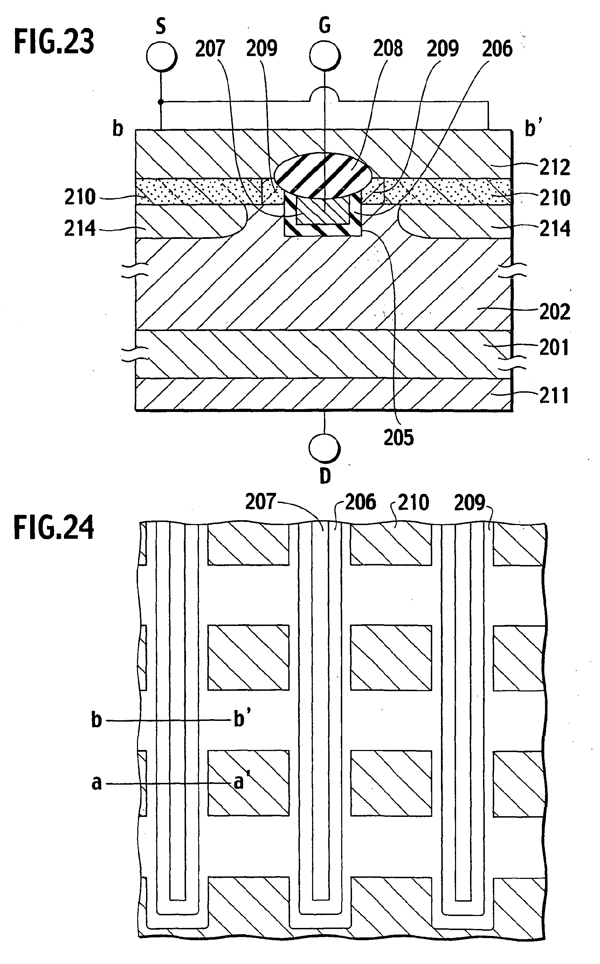

Figure 22A is a sectional view showing a semiconductor device according to a fourth embodiment of the present invention. Figure 22B is a plan view showing a layout of the semiconductor device of Fig. 22A. Figure 23 is a sectional view showing a contact part of the semiconductor device of Fig. 22A. Figure 24 is a plan view showing a wider area of the semiconductor device of the fourth embodiment. Figure 22A is a sectional view taken along a line a-a' of Fig. 22B, and Fig. 23 is a sectional view taken along a line b-b' of Fig. 22B.

The sectional view of Fig. 22A shows two basic unit cells that face each other. In practice, a plurality of such cells are arranged in parallel to form the semiconductor device of the fourth embodiment. The semiconductor device of the fourth embodiment will be explained in connection with.the cells shown in Fig. 22A. An n⁺-type silicon carbide (SiC) substrate 201 is prepared. On the substrate 201, a drain region 202 is formed from an n⁻-type silicon carbide epitaxial layer. On the drain region 202, a polysilicon first hetero-semiconductor region 209 and a polysilicon second hetero-semiconductor region 210 are formed. By anisotropic etching, for example, a trench 205 is formed along the first hetero-semiconductor region 209, to reach the drain region 202. In Fig. 22A, the drain region 202 made of silicon carbide is also etched. The drain region 202 may not be etched. In the trench 205, a gate insulating film 206 is formed, and then, a gate electrode 207 is formed from, for example, polysilicon. On top of the gate electrode 207, a cap insulating layer 208 is formed by thermal oxidation. In ohmic-contact with the substrate 201, a drain electrode 211 is formed from metal. A source electrode 212 is formed in contact with the polysilicon hetero-semiconductor regions 209 and 210. The fourth embodiment is characterized in that the first hetero-semiconductor region 209 is formed in a very narrow area and that the majority of heterojunction is composed of the second hetero-semiconductor region 210. The cap insulating layer 208 electrically insulates the gate electrode 207 from the source electrode 212.

The method of manufacturing a semiconductor device according to any one of the first to third embodiments is employable to manufacture the first hetero-semiconductor region 209 and second hetero-semiconductor region 210.

A layout of the semiconductor device of the fourth embodiment will be explained with reference to Fig. 22B. The source electrode 212 covers the whole surface of the semiconductor device, and therefore, the layout shown in Fig. 22B is not visible from the top side of the semiconductor device. For the sake of clear understanding, Fig. 22B shows an image with the source electrode 212 being made transparent. On each side of the cap insulating layer 208, there is the narrow first hetero-semiconductor region 209. On an outer side of the region 209, there is the wide second hetero-semiconductor region 210. The narrow first hetero-semiconductor region 209 is also continuous to a wide first hetero-semiconductor region, i.e., a contact region 213. Figure 24 shows a wider layout including a reduced view of Fig. 22B. The gate electrode 207 is not shown in Fig. 22B and is shown in Fig. 24.

Figure 23 shows a part different from the part shown in Fig. 22A. On the drain region 202, the wide contact region 213 made of polysilicon is continuous to the narrow first hetero-semiconductor region 209. At a part where the wide contact region 213 is in contact with the drain region 202, there is a p-type field relaxation region 214. The other parts are the same as those of Fig. 22A.

The field relaxation region 214 that is a p-type well region may be formed by implanting p-type impurity ions into a predetermined area of the surface of the drain region 202 and by activating the implanted ions. Thereafter, the contact region 213 of the first conductivity type may be formed in the field relaxation region 214.

Operation of the semiconductor device according to this embodiment of the present invention will be explained. For example, the source electrode 212 is grounded, and a positive potential is applied to the drain electrode 211. If a ground potential or a negative potential is applied to the gate electrode 207, a nonconductive state is maintained. Namely, heterojunction interfaces between the first hetero-semiconductor region 209 and second hetero-semiconductor region 210 and the drain region 202 form energy barriers against conduction electrons. The first hetero-semiconductor region 209 and second hetero-semiconductor region 210 are each made of silicon material, and therefore, substantially form the same energy barrier difference "EC relative to the drain region 202 made of silicon carbide. However, the n-type first hetero-semiconductor region 209 and p-type second hetero-semiconductor region 210 differ from each other in Fermi energy that is energy from a conduction band to Fermi level. Accordingly, the regions 209 and 210 form built-in depletion layers having different widths, the built-in depletion layers extending from the junction interface with the drain region 202. More precisely, the width of a built-in depletion layer extending from the junction interface of the second hetero-semiconductor region 210 is larger than that of a built-in depletion layer extending from the junction interface of the first hetero-semiconductor region 209, to block a leakage current. If the impurity concentration of the second hetero-semiconductor region 210 is set to be higher than that of the first hetero-semiconductor region 209, a depletion layer that is produced by a built-in electric field of a pn diode formed from the second hetero-semiconductor region 210 and first hetero-semiconductor region 209 extends toward the first hetero-semiconductor region 209. This may further reduce a leakage current at the heterojunction between the first hetero-semiconductor region 209 and the drain region 202.

The manufacturing method according to the embodiment is capable of easily controlling the width of the first hetero-semiconductor region 209 to cover a gate electric field extending from the gate electrode 207. It is possible, for example, to form an inverted region over the first hetero-semiconductor region 209 when a negative potential is applied to the gate electrode 207, thereby further improving the turn-off capability of the semiconductor device.

According to this embodiment, the first hetero-semiconductor region 209 is formed in a self-aligning manner by introducing impurities into a part that is in contact with the gate electrode 207 through the gate insulating film 206. Due to this, the width of the first hetero-semiconductor region 209 is correctly controllable even when integrating a plurality of cells. This eliminates variations in turn-off capability among the cells. In this way, the embodiment improves turn-off capability higher than that of the conventional structure.

Next, a positive potential is applied to the gate electrode 207 to change the nonconductive state to a conductive state. Through the gate insulating film 206, a gate electric field extends up to the heterojunction interface between the first hetero-semiconductor region 209 and the drain region 202. As a result, an accumulation layer of conduction electrons is formed in the first hetero-semiconductor region 209 and drain region 202 around the gate electrode 207. Namely, at the junction interface between the first hetero-semiconductor region 209 and the drain region 202 in the vicinity of the gate electrode 207, the potential of the first hetero-semiconductor region 209 is pushed down, and the energy barrier on the drain region 202 side becomes steep to pass conduction electrons through the energy barrier.

Here, the first hetero-semiconductor region 209 has been formed in a self-aligning manner by introducing impurities into a part that is in contact with the gate electrode 207 through the gate insulating film 206, to correctly control the width of the first hetero-semiconductor region 209 and suppress variations in ON-resistance among a plurality of cells that are integrated. Consequently, the embodiment can suppress a current concentration and improve the reliability of the semiconductor device.

Next, a ground potential is again applied to the gate electrode 207 to switch the conductive state to a nonconductive state. The conduction electron accumulated state at the heterojunction interface between the first hetero-semiconductor region 209 and the drain region 202 is released to stop the tunneling of the energy barrier. Namely, the flow of conduction electrons from the first hetero-semiconductor region 209 to the drain region 202 stops. Conduction electrons in the drain region 202 flow to the substrate 201 and deplete. Then, a depletion layer extends from the heterojunction to the drain region 202, to establish the nonconductive state.

Like the conventional structure, this embodiment can realize reverse conduction (return operation) with the source electrode 212 being grounded and the drain electrode 211 receiving a negative potential. For example, the source electrode 212 and gate electrode 207 are grounded, and a predetermined negative potential is applied to the drain electrode 211. In this state, an energy barrier against conduction electrons disappears, so that conduction electrons flow from the drain region 202 to the first hetero-semiconductor region 209 and second hetero-semiconductor region 210, to establish the reverse conduction state. At this time, there is no injection of holes. Namely, the conductive state is established only with conduction electrons. As a result, a loss due to a reverse recovery current to shift the reverse conduction state to a nonconductive state is small. It is possible to use the gate electrode 207 as a control electrode instead of grounding the same.

As is apparent from the sectional view of the semiconductor device according to this embodiment, the second hetero-semiconductor region 210 forms a majority of the heterojunction. The turn-off capability of this embodiment in an OFF state is excellent The first hetero-semiconductor region 209 formed at the interface of the gate insulating film 206 forms a channel during an ON period. The first hetero-semiconductor region 209 for forming the channel has another region having another sectional structure as shown in Fig. 23 taken along the ling b-b' of Fig. 22B. In this region, the wide contact region 213 continuous to the first hetero-semiconductor region 209 is connected to the source electrode 212 through a wide area having low electrical resistance. This reduces contact resistance with respect to the source electrode 212, as well as reducing ON-resistance. In the cross-sectional view of the contact part, the field relaxation layer 214 is formed lower than the first hetero-semiconductor region 209. This helps maintain the turn-off capability of the semiconductor device during an OFF state.

As explained above, the semiconductor device according to this embodiment has the semiconductor base (consisting of the n⁺-type silicon carbide substrate 201 and the drain region 202 made of an n⁻-type silicon carbide epitaxial layer) of a first conductivity type, the first and second hetero-semiconductor regions 209 and 210 that are in contact with a principal surface of the semiconductor base and have different band gaps from that of the semiconductor base, the gate electrode 207 formed on the gate insulating film 206 at a junction between the first hetero-semiconductor region 209 and the semiconductor base, the source electrode 212 connected to the first hetero-semiconductor region 209, and the drain electrode 211 formed in ohmic-contact with the semiconductor base. The semiconductor device consists of a plurality of basic unit cells connected in parallel. At least on the side where the first hetero-semiconductor region 209 is in contact with the source electrode 212, the first hetero-semiconductor region 209 has the contact region 213 having an expanded area connected to the source electrode 212. Without regard to an area occupied by the first and second hetero-semiconductor regions 209 and 210 in a basic unit cell, low-resistance contact is realized between the first hetero-semiconductor region 209 and the source electrode 212.

The first hetero-semiconductor region 209 and contact region 213 are made of the same continuous material. Namely, this embodiment forms the first hetero-semiconductor region 209 and contact region 213 from the same layer made of polysilicon. This arrangement prevents an increase in resistance in a current path from the first hetero-semiconductor region 209 to the source electrode 212.

The field relaxation region 214 is formed at the surface of the semiconductor base at least just under the contact region 213. With this arrangement, the semiconductor device has low ON-resistance and excellent turn-off capability.

Opposite to the first and second heterojunctions where the first and second hetero-semiconductor regions 209 and 210 are in contact with the semiconductor base, the first hetero-semiconductor region 209 and second hetero-semiconductor region 210 are in contact with the source electrode 212. With this arrangement, low-resistance contact is realized between the first hetero-semiconductor region 209 and the source electrode 212 without regard to an area occupied by the first and second hetero-semiconductor regions 209 and 210 in a basic unit cell.

The semiconductor base is made of silicon carbide. At least one of the first and second hetero-semiconductor regions 209 and 210 is made of at least one of polysilicon, amorphous silicon, and monosilicon. The first hetero-semiconductor region 209 and second hetero-semiconductor region 210 are selectively doped with impurities to have first and second conductivity types, respectively. Without using special manufacturing processes and by using standard semiconductor materials, this embodiment can easily provide a semiconductor device having low ON-resistance, excellent turn-off capability, and high withstand voltage.

As shown in Fig. 24, the first hetero-semiconductor region 209 including the contact region 213 has a lattice layout in a plan view. This layout is easy to realize and provides the semiconductor device with low ON-resistance and excellent turn-off capability.

The first hetero-semiconductor region 209 and contact region 213 may be different parts or different layers. In this case, the first hetero-semiconductor region 209 and contact region 213 must be connected to each other through low electrical resistance, to prevent an increase in resistance in a current path from the first hetero-semiconductor region 209 to the source electrode 212.

### (Fifth embodiment)

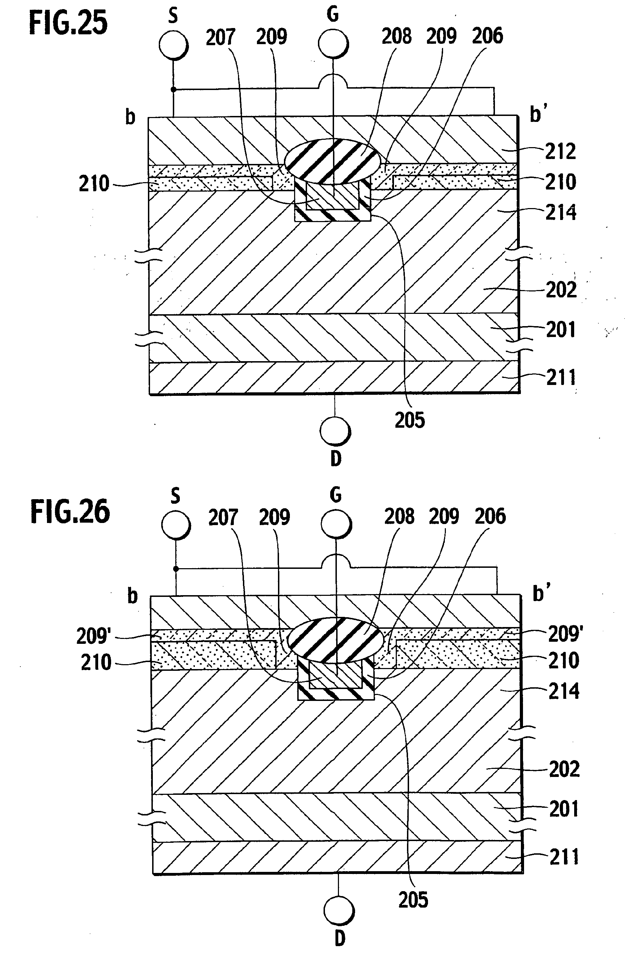

Figure 25 is a sectional view showing a contact part of a semiconductor device according to a fifth embodiment of the present invention. The cross-sectional structure and planar layout of the fifth embodiment are basically the same as those of the fourth embodiment Namely, the cross-sectional structure taken along a line a-a' of the fifth embodiment is like that shown in Fig. 22A, and the planar layout thereof is like that shown in Figs. 22B and 24.

Parts of the fifth embodiment that differ from those of the fourth embodiment will be explained. A polysilicon hetero-semiconductor region formed on a drain region 202 has a second conductivity type at a part that is in contact with the drain region 202, to form a second hetero-semiconductor region 210. A surface part thereof has a first conductivity type to form a first hetero-semiconductor region 209. In this way, the fifth embodiment forms the layered regions having different conductivity types from the same polysilicon. This configuration secures turn-off capability at a hetero-interface between the second hetero-semiconductor region 210 and the drain region 202. At the same time, the surface first hetero-semiconductor region 209 is widely and directly in contact with a source electrode 212.

This structure is manufacturable by implanting impurities of the second conductivity type, such as As (arsenic) ions into a thin surface area of the hetero-semiconductor region as shown in a b-b' section of Fig. 25. Operation of the semiconductor device of the fifth embodiment is basically the same as that of the fourth embodiment. The fifth embodiment can provide excellent turn-off capability and low ON-resistance without forming a field relaxation region in the drain region 202.

According to this embodiment, on the opposite side of a first heterojunction between the first hetero-semiconductor region 209 and the semiconductor base, the first hetero-semiconductor region 209 occupies a larger area than the first heterojunction. Namely, on the side opposite to the first heterojunction between the first hetero-semiconductor region 209 and the semiconductor base, an area occupied by the first hetero-semiconductor region 209 is larger than an area occupied by the first heterojunction. This arrangement realizes low-resistance contact between the first hetero-semiconductor region 209 and the source electrode 212 without regard to areas occupied by the first and second hetero-semiconductor regions 209 and 210. Under a contact region 213 of the first hetero-semiconductor 209, the second hetero-semiconductor region 210 is present. This arrangement improves the turn-off capability of the semiconductor device and decreases ON-resistance thereof.

### (Sixth embodiment)

Figure 26 is a sectional view showing a contact part of a semiconductor device according to a sixth embodiment of the present invention. The cross-sectional structure and planar layout of the sixth embodiment are basically the same as those of the fourth embodiment. Namely, the cross-sectional structure taken along a line a-a' of the sixth embodiment is like that shown in Fig. 22A, and the planar layout thereof is like that shown in Figs. 22B and 24.

Parts of the sixth embodiment that differ from those of the fourth embodiment will be explained. A polysilicon hetero-semiconductor region formed on a drain region 202 has a second conductivity type at a part that is in contact with the drain region 202, to form a second hetero-semiconductor region 210. On the second hetero-semiconductor region 210, a first hetero-semiconductor region 209' of a first conductivity type is formed as a separate layer. In the first polysilicon layer, a part adjacent to a gate insulating film 206 forms a thin first hetero-semiconductor region 209 of the first conductivity type. The first hetero-semiconductor region 209 is connected to the second-layer first hetero-semiconductor region 209' through low electric resistance. In this way, the sixth embodiment forms the two layers of polysilicon having different conductivity types. This configuration secures turn-off capability at a hetero-interface between the second hetero-semiconductor region 210 and the drain region 202. At the same time, the surface first hetero-semiconductor region 209' is widely and directly in contact with a source electrode 212. Operation of the semiconductor device of the sixth embodiment is basically the same as that of the fourth embodiment. The sixth embodiment can provide excellent turn-off capability and low ON-resistance without forming a field relaxation region in the drain region 202.

According to this embodiment, on the opposite side of a first heterojunction between the first hetero-semiconductor region 209 and the semiconductor base, the first hetero-semiconductor region 209' occupies a larger area than the first heterojunction. This arrangement realizes low-resistance contact between the first hetero-semiconductor region 209 and the source electrode 212 without regard to areas occupied by the first and second hetero-semiconductor regions 209 and 210.

Under a contact region 213 of the first hetero-semiconductor 209', the second hetero-semiconductor region 210 is present. This arrangement improves the turn-off capability of the semiconductor device and decreases ON-resistance thereof.

Under the contact region 213 of the first hetero-semiconductor 209', the second hetero-semiconductor region 210 is present, and the first hetero-semiconductor region 209' and second hetero-semiconductor region 210 are formed in different layers. This arrangement can provide excellent turn-off capability and low ON-resistance without forming a field relaxation region in the drain region 202.

### (Seventh embodiment)

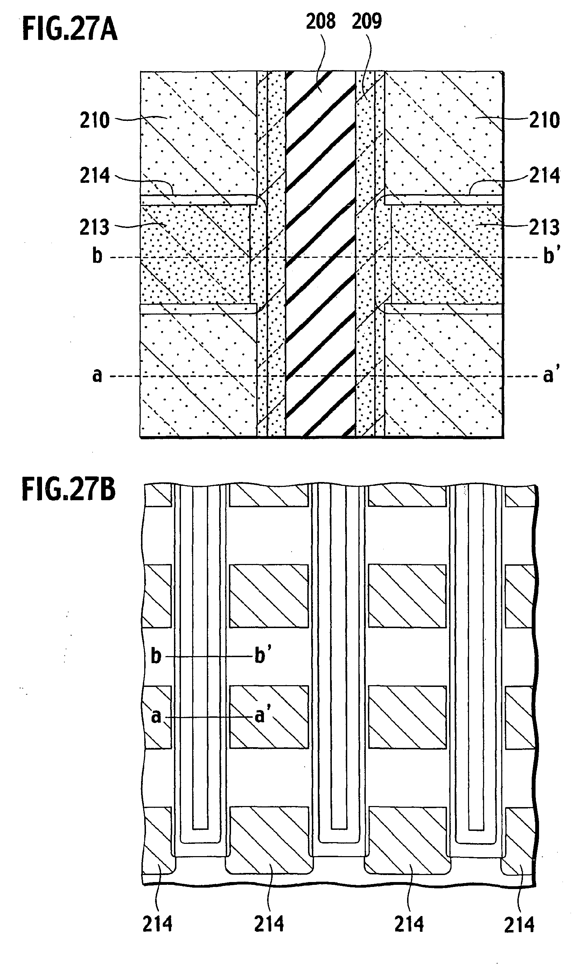

Figure 27A is a plan view showing a layout of a semiconductor device according to a seventh embodiment of the present invention. Figure 27B is a plan view showing a wider area of the semiconductor device of the seventh embodiment

Parts of the seventh embodiment that differ from those of the fourth embodiment will be explained. The fourth embodiment of Fig. 22B forms the field relaxation region 214 only at a part where the wide contact region 213 is in contact with the drain region 202. The seventh embodiment forms a field relaxation region 214 allover the surface of a semiconductor base except a part just under a gate region (gate electrode 207 and gate insulating film 206).

In each of the above-mentioned embodiments, the source electrode 212 is entirely in contact with the first and second polysilicon hetero-semiconductor regions 209 and 210 except a part where a cap insulating layer 208 is formed. It is possible to form an interlayer insulating layer between the first and second hetero-semiconductor regions 209 and 210 and the source electrode 212. In this case, a contact hole is formed through the interlayer insulating layer at a location separated from the gate electrode by a predetermined distance. Through the contact hole, the first and second hetero-semiconductor regions 209 and 210 are connected to the source electrode 212. This type of structure will be explained below.

### (Eighth embodiment)

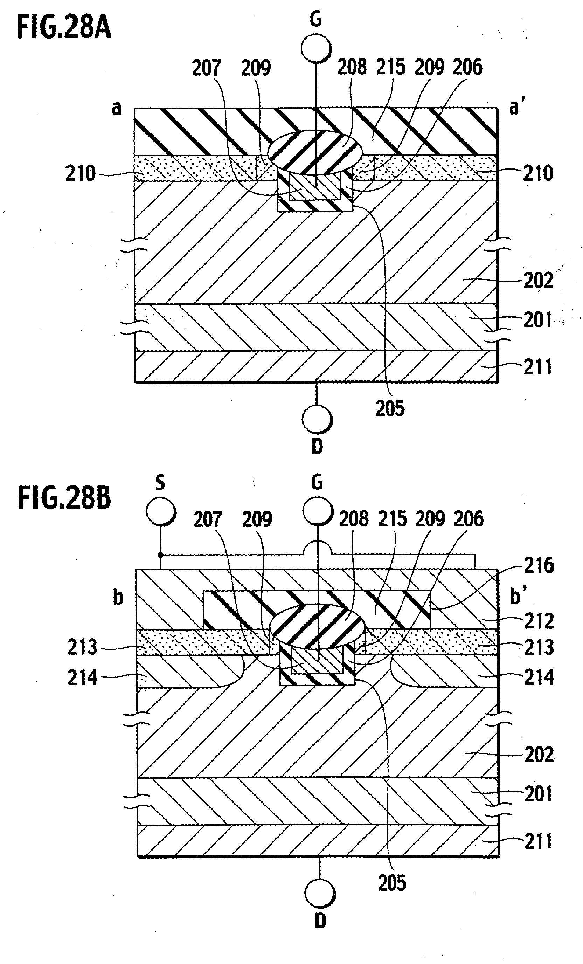

Figure 28A is a sectional view showing a semiconductor device according to an eighth embodiment of the present invention. Figure 28B is a sectional view showing a contact structure of the eighth embodiment. Figure 28A corresponds to a sectional view taken along a line a-a' of Fig. 22B, and Fig. 28B corresponds to a sectional view taken along a line b-b' of Fig. 22B.

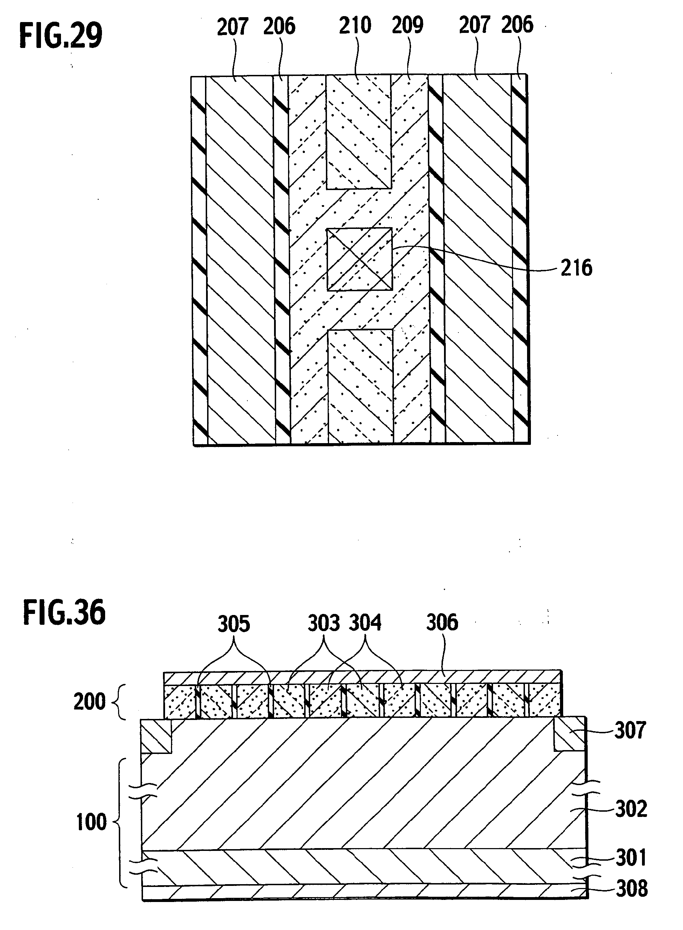

Figure 29 is a planar layout showing the eighth embodiment. This view shows a different part from the part shown in Fig. 22B. A reference numeral 215 represents an interlayer insulating film and 216 a contact hole.

Parts specific to the eighth embodiment will be explained. In the a-a' sectional area, first and second semiconductor regions 209 and 210 are not in contact with a source electrode. 212 and are in contact therewith through the contact hole 216 that is formed on the depth side of Fig. 28A as shown in Fig. 28B.

### (Ninth embodiment)

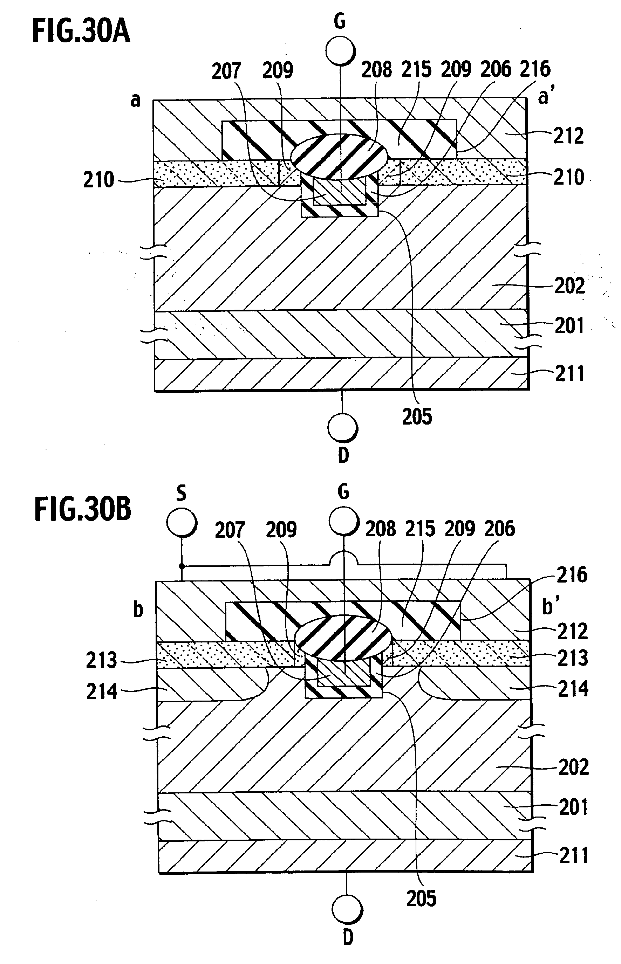

Figure 30A is a sectional view showing a semiconductor device according to a ninth embodiment of the present invention. Figure 30B is a sectional view showing a contact structure of the ninth embodiment. Figure 30A corresponds to a sectional view taken along a line a-a' of Fig. 22B, and Fig. 30B corresponds to a sectional view taken along a line b-b' of Fig. 22B.

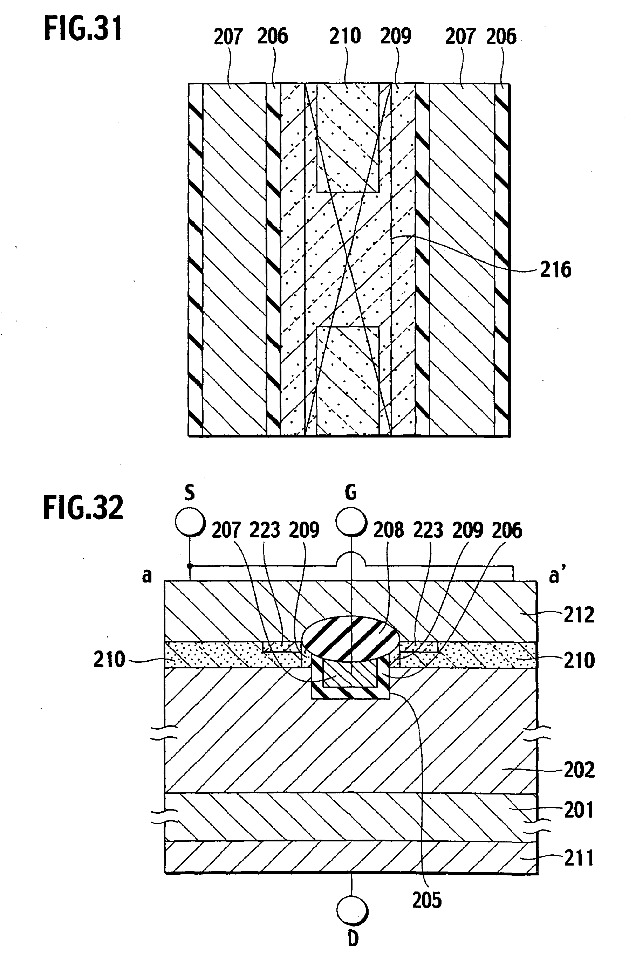

Figure 31 is a planar layout showing the eighth embodiment. This view shows a different part from the part shown in Fig. 22B.

Parts specific to the ninth embodiment will be explained. Unlike the fourth embodiment that entirely connects the first and second hetero-semiconductor regions 209 and 210 to the source electrode 212, the ninth embodiment forms a contact hole 216 as shown in Fig. 31, to connect first and second hetero-semiconductor regions 209 and 210 to a source electrode 212.

### (Tenth embodiment)

Figure 32 is a sectional view showing two unit cells that face each other of a semiconductor device according to a tenth embodiment of the present invention. In practice, a plurality of such cells are arranged in parallel to form the semiconductor device of the tenth embodiment. The semiconductor device of the tenth embodiment will be explained in connection with the cells shown in Fig. 32. The semiconductor device of this embodiment employs silicon carbide (SiC) as substrate material. An n⁺-type SiC substrate 201 having a polytype of, for example, 4H is prepared On the substrate 201, a drain region 202 is formed from an n⁻-type SiC epitaxial layer. On a principal surface of the drain region 202 opposite to a junction with respect to the substrate 201, a first hetero-semiconductor region 209 made of, for example, n-type polysilicon and a second hetero-semiconductor region 210 made of, for example, p-type polysilicon are formed

Junctions between the drain region 202 and the first and second hetero-semiconductor regions 209 and 210 are heterojunctions made of SiC and polysilicon having different band gaps. Along the heterojunctions, there are energy barriers. In contact with a junction interface between the first hetero-semiconductor region 209 and the drain region 202, there is formed a gate insulating film 206 made of, for example, a silicon oxide film. On the gate insulating film 206, there is formed a gate electrode 207. Opposite to the junction interfaces between the first and second hetero-semiconductor regions 209 and 210 and the drain region 202, there is formed a source electrode 212, and opposite to the source electrode 212, a drain electrode 211 is formed on the bottom surface of the SiC substrate 201. A reference numeral 208 represents a cap insulating layer. In this way, the semiconductor device according to this embodiment has a semiconductor base (consisting of the n⁺-type silicon carbide substrate 201 and the drain region 202 made of an n⁻-type silicon carbide epitaxial layer) of a first conductivity type, the first and second hetero-semiconductor regions 209 and 210 that are in contact with a principal surface of the semiconductor base and have different band gaps from that of the semiconductor base, the gate electrode 207 formed on the gate insulating film 206 at a junction between the first hetero-semiconductor region 209 and the semiconductor base, the source electrode 212 connected to the first hetero-semiconductor region 209, and the drain electrode 211 formed in ohmic-contact with the semiconductor base. At a predetermined location on the surface of the second hetero-semiconductor region 210, there is formed an n⁺-type source contact region 223 of the first conductivity type electrically connected to the first hetero-semiconductor region 209. This embodiment is characterized in that the n⁺-type source contact region 223 is wide to electrically connect the source electrode 212 and first hetero-semiconductor region 209 to each other at low electric resistance, to thereby reduce contact resistance with respect to the source electrode 212.

As shown in Fig. 32, this embodiment forms a trench 205 in the surface of the drain region 202, the gate insulating film 206 in the trench 205, and the gate electrode 207 on the gate insulating film 206, to provide a trench-type semiconductor device. The drain region 202 may have no trench, to provide a planar-type semiconductor device. A planar layout of this embodiment is different from that shown in Fig. 24. Namely, this embodiment has no contact region 213. The n⁺-type source contact region 223 of the same area and arrangement is provided for every basic unit cell in the semiconductor device of this embodiment. This embodiment may have the contact region 213 like the fourth embodiment.

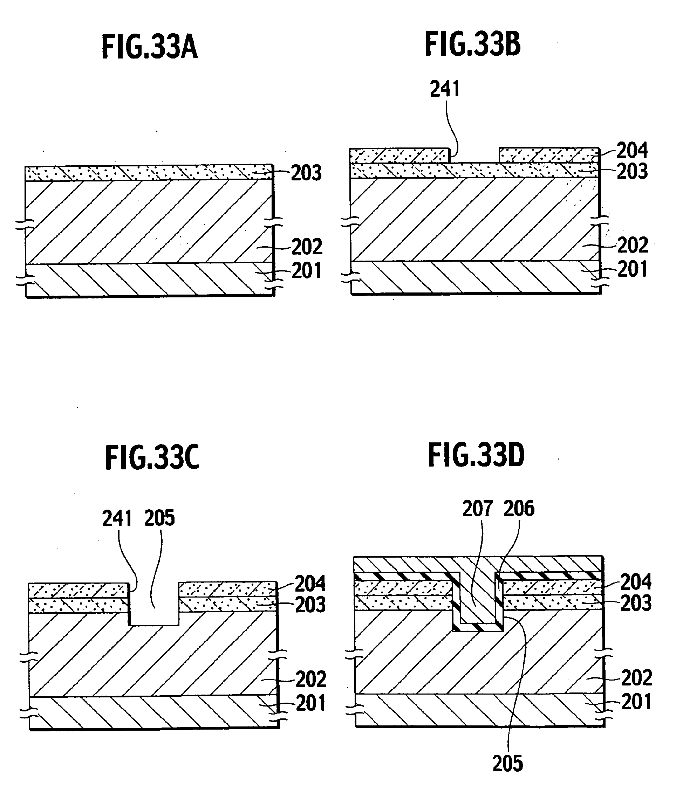

A method of manufacturing the semiconductor device shown in Fig. 32 will be explained with reference to sectional views of Figs. 33A to 35D.

In Fig. 33A, there is prepared an n⁺-type SiC substrate 201 on which an n-type SiC epitaxial layer serving as a drain region 202 is formed. On the drain region 202, a polysilicon hetero-semiconductor region 203 is formed. In Fig. 33B, a mask layer 204 made of, for example, a silicon nitride film is formed on the hetero-semiconductor region 203. A predetermined location is patterned to form an opening 241. In this embodiment, the mask layer 204 is a silicon nitride film. The mask layer 204 may have a multilayer structure including a deposited oxide film and a resist depending on etching conditions to be explained later. An important matter is to include at least a silicon nitride film In Fig. 33C, the patterned opening 241 is used to form a trench 205 in the hetero-semiconductor region 203 by, for example, anisotropic etching. In Fig. 33C, the SiC drain region 202 is also etched. It is possible not to etch the SiC drain region 202. In Fig. 33D, a gate insulating film 206 is formed in the trench 205, and a gate electrode 207 is formed from, for example, polysilicon.

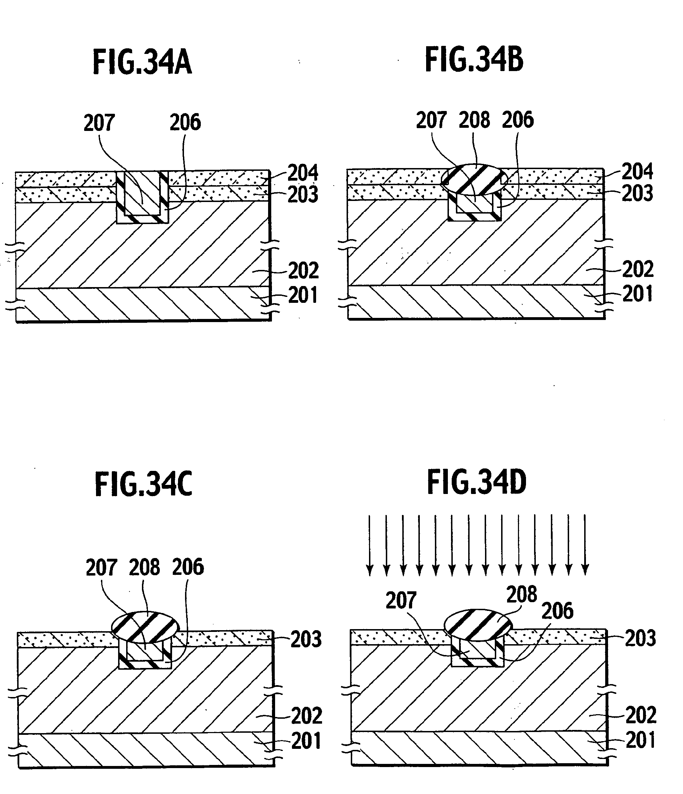

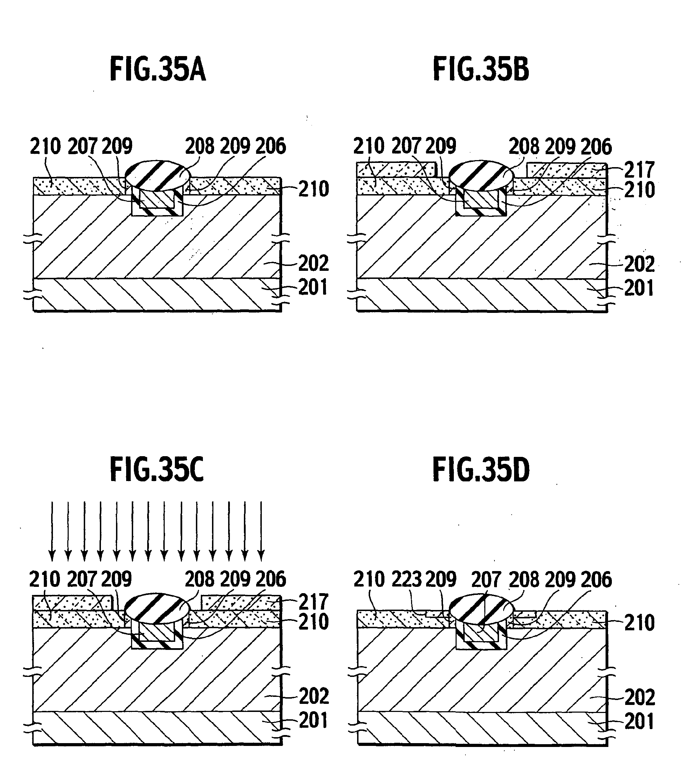

In Fig. 34A, the polysilicon gate electrode 207 is totally etched back by, for example, anisotropic etching, to leave the gate electrode 207 only in the trench 205. The flattening process of the gate electrode 207 may be carried out by, for example, CMP (chemical mechanical polishing). During this process, the silicon nitride mask layer 204 must remain. In Fig. 34B, the patterned mask layer 204 is used to form a cap insulating layer 208 on the gate electrode 207 by thermal oxidation. At this time, a lateral dimension of the cap insulating layer 208 must be slightly greater than the width of the trench 205. The cap insulating layer 208 has a bird's beak shape, to slightly get in an end of the silicon nitride mask layer 204. In Fig. 34C, the mask layer 204 is removed by etching. In Fig. 34D, the cap insulating layer 208 is used as a mask to implant impurity ions to make the polysilicon hetero-semiconductor region 203 into a p-type. The impurities may be boron ions. Before this process, the hetero-semiconductor region 203 is implanted with impurities to make it an n-type. Into this n-type polysilicon layer, the p-type impurities are implanted over the cap insulating layer 208, to form a very narrow n-type first hetero-semiconductor region 209 and a second hetero-semiconductor region 210 as shown in Fig. 35A. In Fig. 35B, a mask layer 217 is formed and patterned to form an opening that is wider than the cap insulating film 208. The mask layer 217 may be a resist.

In Fig. 35C, n-type impurities such as As (arsenic) ions are implanted over the mask layer 217. In Fig. 35D, the mask layer 217 is removed. The implanted n-type impurities form an n⁺-type source contact region 223 at a specified location at the surface of the second hetero-semiconductor region 210. The source contact region 223 is in electrical connection to the first hetero-semiconductor region 209.

As shown in Fig. 32, a metal drain electrode 211 is formed in ohmic-contact with the SiC substrate 201. A source electrode 212 is formed in contact with the polysilicon hetero-semiconductor regions 209 and 210, to complete the semiconductor device of the tenth embodiment shown in Fig. 32.

### (Eleventh embodiment)

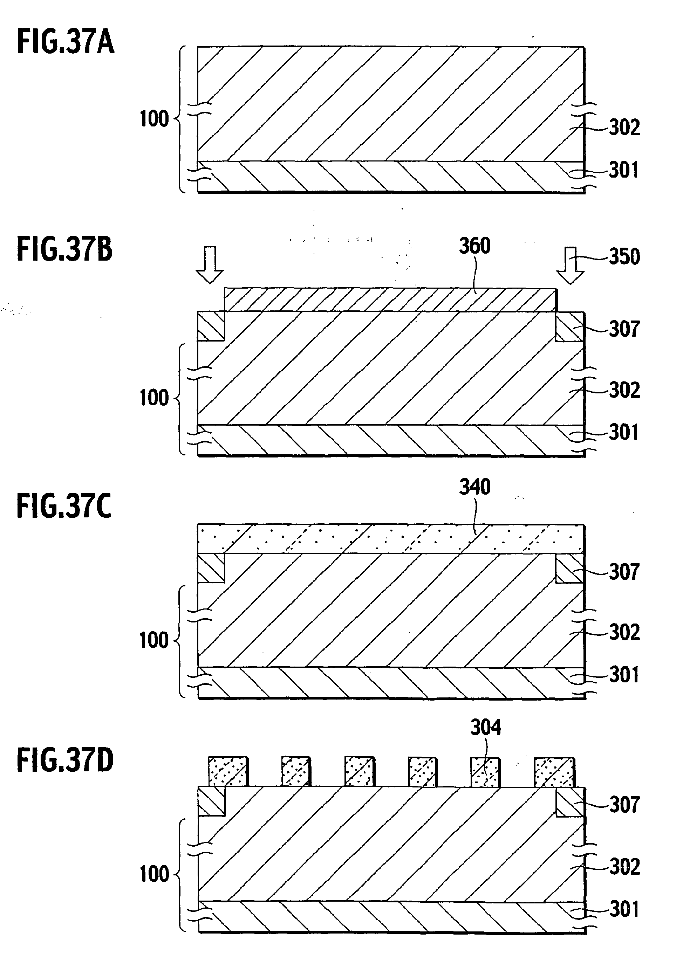

Figure 36 is a sectional view showing a heterojunction diode according to an eleventh embodiment of the present invention. This semiconductor device employs silicon carbide (SiC) as a material for a semiconductor substrate.

In Fig. 36, an SiC substrate 301 of first conductivity type, i.e., n-type, for example, is prepared. On the substrate 301, an n-type SiC drain region (epitaxial layer) 302 is formed. The substrate 301 and drain region 302 constitute an SiC semiconductor base 100. On a principal surface of the drain region 302 opposite to a junction with respect to the substrate 301, there is formed a hetero-semiconductor region 200. The hetero-semiconductor region 200 consists of a first hetero-semiconductor region 303 made of, for example, n-type polysilicon and a second hetero-semiconductor region 304 made of p-type, i.e., second conductivity type polysilicon. The first and second hetero-semiconductor regions 303 and 304 are alternately arranged side by side. On the hetero-semiconductor region 200, an anode electrode 306 is formed in contact therewith. On the substrate 301, there is formed a cathode electrode 308 in contact therewith. In the vicinity of a heterojunction between the drain region 302 and the second hetero-semiconductor region 304, a field relaxation region 307 is formed in the surface of the drain region 302. Between the adjacent first and second hetero-semiconductor regions 303 and 304, there is formed an impurity diffusion preventive film 305.

In this way, the semiconductor device according to this embodiment has the semiconductor base 100 and the hetero semiconductor region 200. The hetero-semiconductor region 200 is made of hetero-semiconductor materials whose band gaps are different from that of a semiconductor material that forms the semiconductor base 100. The hetero-semiconductor region 200 forms a heterojunction with respect to the semiconductor base 100 and is composed of at least two hetero-semiconductor regions 303 and 304 having different impurity concentrations or conductivity types (in this embodiment, they have different conductivity types). The adjacent hetero-semiconductor regions 303 and 304 are arranged side by side with the impurity diffusion preventive film 305 interposed between them.

At least two hetero-semiconductor regions 303 and 304 are electrically connected to each other so that they may have the same potential. Namely, the semiconductor device of this embodiment includes heterojunction diodes each consisting of the hetero-semiconductor regions 303 and 304. The heterojunction diodes are connected in parallel to pass a large current.

According to this embodiment, the hetero-semiconductor region 200 consists of the hetero-semiconductor regions 303 and 304 that form heterojunctions with respect to the semiconductor base 100 and have different conductivity types (or impurity concentrations). The adjacent hetero-semiconductor regions 303 and 304 are arranged side by side with the impurity diffusion preventive film 305 interposed between them. Each of the hetero-semiconductor regions 303 and 304 is connected to the anode electrode 306, to have the same potential as the anode electrode 306.

According to this embodiment, the impurity diffusion preventive film 305 prevents the diffusion of impurities between the adjacent hetero-semiconductor regions 303 and 304. This realizes the formation of fine hetero-semiconductor layers having different impurity concentrations or conductivity types, which the related arts hardly form. At least one of the hetero-semiconductor regions 303 and 304 (in this embodiment, the second hetero-semiconductor region 304) has a conductivity type that is opposite to the conductivity type of the semiconductor base 100. Making the conductivity type of a part (the second hetero-semiconductor region 304 in this embodiment) of the hetero-semiconductor region 200 opposite to that of the semiconductor base 100 results in reducing a leakage current and increasing a withstand voltage. Combining the n-type polysilicon layer and p-type polysilicon layer results in realizing a high reverse withstand voltage and a low ON-voltage. The impurity diffusion preventive film 305 is made of a silicon oxide film or a silicon nitride film.

The semiconductor device of this embodiment is easy to realize with standard semiconductor materials. According to the embodiment, the semiconductor base 100 employs SiC as a semiconductor material. Namely, the semiconductor device of the embodiment having a high withstand voltage can be realized with standard semiconductor materials.

The hetero-semiconductor regions 303 and 304 are made of at least one of polysilicon, monosilicon, and amorphous silicon. Namely, the semiconductor device of the embodiment is easy to realize with standard semiconductor materials.

According to the embodiment, a combination of the hetero-semiconductor regions 303 and 304 forming the hetero-semiconductor region 200 is a combination of an n-type polysilicon layer and a p-type polysilicon layer. The combination may be made of hetero-semiconductor layers having different impurity concentrations and the same conductivity type. Instead of a combination of two kinds of hetero-semiconductor layers, i.e., the hetero-semiconductor regions 303 and 304, the embodiment may employ a combination of more kinds of hetero-semiconductor layers. The field relaxation layer 307 may be omitted. However, the field relaxation region 307 is preferred to realize a high withstand voltage.

### (Method of manufacturing the semiconductor device)

Figures 37A to 39C are sectional views showing a method of manufacturing the heterojunction diode of Fig. 36. In Fig. 37A, an SiC semiconductor base 100 is prepared by forming a drain region 302 on an n-type SiC substrate 301. The thickness of the SiC drain region 302 is, for example, 10 ,,m, and the impurity concentration thereof is, for example, 1.0 x 10¹⁶ cm⁻³. In Fig. 37B, a mask layer 360 made of, for example, a CVD oxide film is used to implant aluminum ions 350 into a predetermined area to form a p-type field relaxation region 307. The ion implantation may be multistage implantation carried out at, for example, an acceleration voltage of 30 to 360 KeV, a total dose quantity of 5.0 x 10¹⁶ cm⁻³, and a substrate temperature of 800°C. After the ion implantation, the CVD oxide film is removed with, for example, a BHF solution. Activation annealing is carried out to activate the implanted aluminum. For example, the activation annealing is carried out in an argon atmosphere at 1700°C for 10 minutes.

In Fig. 37C, polysilicon is deposited on the drain region 302 to a thickness of, for example, 5000 A (angstroms). Solid state diffusion with BBr₃ is carried out to form a p-type polysilicon layer 340. The doping on polysilicon may be carried out with a combination of ion implantation and activation annealing. The p-type dopant may be boron (B), aluminum (Al), or the like.

In Fig. 37D, photolithography and etching are carried out to etch a predetermined area of the p-type polysilicon layer 340 to form a second hetero-semiconductor region 304.

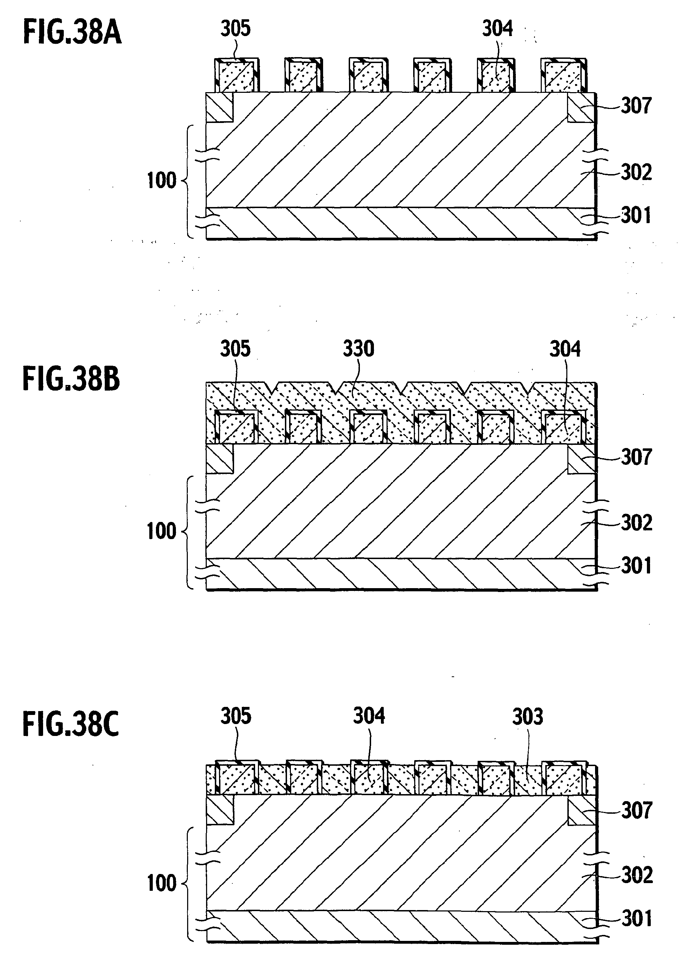

In Fig. 38A, thermal oxidation is carried out in an oxidizing atmosphere of 1.0 in partial vapor pressure, to form an oxide film serving as an impurity diffusion preventive film 305 on the surface of the second hetero-semiconductor region 304. At this time, the thermal oxidation carried out in the atmosphere of 1.0 in partial vapor pressure selectively oxidizes only polysilicon, to easily form the structure shown in Fig. 38A.

In Fig. 38B, the exposed drain region 302 is filled by depositing polysilicon to a thickness of, for example, 5000 A (angstroms), and solid state diffusion with POCl₃ is carried out to form an n-type polysilicon layer 330. The doping of polysilicon may be carried out with a combination of ion implantation and activation annealing. The n-type dopant may be phosphorus (P), arsenic (As), antimony (Sb), or the like. Here, the surface of the second hetero-semiconductor region 304 made of p-type polysilicon is covered with the impurity diffusion preventive film 305, i.e., an oxide film to prevent the diffusion of impurities during the thermal processes. Namely, during the solid state diffusion process with POCl₃ and the activation annealing carried out after the n-type dopant ion implantation, no dopant diffuses from the n-type polysilicon layer 330 into the second hetero-semiconductor region 304 made of p-type polysilicon. Also, no dopant diffuses from the second hetero-semiconductor region 304 into the n-type polysilicon layer 330. In any thermal process to be carried out later, the impurity diffusion preventive film 305 prevents the diffusion of dopant. This results in accurately controlling the conductivity of polysilicon. Thereafter, the n-type polysilicon layer 330 is etched back by dry etching, to from the structure of Fig. 38C.

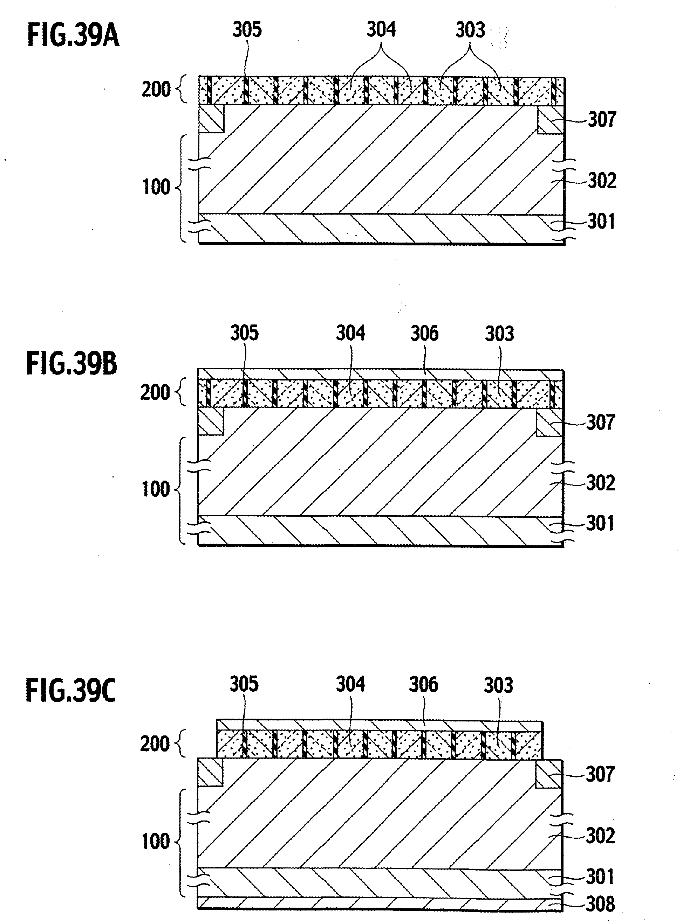

In Fig. 39A, a BHF solution, for example, is used to partly remove the oxide film serving as the impurity diffusion preventive film 305 formed on the second hetero-semiconductor region 304 made of p-type polysilicon. This forms the hetero-semiconductor region 200 consisting of the first hetero-semiconductor region 303 made of n-type polysilicon and the second hetero-semiconductor region 304 made of p-type polysilicon.

In Fig. 39B, aluminum is deposited to form an anode electrode 306 that is in contact with the first and second hetero-semiconductor regions 303 and 304. In Fig. 39C, photolithography and etching are carried out to pattern the aluminum anode electrode 306 and the hetero semiconductor region 200 consisting of the first and second hetero-semiconductor regions 303 and 304. Titanium and nickel are sequentially deposited on the bottom face of the SiC substrate 301 to form a cathode electrode 308, to complete the heterojunction diode shown in Fig. 39C.

In this way, the method of manufacturing a semiconductor device according to this embodiment includes a process of forming a hetero-semiconductor layer having predetermined impurities on a semiconductor base 100 (Fig. 37C, the hetero-semiconductor layer being a p-type polysilicon layer 340), a process of etching the hetero-semiconductor layer (Fig. 37D), and a process of forming an impurity diffusion preventive film 305 on the surface of the hetero-semiconductor layer (Fig. 38A). According to this embodiment, the impurity diffusion preventive film 305 prevents the diffusion of impurities between the adjacent hetero-semiconductor regions 303 and 304. Accordingly, the embodiment can form fine hetero-semiconductor layers having different impurity concentrations or different conductivity types which the related arts hardly produce. The heterojunction diode according to the embodiment is capable of reducing a leakage current at a hetero-interface.

The process of forming the impurity diffusion preventive film 305 on the surface of the hetero-semiconductor layer is carried out by selectively and thermally oxidizing or nitriding the hetero-semiconductor layer. Due to this, the heterojunction diode of the embodiment is easy to manufacture through standard semiconductor manufacturing processes.

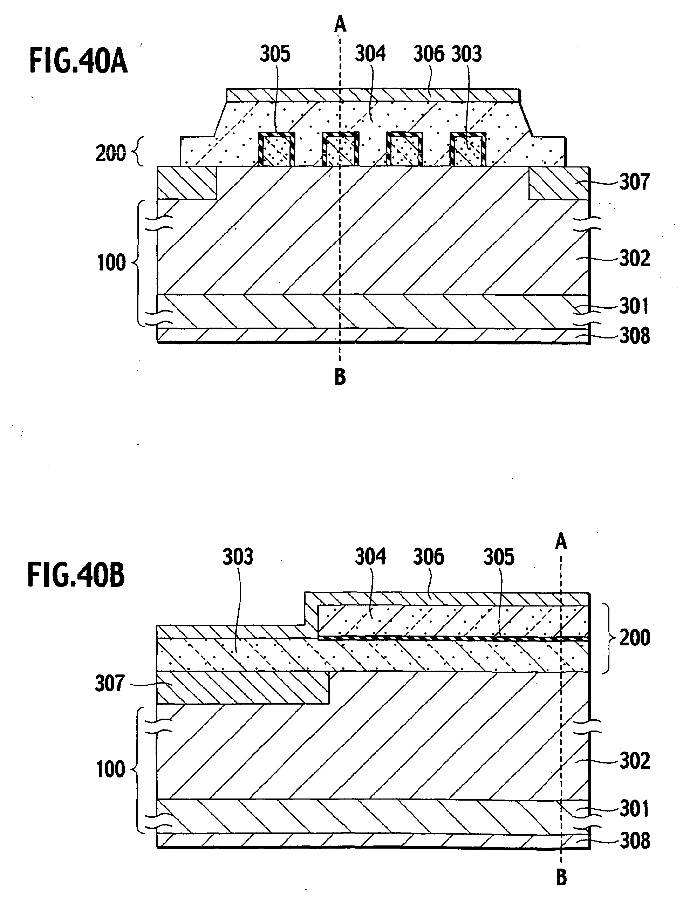

Figure 40A is a sectional view showing a heterojunction diode according to a modification of the twelfth embodiment of the present invention and Fig. 40B is a sectional view taken along a line A-B of Fig. 40A in a direction orthogonal to the plane of Fig. 40A. This modification is based on the structure of Fig. 36. As shown in Figs. 40A and 40B, a second hetero-semiconductor region 304 is in contact with an anode electrode 306 and a first hetero-semiconductor region 303 is in contact with the anode electrode 306 on the back side of Fig. 40A. The other arrangements and effect of this modification are the same as those of the structure of Fig. 36, and therefore, the detailed description thereof will be omitted.

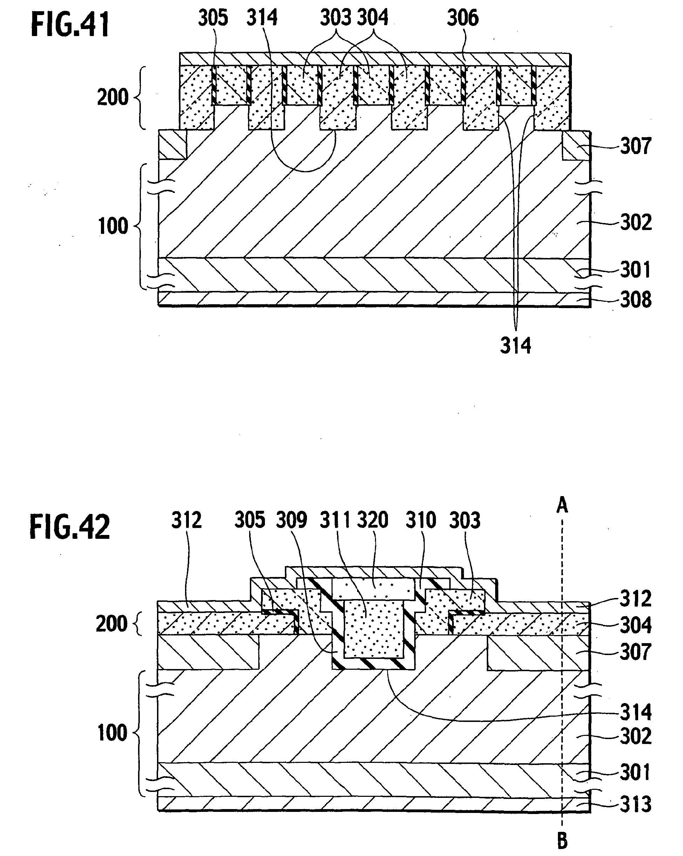

Figure 41 is a sectional view showing a heterojunction diode according to another modification of the eleventh embodiment of the present invention. Like the eleventh embodiment, this modification employs a hetero-semiconductor region consisting of a combination of a first hetero-semiconductor region 303 made of n-type polysilicon and a second hetero-semiconductor region 304 made of p-type polysilicon. The second hetero-semiconductor region 304 fills a trench 314 that is formed at a predetermined position in an SiC semiconductor base 100. This trench structure realizes a higher withstand voltage and improves an OFF characteristic of the semiconductor device. The other arrangements and effect of this modification are the same as those of the structure of Fig. 36, and therefore, the detailed explanation thereof is omitted.

### (Twelfth embodiment)

### (Semiconductor device)

Figure 42 is a sectional view showing a heterojunction field effect transistor according to a twelfth embodiment of the present invention. In Fig. 42, an SiC substrate 301 of first conductivity type, i.e., n-type, for example, is prepared. On the substrate 301, an n-type SiC drain region (epitaxial layer) 302 is formed The substrate 301 and drain region 302 constitute an SiC semiconductor base 100. On a principal surface of the drain region 302 opposite to a junction with respect to the substrate 301, there is formed a hetero-semiconductor region 200. The hetero-semiconductor region 200 consists of a first hetero-semiconductor region 303 made of, for example, n-type polysilicon and a second hetero-semiconductor region 304 made of p-type, i.e., second conductivity type polysilicon. Namely, junctions between the drain region 302 and the first and second hetero-semiconductor regions 303 and 304 are heterojunctions made of SiC and polysilicon having different band gaps. Along the heterojunctions, there are energy barriers. In contact with a junction interface between the first hetero-semiconductor region 303 and the drain region 302, there is formed a gate insulating film 309 made of, for example, a silicon oxide film. On the gate insulating film 309, there is formed a gate electrode 311. Opposite of the junction interface between the first and second hetero-semiconductor regions 303 and 304 and the drain region 302, there is formed a source electrode 312. A drain electrode 313 is formed on the bottom surface of the substrate 301. The gate electrode 311 is insulated from the source electrode 312 with a cap oxide film 320 and an interlayer insulating film 310. In the vicinity of the heterojunction between the drain region 302 and the second hetero-semiconductor region 304, there is formed a field relaxation region 307 in the surface of the drain region 302. Between the adjacent first and second hetero-semiconductor regions 303 and 304, there is formed an impurity diffusion preventive film 305.

According to this embodiment, a trench 314 is formed in the surface of the drain region 302, the gate insulating film 309 is formed in the trench 314, and the gate electrode 311 is formed on the gate insulating film 309, to constitute a trench-type semiconductor device. The embodiment is also applicable to a planar-type semiconductor device having no trench in the drain region 302. In this way, the semiconductor device according to the embodiment has the semiconductor base 100, the hetero-semiconductor region 200 made of hetero-semiconductor material that forms a heterojunction with respect to the semiconductor base 100 and has a different band gap from that of a semiconductor material that forms the semiconductor base 100, the gate electrode 311 arranged on the gate insulating film 309 adjacent to a junction between the semiconductor base 100 and the hetero-semiconductor region 200, the source electrode 312 formed in contact with the hetero-semiconductor region 200, and the drain electrode 313 formed in contact with the semiconductor base 100. The hetero-semiconductor region 200 forms a heterojunction with respect to the semiconductor base 100 and is made of two or more hetero-semiconductor regions 303 and 304 having different impurity concentrations or different conductivity types (different conductivity types in this embodiment). The adjacent hetero-semiconductor regions 303 and 304 are arranged side by side with the impurity diffusion preventive film 305 interposed between them.

The at least two hetero-semiconductor regions 303 and 304 are electrically connected to each other and have the same potential. In the semiconductor device of this embodiment, heterojunction diodes each consisting of the hetero-semiconductor regions 303 and 304 are connected in parallel to pass a large current in a current returning operation.

According to the embodiment, the hetero-semiconductor region 200 consists of the first and second hetero-semiconductor regions 303 and 304. The first hetero-semiconductor region 303 involves a low barrier so that the gate electrode 311 modulates a source-drain current at the first hetero-semiconductor region 303. On the other hand, the second hetero-semiconductor region 304 involves a high barrier to secure a withstand voltage. The first and second hetero-semiconductor regions 303 and 304 are separated from each other with the impurity diffusion preventive film 305, to thereby form an Si/SiC heterojunction field-modulation field effect transistor. The impurity diffusion preventive film 305 prevents the diffusion of impurities between the adjacent hetero-semiconductor regions 303 and 304. The embodiment can form fine hetero-semiconductor layers having different impurity concentrations or different conductivity types which the related arts hardly produce. The heterojunction field effect transistor according to the embodiment is capable of reducing a leakage current at a hetero-interface. The first and second hetero-semiconductor regions 303 and 304 are independent of each other, and therefore, they are manufacturable with their respective optimum conditions.

At least one of the hetero-semiconductor regions 303 and 304 has a conductivity type that is opposite to that of the semiconductor base 100. Making the conductivity type of a part (the hetero-semiconductor region 304 in this embodiment) of the hetero-semiconductor region 200 opposite to that of the semiconductor base 100 results in reducing a leakage current and realizing a high-voltage withstanding semiconductor device. A combination of n- and p-type polysilicon layers realizes a high reverse withstand voltage and a low ON-resistance.

The conductivity type of the first hetero-semiconductor region 303 that is in the vicinity of the gate electrode 311 over the gate insulating film 309 is the same as that of the semiconductor base 100. This configuration realizes a high-voltage withstanding field effect transistor capable of securing a drive power equivalent to that of the related art and lowering a leakage current occurring at a hetero-interface.

The impurity diffusion preventive film 305 is made of a silicon oxide film or a silicon nitride film. Due to this, the semiconductor device of this embodiment is easy to realize with standard semiconductor materials. According to the embodiment, the semiconductor base 100 employs SiC as a semiconductor material. Namely, the semiconductor device of the embodiment having a high withstand voltage can be realized with standard semiconductor materials. The hetero-semiconductor regions 303 and 304 are made of at least one of polysilicon, monosilicon, and amorphous silicon. Namely, the semiconductor device of the embodiment is easy to realize with standard semiconductor materials.

According to the embodiment, a combination of the hetero-semiconductor regions 303 and 304 forming the hetero-semiconductor region 200 is a combination of an n-type polysilicon layer and a p-type polysilicon layer. The combination may consist of hetero-semiconductor layers having different impurity concentrations and the same conductivity type. Instead of a combination of two kinds of hetero-semiconductor layers, i.e., the hetero-semiconductor regions 303 and 304, the embodiment may employ a combination of more lands of hetero-semiconductor layers. The field relaxation layer 307 may be omitted. However, the field relaxation region 307 is preferred to realize a high withstand voltage.

### (Method of manufacturing the semiconductor device)

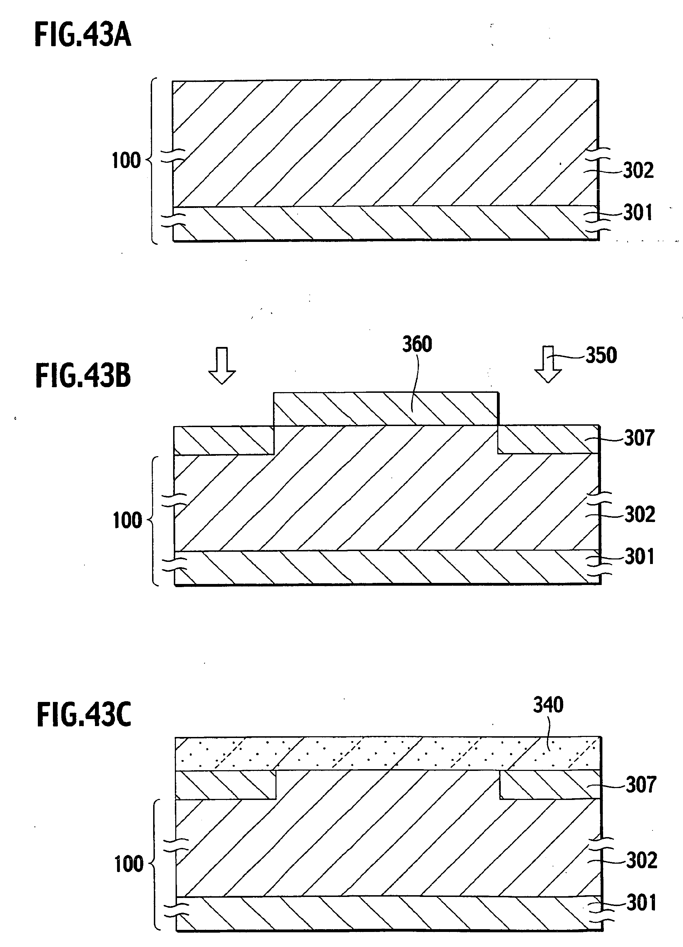

Figures 43A to 47B are sectional views showing a method of manufacturing the heterojunction diode of Fig. 42. In Fig. 42A, an SiC semiconductor base 100 is prepared by forming an n-type SiC drain region (n-type SiC epitaxial layer) 302 on an n-type SiC substrate 301. The thickness of the SiC drain region 302 is, for example, 10 "m, and the impurity concentration thereof is, for example, 1.0 × 10¹⁶ cm⁻³.

In Fig. 43B, a mask layer 360 made of, for example, a CVD oxide film is used to implant aluminum ions 350 into a predetermined area to form a field relaxation region 307. The ion implantation may be multistage implantation carried out at, for example, an acceleration voltage of 30 to 360 KeV, a total dose quantity of 5.0 x 10¹⁶ cm⁻³, and a substrate temperature of 800°C. After the ion implantation, the CVD oxide film is removed with, for example, a BHF solution. Activation annealing is carried out to activate the implanted aluminum. For example, the activation annealing is carried out in an argon atmosphere at 1700°C for 10 minutes. In Fig. 43C, polysilicon is deposited on the drain region 302 to a thickness of, for example, 5000 A (angstroms). Solid state diffusion with BBr₃ is carried out to form a p-type polysilicon layer 340. The doping on polysilicon may be carried out with a combination of ion implantation and activation annealing. The p-type dopant may be boron (B), aluminum (Al), or the like.

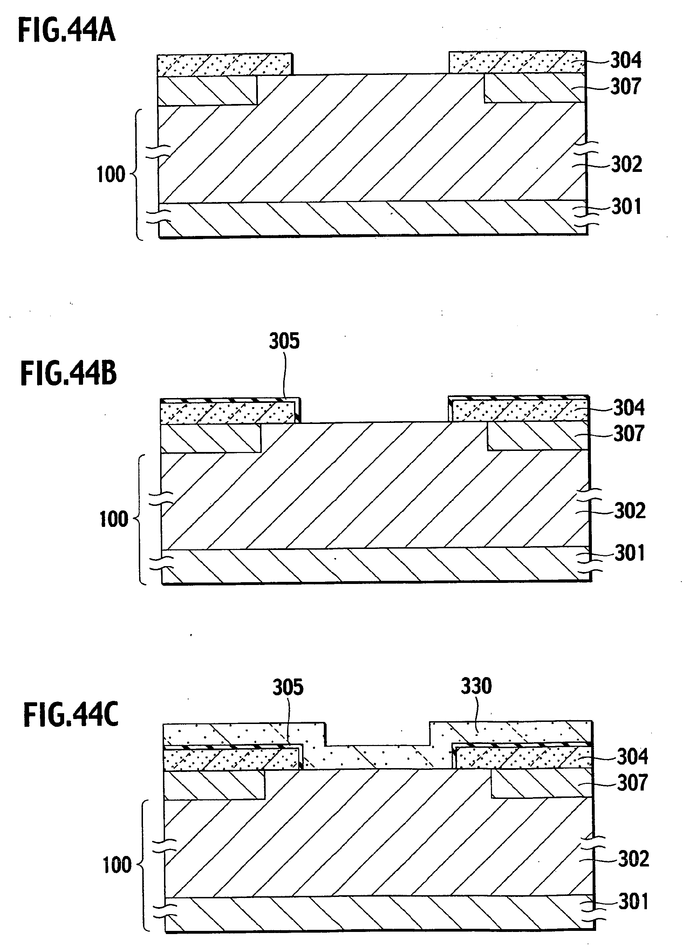

In Fig. 44A, photolithography and etching are carried out to etch a predetermined area of the p-type polysilicon layer 340 to form a second hetero-semiconductor region 304. In Fig. 44B, thermal oxidation is carried out in an oxidizing atmosphere of 1.0 in partial vapor pressure, to form an oxide film serving as an impurity diffusion preventive film 305 on the surface of the second hetero-semiconductor region 304. At this time, the thermal oxidation carried out in the atmosphere of 1.0 in partial vapor pressure selectively oxidizes only polysilicon, to easily form the structure shown in Fig. 44B.

In Fig. 44C, the exposed drain region 302 is filled by depositing polysilicon to a thickness of, for example, 5000 A (angstroms), and solid state diffusion with POCl₃ is carried out to form an n-type polysilicon layer 330. The doping of polysilicon may be carried out with a combination of ion implantation and activation annealing. The n-type dopant may be phosphorus (P), arsenic (As), antimony (Sb), or the like. Here, the surface of the second hetero-semiconductor region 304 made of p-type polysilicon is covered with the impurity diffusion preventive film 305, i.e., an oxide film to prevent the diffusion of impurities during the thermal processes. Namely, during the solid state diffusion process with POCl₃ and the activation annealing carried out after the n-type dopant ion implantation, no dopant diffuses from the n-type polysilicon layer 330 to the second hetero-semiconductor region 304 made of p-type polysilicon. Also, no dopant diffuses from the second hetero-semiconductor region 304 to the n-type polysilicon layer 330. In any thermal process to be carried out later, the impurity diffusion preventive film 305 prevents the diffusion of dopant. This results in accurately controlling the conductivity of polysilicon.

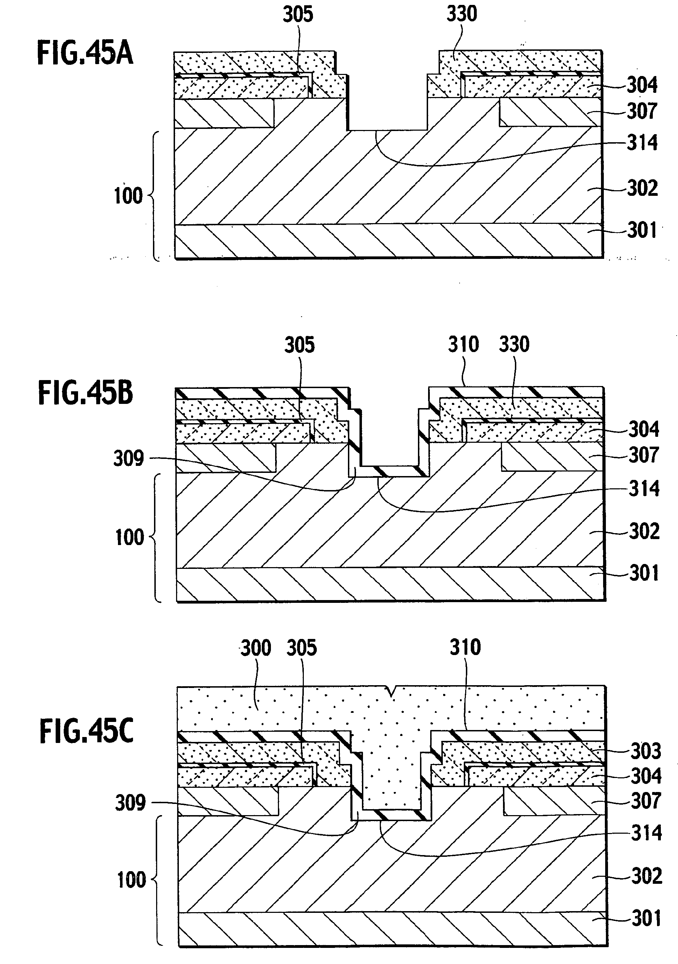

In Fig. 45A, photolithography and etching are used to etch the n-type polysilicon layer 330 and drain region 302 to form a trench 314.

In Fig. 45B, a TEOS film serving as a gate insulating film 309 and an interlayer insulating film 310 is deposited to cover the n-type polysilicon layer 330 and the inner wall of the trench 314. The gate insulating film 309 and interlayer insulating film 310 are the same layer.

In Fig. 45C, polysilicon is deposited to a thickness of, for example, 5000 A to fill the trench 314. Solid state diffusion with POCl₃ is carried out to form a polysilicon layer 300 serving as a gate electrode. The doping of polysilicon may be carried out with a combination of ion implantation and activation annealing. The n-type dopant may be phosphorus (P), arsenic (As), antimony (Sb), or the like.

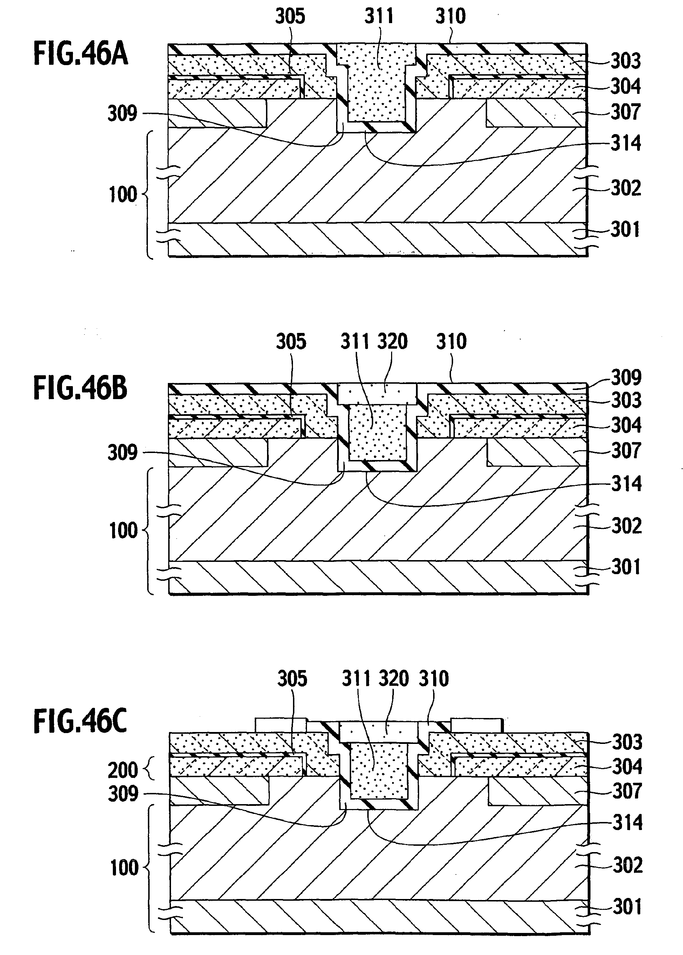

In Fig. 46A, the polysilicon layer 300 is etched back by dry etching, to form a gate electrode 311. In Fig. 46B, a part of the gate electrode 311 is thermally oxidized in an oxidizing atmosphere, to form a cap oxide film 320 that insulate the gate electrode 311. In Fig. 46C, a combination of photolithography and etching is carried out to pattern the interlayer insulating film 310 to form a contact hole for the second hetero-semiconductor region 304.

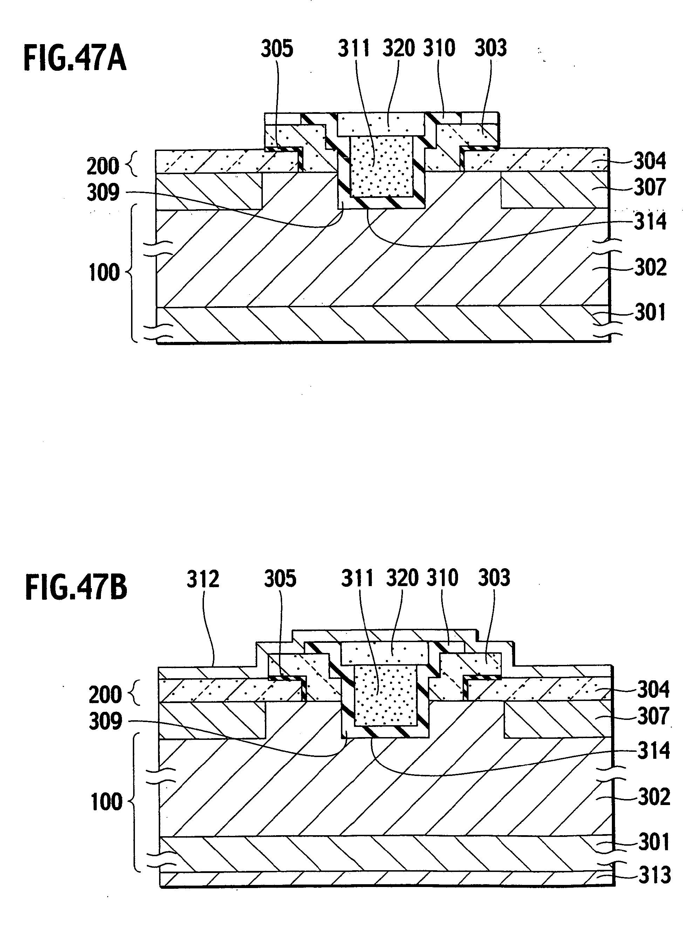

In Fig. 47A, a combination of photolithography and etching is used to etch the n-type polysilicon layer 330 and the diffusion preventive oxide film 305, to form a contact hole for the second hetero-semiconductor region 304. This forms an n-type polysilicon first hetero-semiconductor region 303, thus forming a hetero-semiconductor region 200 consisting of the first and second hetero-semiconductor regions 303 and 304. In Fig. 47B, aluminum is deposited to form a source electrode 312 that is in contact with the first and second hetero-semiconductor regions 303 and 304. Titanium and nickel are sequentially deposited on the bottom face of the SiC substrate 301 to form a drain electrode 313, thereby completing the field effect transistor shown in Fig. 42.

In this way, the method of manufacturing a semiconductor device according to this embodiment includes a process of forming a hetero-semiconductor layer having predetermined impurities on a semiconductor base 100 (Fig. 43C, the hetero-semiconductor layer being a p-type polysilicon layer 340), a process of etching the hetero-semiconductor layer (Fig. 44A), and a process of forming an impurity diffusion preventive film 305 on the hetero-semiconductor layer (Fig. 44B). According to this embodiment, the impurity diffusion preventive film 305 prevents the diffusion of impurities between the adjacent hetero-semiconductor regions 303 and 304. Accordingly, the embodiment, can form fine hetero-semiconductor layers having different impurity concentrations or different conductivity types which the related arts hardly produce. The heterojunction field effect transistor according to the embodiment is capable of reducing a leakage current produced at a hetero-interface.

The process of forming the impurity diffusion preventive film 305 on the hetero-semiconductor layer is carried out by selectively and thermally oxidizing or nitriding the hetero-semiconductor layer. Due to this, the heterojunction field effect transistor of the embodiment is easy to manufacture through standard semiconductor manufacturing processes.

In this way, the semiconductor device of this embodiment is easy to realize with the use of conventional manufacturing techniques. The embodiment is capable of forming the first hetero-semiconductor region 303 of narrow width. The embodiment is capable of freely designing the conductivity type and impurity concentration of the first hetero-semiconductor region 303.

Operation of the semiconductor device of this embodiment will be explained. For example, the source electrode 312 is grounded, and a positive potential is applied to the drain electrode 313. If a ground potential or a negative potential is applied to the gate electrode 311, a nonconductive state (OFF state, or disconnected state) is maintained. Namely, heterojunction interfaces between the first and second hetero-semiconductor regions 303 and 304 and the drain region 302 form energy barriers against conduction electrons. The first and second hetero-semiconductor regions 303 and 304 are each made of silicon material, and therefore, substantially form the same energy barrier difference "EC relative to the drain region 302 made of silicon carbide. However, the n-type first hetero-semiconductor region 303 and p-type second hetero-semiconductor region 304 differ from each other in Fermi energy that is energy from a conduction band to Fermi level. Accordingly, the regions 303 and 304 form depletion layers having different widths, the depletion layers extending from the junction interfaces with the drain region 302. More precisely, the width of the depletion layer extending from the junction interface of the second hetero-semiconductor region 304 is larger than that of the depletion layer extending from the junction interface of the first hetero-semiconductor region 303, to block a leakage current If the impurity concentration of the second hetero-semiconductor region 304 is set to be higher than that of the first hetero-semiconductor region 303, a depletion layer that is produced by a built-in electric field of a pn diode formed from the second hetero-semiconductor region 304 and first hetero-semiconductor region 303 extends toward the first hetero-semiconductor region 303. This may further reduce a leakage current at the heterojunction between the first hetero-semiconductor region 303 and the drain region 302.

The manufacturing method according to the embodiment is capable of easily controlling the width of the first hetero-semiconductor region 303 to cover a gate electric field extending from the gate electrode 311. It is possible, for example, to form an inverted region over the first hetero-semiconductor region 303 when a negative potential is applied to the gate electrode 311, thereby further improving the turn-off capability of the semiconductor device.

According to this embodiment, the first hetero-semiconductor region 303 is formed in a self-aligning manner. Due to this, the width of the first hetero-semiconductor region 303 is correctly controllable even when integrating a plurality of cells. This eliminates variations in turn-off capability among the cells. In this way, the embodiment improves turn-off capability higher than that of the conventional structure. The first hetero-semiconductor region 303 is formed from a separate polysilicon layer from a polysilicon layer that forms the second hetero-semiconductor region 304. Accordingly, the embodiment can freely set the conductivity type and concentration of impurities, to improve the degree of designing freedom.

Next, a positive potential is applied to the gate electrode 311 to change the nonconductive state to a conductive state. Through the gate insulating film 309, a gate electric field extends up to the heterojunction interface between the first hetero-semiconductor region 303 and the drain region 302. As a result, an accumulation layer of conduction electrons is formed in the first hetero-semiconductor region 303 and drain region 302 around the gate electrode 311. Namely, at the junction interface between the first hetero-semiconductor region 303 and the drain region 302 in the vicinity of the gate electrode 311, the potential of the first hetero-semiconductor region 303 is pushed down, and the energy barrier on the drain region 302 side becomes steep to pass conduction electrons through the energy barrier. Here, the first hetero-semiconductor region 303 has been formed in a self-aligning manner to correctly control the width thereof and suppress variations in ON-resistance among a plurality of cells that are integrated. Consequently, the embodiment can suppress a current concentration and improve the reliability of the semiconductor device.

Next, a ground potential is again applied to the gate electrode 311 to switch the conductive state to a nonconductive state. The conduction electron accumulated state at the heterojunction interface between the first hetero-semiconductor region 303 and the drain region 302 is released to stop the tunneling of the energy barrier. Namely, the flow of conduction electrons from the first hetero-semiconductor region 303 to the drain region 302 stops. Conduction electrons in the drain region 302 flow to the substrate 301 and deplete. Then, a depletion layer extends from the heterojunction to the drain region 302, to establish the nonconductive state.

Like the conventional structure, this embodiment can realize reverse conduction (return operation) with the source electrode 312 being grounded and the drain electrode 313 receiving a negative potential. For example, the source electrode 312 and gate electrode 311 are grounded, and a predetermined positive potential is applied to the drain electrode 313. In this state, an energy barrier against conduction electrons disappears, so that conduction electrons flow from the drain region 302 to the first hetero-semiconductor region 303 and second hetero-semiconductor region 304, to establish the reverse conduction state. At this time, there is no injection of holes. Namely, the conductive state is established only with conduction electrons. As a result, a loss due to a reverse recovery current to shift the reverse conduction state to a nonconductive state is small. It is possible to use the gate electrode 311 as a control electrode instead of grounding the same.

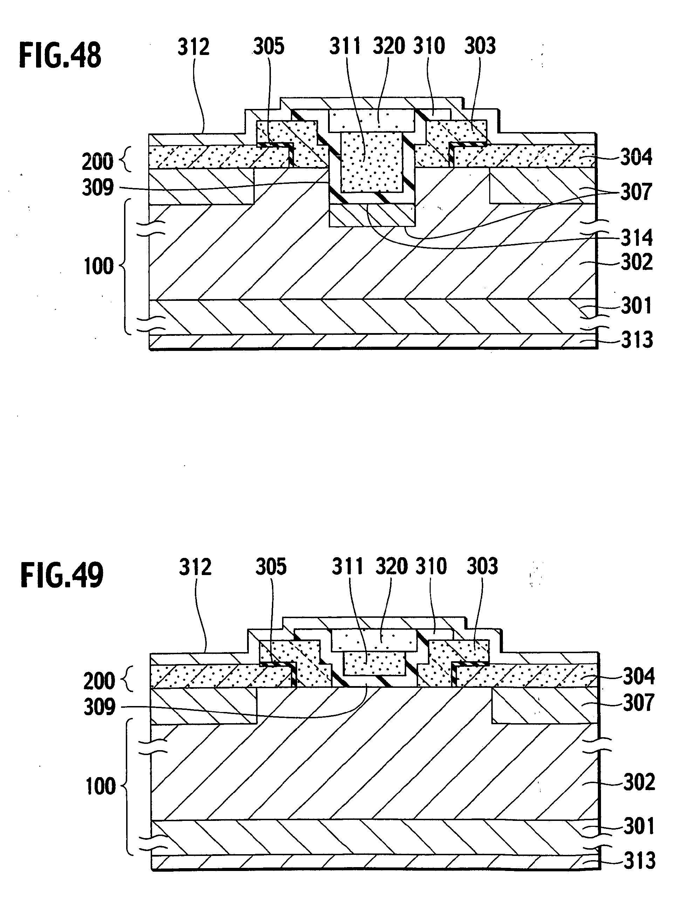

Although the semiconductor device of the embodiment has been explained in connection with a heterojunction field effect transistor having the structure of Fig. 36, the semiconductor device of the embodiment may have any one of the structures shown in Figs. 48 to 53B.

Figure 48 is a sectional view showing a semiconductor device according to a modification of the twelfth embodiment of the present invention. Like the structure of Fig. 42, the modification forms a field relaxation region 307 in the surface of a drain region 302. The relaxation region 307 is separated by a predetermined distance from a part where a gate electrode 311 faces a first hetero-semiconductor region 303. The relaxation region 307 is in contact with the first hetero-semiconductor region 303 or a second hetero-semiconductor region 304 (in this embodiment, the second hetero-semiconductor region 304). In addition, the field relaxation region 307 is formed in contact with the bottom of a trench 314 in which the gate electrode 311 is formed. An example of a method of manufacturing the semiconductor device of Fig. 48 will be explained.

Like the structure of Fig. 42, the field relaxation region 307 (and simultaneously the field relaxation region 307 at the bottom of the trench 314, if required) is formed as shown in Fig. 43B before forming the polysilicon layer 340. Thereafter, like the structure of Fig. 42, the polysilicon layer 340 is formed (Fig. 43C). Ion etching is carried out to form the trench 314 (Fig. 45A). With the mask layer for etching the trench 314, aluminum ions or boron ions are implanted to form the field relaxation region 307.

In a nonconductive state, a depletion layer spreads according to a drain potential between the drain region 302 and both the field relaxation layers 307 one of which is in contact with the second hetero-semiconductor region 304 and the other at the bottom of the trench 314. Namely, the field relaxation region 307 in contact with the second hetero-semiconductor region 304 relaxes a drain electric field acting on the heterojunction interface between the first and second hetero-semiconductor regions 303 and 304 and the drain region 302. This further reduces a leakage current and improves turn-off capability. The field relaxation region 307 at the bottom of the trench 314 relaxed a drain electric field acting on the gate insulating film 309, to prevent the dielectric breakdown of the gate insulating film 309, thereby improving the reliability of the gate insulating film 309.

According to this embodiment, the trench 314 is formed in the surface of the drain region 302 as shown in Fig. 48. In the trench 314, the gate insulating film 309 and gate electrode 311 are formed, to constitute a trench-type semiconductor device. The drain region 302 may have no trench as shown in Figure 49, to constitute a planar-type semiconductor device.

Figure 49 is a sectional view showing a semiconductor device according to another modification of the twelfth embodiment of the present invention. To form the structure of Fig. 49, only the polysilicon layer 340 (Fig. 45A) is etched and removed without etching the surface of the drain region 302. Processes that follow are the same as those for forming the structure of Fig. 42, and therefore, the detailed explanation thereof is omitted.

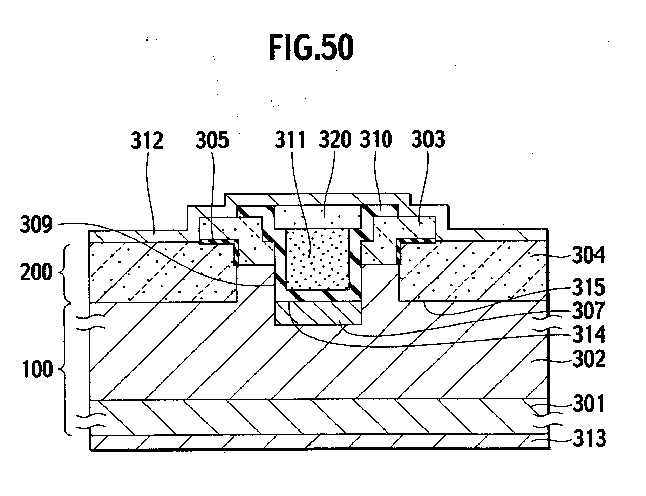

Figure 50 is a sectional view showing a semiconductor device according to still another modification of the twelfth embodiment of the present invention. To form the structure of Fig. 50, the trench 314 is formed in the drain region 302 before forming the p-type polysilicon hetero-semiconductor region 304 (Fig. 43C). Thereafter, the hetero-semiconductor region 304 is formed. Processes that follow are the same as those for forming the structure of Fig. 42. According to this structure, a depletion layer that extends from the hetero-semiconductor region 304 toward the semiconductor base 100 relaxes a drain electric field applied to a modulation location when a reverse voltage is applied. Compared with the structure of Fig. 42, the structure of Fig. 50 can further reduce a leakage current at the first hetero-semiconductor region 303. Like the structure of Fig. 48, the structure of Fig. 50 has a field relaxation region 307 at the bottom of the trench 314. A method of manufacturing the structure of Fig. 50 and the effect thereof are the same as those of the structure of Fig. 48.

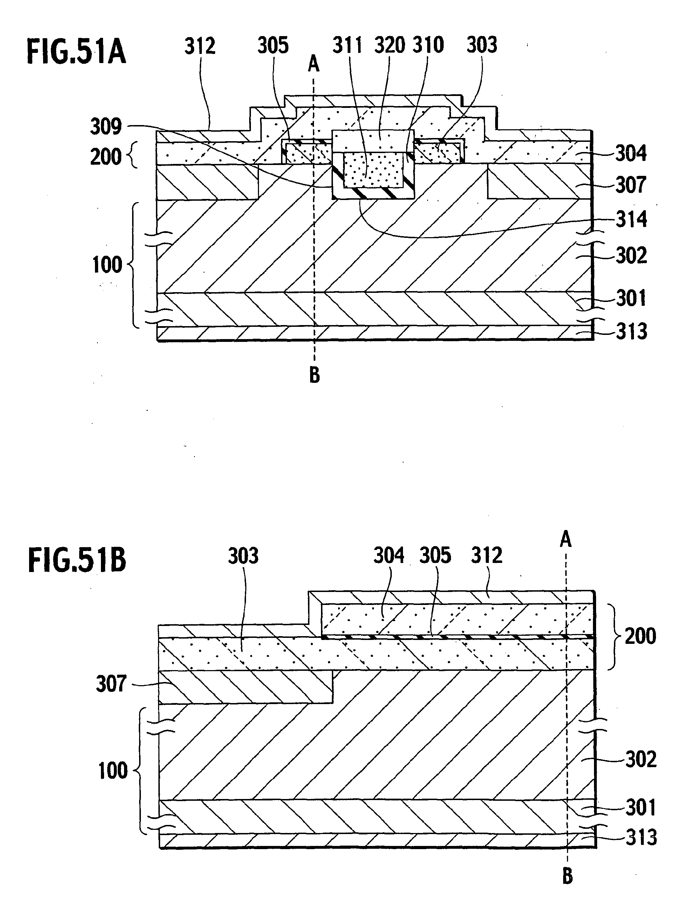

Figure 51A is a sectional view showing a heterojunction field effect transistor according to still another modification of the twelfth embodiment of the present invention, and Fig. 5 1 B is a sectional view taken along a line A-B of Fig. 5 1 A in a direction orthogonal to the plane of Fig. 51A.

This structure is based on the structure of Fig. 50. As shown in Figs. 51A and 51B, a second hetero-semiconductor region 304 is in contact with a source electrode 312 and a first hetero-semiconductor region 303 is in contact with the source electrode 312 on the back side of Fig. 51A. The other arrangements and effect of this modification are the same as those of the structure of Fig. 42, and therefore, the detailed description thereof will be omitted.

In this way, the basic processes according to the embodiment explained with reference to Figs. 37A to 39C are usable to form the semiconductor devices of different structures shown in Figs. 40A to 51B. At a predetermined part of the drain region 302 that is in contact with the gate insulating film 309 and first hetero-semiconductor region 303, an n-type conductive region whose impurity concentration is higher than the drain region 302 may be formed. Through the conductive region, majority carriers may easily flow from the first hetero-semiconductor region 303 to the drain region 302, to further improve conductivity and reduce ON-resistance.

In each of the embodiments mentioned above, the semiconductor device employs SiC as a material for the semiconductor base 100. The material may be any other material such as silicon, silicon germanium, gallium nitride, or diamond. Each of the embodiments employs SiC having a polytype of 4H. It is possible to employ SiC having any other polytype such as 6H, 3C, or the like. In each of the embodiments, a drain electrode and a source electrode are arranged opposite to each other with a drain region interposed between them, to vertically pass a drain current Namely, in each of the embodiments, the semiconductor device is a vertical transistor. Instead, the drain electrode and source electrode may be arranged on the same principal surface to horizontally pass a drain current. Namely, the embodiment is applicable to a horizontal transistor.

In the embodiments, the first hetero-semiconductor layer and second hetero-semiconductor layer are made of polysilicon. The present invention is achievable with any other material if the material can form a heterojunction with respect to SiC. In the embodiments, the drain region is made of n-type SiC and the first hetero-semiconductor layer is made of n-type polysilicon. These regions may be made of n-type SiC and p-type polysilicon, respectively. Instead, they may be made of p-type SiC and p-type polysilicon, respectively. Alternatively, they may be made of p-type SiC and n-type polysilicon, respectively.

The entire contents of Japanese patent applications P2004-270923 filed September 17^{th}, 2004, P2004-279224 filed September 27^{th}, 2004, P2004-281158 filed September 28^{th}, 2004 are hereby incorporated by reference.

The invention may be embodied in other specific forms without departing from the spirit or essential characteristics thereof. The present embodiment is therefore to be considered in all respects as illustrative and not restrictive, the scope of the invention being indicated by the appended claims rather than by the foregoing description, and all changes which come within the meaning and range of equivalency of the claims are therefore intended to be embraced therein.

## Claims

1. A method of manufacturing a semiconductor device including a semiconductor base (100, 101, 102, 121, 122, 201, and 202) of a first conductivity type, a first hetero-semiconductor region (103, 123, 209, and 303) and a second hetero-semiconductor region (104, 124, 224, and 304) the first and second hetero-semiconductor regions (103, 104, 123, 124, 209, 224, 303, and 304) in contact with the semiconductor base (100, 101, 102, 121, 122, 201, and 202) and having different band gaps from that of the semiconductor base (100, 101, 102, 121, 122, 201, and 202), the method comprising:
a first process to form a second-hetero-semiconductor-region-forming semiconductor layer (240, 400) on a principal surface of the semiconductor base (100, 101, 102, 121, 122, 201, and 202);
a second process to etch selectively the second-hetero-semiconductor-region-forming semiconductor layer (240, 400) to form the second hetero-semiconductor region (104, 124, 224, and 304) employing a mask layer (109,131) provided with a predetermined opening (114,136, and 241);
a third process to form, employing the mask layer (109, and 131), a first-hetero-semiconductor-region-forming semiconductor layer (123, and 300);
a fourth process to etch selectively the first-hetero-semiconductor-region-forming semiconductor layer (123, 300), to form the first hetero-semiconductor region (103, 123, 209, and 303); and
a fifth process to form the gate insulating film (105, 127, 206, and 309) in contact with the first hetero-semiconductor region (103, 123, 209, and 303) and the semiconductor base (100, 101, 102, 121, 122, 201, and 202).

2. The method as claimed in claim 1, wherein:
one of the second and fourth processes simultaneously and selectively etches the surface of the semiconductor base (100, 101, 102, 121, 122, 201, and 202) when selectively etching a corresponding one of the second-hetero-semiconductor-region-forming semiconductor layer (240, and 400) and the first-hetero-semiconductor-region-forming semiconductor layer (123, and 300).

3. The method as claimed in claim 1, further comprising:
after the first process, at least a process to introduce impurities into a predetermined part of the second-hetero-semiconductor-region-forming semiconductor layer (240, and 400) so that the second hetero-semiconductor region (104, 124, 224, and 304) has a second conductivity type.

4. The method as claimed in claim 1, further comprising:
before the third process, at least a process to remove an end of the second-hetero-semiconductor-region-forming semiconductor layer (240, and 400) by a predetermined width to form a space under an end of the mask layer (109, and 131).

5. The method as claimed in claim 1, further comprising:
between the third process and the fifth process, at least a process to introduce, with the mask layer (109, and 131) being left, impurities into the first-hetero-semiconductor-region-forming semiconductor layer (123, and 300).

6. The method as claimed in claim 5, wherein:
the third process introduces impurities into the first-hetero-semiconductor-region-forming semiconductor layer (123, and 300).

7. The method as claimed in claim 1, further comprising:
before the third process, at least a process to form an impurity diffusion preventive film (305) in contact with the second-hetero-semiconductor-region-forming semiconductor layer (240, and 400).

8. A method of manufacturing a semiconductor device including a semiconductor base (100, 101, 102, 121, 122, 201, and 202) of a first conductivity type, and a first hetero-semiconductor region (103, 123, 209, and 303) and a second hetero-semiconductor region (104, 124, 224, and 304) that are in contact with a principal surface of the semiconductor base (100, 101,102,121, 122, 201, and 202) and have different band gaps from that of the semiconductor base (100, 101 , 102, 121, 122, 201, and 202), the method comprising:
a first process to form a second-hetero-semiconductor-region-forming semiconductor layer (240, 400) on a principal surface of the semiconductor base (100, 101 , 102, 121, 122, 201, and 202);
a second process to form an interlayer insulating film (125, 215, and 310) in contact with at least the second-hetero-semiconductor-region-forming semiconductor layer (240, and 400);
a third process to form a semiconductor layer (260) in contact with at least the interlayer insulating film (125, 215, and 310);
a fourth process to etch selectively, employing a mask layer (109, and 131) provided with a predetermined opening (114, 136, and 241), the second-hetero-semiconductor-region-forming semiconductor layer (240, and 400), interlayer insulating film (125, 215, and 310), and a semiconductor layer (260), to form the second hetero-semiconductor region (104, 124, 224, and 304), interlayer insulating film (125, 215, and 310), and a semiconductor region (126) in contact with the first hetero-semiconductor region (103, 123, 209, and 303) and formed on at least a part of the second hetero-semiconductor region (104, 124, 224, and 304) through an interlayer insulating film (125, 215, and 310);
a fifth process to form, employing the mask layer (109, and 131), a first-hetero-semiconductor-region-forming semiconductor layer (123, 300);
a sixth process to etch selectively the first-hetero-semiconductor-region-forming semiconductor layer (123, 300), to form the first hetero-semiconductor region (103, 123, 209, and 303); and
a seventh process to form a gate insulating film (105, 127, 206, and 309) in contact with the first hetero-semiconductor region (103, 123, 209, and 303) and the semiconductor base (100, 101, 102, 121, 122, 201, and 202).

9. The method as claimed in claim 8, wherein:
one of the fourth and sixth processes simultaneously and selectively etches the surface of the semiconductor base (100, 101, 102, 121, 122, 201, and 202) when selectively etching a corresponding one of the second-hetero-semiconductor-region-fonning semiconductor layer (240, and 400) and first-hetero-semiconductor-region-forming semiconductor layer (123, and 300).

10. The method as claimed in claim 8, further comprising:
after the first process, at least a process to introduce impurities into a predetermined region of the second-hetero-semiconductor-region-forming semiconductor layer (240, and 400) so that the second hetero-semiconductor region (104, 124, 224, and 304) has a second conductivity type.

11. The method as claimed in claim 8, further comprising:
before the fifth process, at least a process to remove an end of any one of the second-hetero-semiconductor-region-forming semiconductor layer (240, and 400), interlayer insulating film (125, 215, and 310), and semiconductor layer by a predetermined width, so that a space is formed just under an end of the mask layer (109, and 131).

12. The method as claimed in claim 8, further comprising:
between the fifth process and the seventh process, at least a process to introduce, with the mask layer (109, and 131) being left, impurities into the first-hetero-semiconductor-region-forming semiconductor layer (123, and 300).

13. The method as claimed in claim 12, wherein:
the fifth process introduces impurities into the first-hetero-semiconductor-region-forming semiconductor layer (123, and 300).

14. The method as claimed in claim 8, further comprising:
when connecting the first hetero-semiconductor region (103, 123, 209, and 303) to the source electrode connected through the semiconductor region (126) to the first hetero-semiconductor region (103, 123, 209, and 303), at least a process to connect simultaneously the second hetero-semiconductor region (104, 124, 224, and 304) to the source electrode by etching predetermined parts of the semiconductor region (126) and interlayer insulating film (125, 215, and 310).

15. The method as claimed in claim 1, wherein:
the semiconductor base (100, 101, 102, 121, 122, 201, and 202) is made of silicon carbide.

16. The method as claimed in claim 1, wherein:
the first hetero-semiconductor region (103, 123, 209, and 303) is formed from at least one of monosilicon, polysilicon, and amorphous silicon.

17. The method as claimed in claim 1, wherein:
the second hetero-semiconductor region (104, 124, 224, and 304) is formed from at least one of monosilicon, polysilicon, and amorphous silicon.

18. The method as claimed in claim 8, wherein:
the semiconductor region (126) and first hetero-semiconductor region (103, 123, 209, and 303) are made of the same material.

19. A semiconductor device comprising:
a semiconductor base (100, 101, 102, 121, 122, 201, and 202) of a first conductivity type;
a first hetero-semiconductor region (103, 123, 209, and 303) and a second hetero-semiconductor region (104, 124, 224, and 304) that are in contact with a principal surface of the semiconductor base (100, 101, 102, 121, 122, 201, and 202) and have different band gaps from that of the semiconductor base (100, 101, 102, 121, 122, 201, and 202);
a semiconductor region (126) that is in contact with the first hetero-semiconductor region (103, 123, 209, and 303) and is formed on at least a part of the second hetero-semiconductor region (104, 124, 224, and 304) through an interlayer insulating film (125, 215, and 310);
a gate electrode formed on a gate insulating film (105, 127, 206, and 309) at a junction between the first hetero-semiconductor region (103, 123, 209, and 303) and the semiconductor base (100, 101, 102, 121, 122, 201, and 202);
a source electrode connected through the semiconductor region (126) to the first hetero-semiconductor region (103, 123, 209; and 303), the source electrode being passed through at least the interlayer insulating film (125, 215, and 310) and being connected to the second hetero-semiconductor region (104, 124, 224, and 304); and
a drain electrode formed in ohmic-contact with the semiconductor base (100,101,102, 121, 122, 201, and 202).

20. The device as claimed in claim 19, wherein:
the semiconductor base (100, 101, 102, 121, 122, 201, and 202) is made of silicon carbide.

21. The device as claimed in claim 19, wherein:
the first hetero-semiconductor region (103, 123, 209, and 303) is formed from at least one of monosilicon, polysilicon, and amorphous silicon.

22. The device as claimed in claim 19, wherein:
the second hetero-semiconductor region (104, 124, 224, and 304) is formed from at least one of monosilicon, polysilicon, and amorphous silicon.

23. The device as claimed in claim 19, wherein:
the semiconductor region (126) and first hetero-semiconductor region (103, 123, 209, and 303) are made of the same material.

24. The device as claimed in claim 19, wherein:
the first hetero-semiconductor region (103, 123, 209, and 303) has a contact region (213) configured and arranged to enlarge contact area with the source electrode.

25. The device as claimed in claim 24, wherein:
on the opposite side of a first heterojunction between the first hetero-semiconductor region (103, 123, 209, and 303) and the semiconductor base (100, 101, 102, 121, 122, 201, and 202), the first hetero-semiconductor region (103, 123, 209, and 303) occupies a larger area than the first heterojunction.

26. The device as claimed in claim 24, wherein:
the second hetero-semiconductor region (104, 124, 224, and 304) is formed under the contact region (213) provided for the first hetero-semiconductor region (103, 123, 209, and 303).

27. The device as claimed in claim 24, wherein:
the second hetero-semiconductor region (104, 124, 224, and 304) is formed under the contact region (213) provided for the first hetero-semiconductor region (103, 123, 209, and 303); and
the first hetero-semiconductor region (103, 123, 209, and 303) and second hetero-semiconductor region (104, 124, 224, and 304) are formed in different layers.

28. The device as claimed in claim 24, further comprising:
an insulation film between the first hetero-semiconductor region (103, 123, 209, and 303) and the second hetero-semiconductor region (104, 124, 224, and 304).

29. The device as claimed in claim 24, wherein:
the first hetero-semiconductor region (103,123, 209, and 303) and the contact region (213) are made of the same material.

30. The device as claimed in claim 24, further comprising:
a field relaxation region of a second conductivity type formed at the surface of the semiconductor base (100, 101, 102, 121, 122, 201, and 202) at least under the contact region (213).

31. The device as claimed in claim 24, wherein:
on the side opposite to the first and second heterojunctions where the first and second hetero-semiconductor regions (103, 104, 123, 124, 209, 224, 303, and 304) are in contact with the semiconductor base (100, 101, 102, 121, 122, 201, and 202), the first and second hetero-semiconductor regions (103, 104, 123, 124, 209, 224, 303, and 304) are in contact with the source electrode.

32. The device as claimed in claim 19, further comprising:
at a predetermined location on the surface of the second hetero-semiconductor region (104, 124, 224, 304), a source contact region (223) of the first conductivity type electrically connected to the first hetero-semiconductor region (103, 123, 209, and 303).

33. The device as claimed in claim 32, wherein:
the semiconductor base (100, 101, 102, 121, 122, 201, and 202) is made of silicon carbide;
at least one of the first and second hetero-semiconductor regions (103, 104, 123, 124, 209, 224, 303, and 304) is made of at least one of polysilicon, monosilicon, and amorphous silicon; and
the first and second hetero-semiconductor regions (103, 104, 123,124, 209, 224, 303, and 304) are selectively implanted with impurities to have first and second conductivity types, respectively.

34. The device as claimed in claim 32, wherein:
the first hetero-semiconductor region (103, 123, 209, 3 and 03) with the contact region (213) is arranged in a lattice-like planar layout.
